(19) Europäisches Patentamt
European Patent Office
Office européen des brevets

(11) EP 3 950 726 A1

(12) **EUROPEAN PATENT APPLICATION**
published in accordance with Art. 153(4) EPC

(43) Date of publication:
**09.02.2022 Bulletin 2022/06**

(21) Application number: **20779277.1**

(22) Date of filing: **13.03.2020**

(51) International Patent Classification (IPC):
***C08F 2/44*** (2006.01) ***C08F 220/18*** (2006.01)
***C08G 59/32*** (2006.01) ***C09B 11/28*** (2006.01)
***C09B 67/20*** (2006.01) ***C09B 67/22*** (2006.01)
***G02B 5/20*** (2006.01) ***G03F 7/004*** (2006.01)
***G03F 7/027*** (2006.01) ***H04N 5/225*** (2006.01)

(52) Cooperative Patent Classification (CPC):
**C08F 2/44; C08F 220/18; C08F 220/20; C08G 59/32; C08K 5/23; C08L 101/00; C09B 11/28; C09B 35/03; C09B 43/32; C09B 57/00; G02B 5/20; G03F 7/004; G03F 7/027; H04N 5/225**

(86) International application number:
**PCT/JP2020/011134**

(87) International publication number:
**WO 2020/195962 (01.10.2020 Gazette 2020/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.03.2019 JP 2019056718**

(71) Applicant: **Sumitomo Chemical Company, Limited**
**Tokyo 104-8260 (JP)**

(72) Inventors:
- **MATSUMOTO, Mayuko**
  **Osaka-shi, Osaka 554-8558 (JP)**
- **ICHIOKA, Kenji**
  **Osaka-shi, Osaka 554-8558 (JP)**

(74) Representative: **Vossius & Partner**
**Patentanwälte Rechtsanwälte mbB**
**Siebertstraße 3**
**81675 München (DE)**

(54) **COLORED CURABLE RESIN COMPOSITION, COLOR FILTER AND SOLID-STATE IMAGING ELEMENT**

(57) A colored curable resin composition comprises: a colorant (A); a resin (B); a polymerizable compound (C); and a polymerization initiator (D), the colorant (A) comprising a red pigment, a xanthene dye, and an azo dye.

EP 3 950 726 A1

## Description

Technical Field

The present invention relates to a colored curable resin composition, a color filter, and a solid-state imaging element.

Background Art

Patent Literature 1 proposes a colored curable resin composition containing a red pigment and a compound represented by the following formula.

[Formula 1]

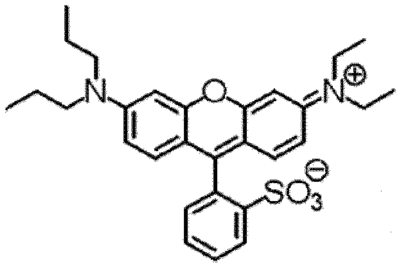

[Formula 2]

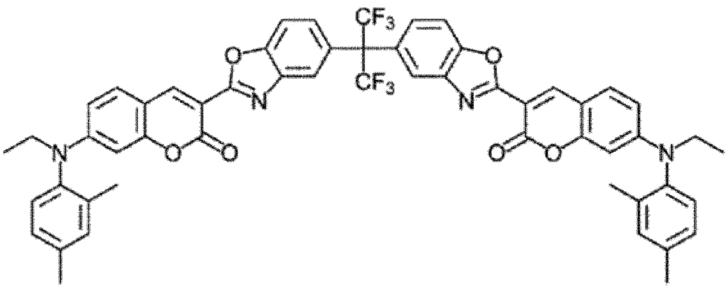

Citation List

Patent Literature

Patent Literature 1: Japanese Patent Laid-Open No. 2016-11419

Summary of Invention

Technical Problem

In the producing process of a color filter, a colored curable resin composition is required, which provides reduced residue after developing to provide a high residual film ratio.

An object of the present invention is to provide a colored curable resin composition having good developability.

Solution to Problem

The present invention provides the following colored curable resin composition, color filter, and solid-state imaging element.

[1] A colored curable resin composition comprising: a colorant (A); a resin (B); a polymerizable compound (C); and

a polymerization initiator (D), the colorant (A) comprising a red pigment, a xanthene dye, and an azo dye.

[2] The colored curable resin composition according to [1], wherein the azo dye comprises a compound represented by formula (I):

$$A^1\text{-N=N-}B^1 \qquad (I)$$

wherein:

$A^1$ represents a monovalent aromatic hydrocarbon group having 6 to 10 carbon atoms and optionally having a substituent; and

$B^1$ represents a monovalent aromatic hydrocarbon group having 6 to 14 carbon atoms and optionally having a substituent or a monovalent heterocyclic group having 3 to 14 carbon atoms and optionally having a substituent, and $-CH_2-$ contained in the heterocyclic group is optionally replaced with -CO-.

[3] The colored curable resin composition according to [2], wherein $A^1$ is a phenyl group having two or more of at least one group selected from the group consisting of a carboxy group, a sulfo group, a sulfamoyl group, and an N-substituted sulfamoyl group, or a naphthyl group having two or more of at least one group selected from the group consisting of a sulfo group, a sulfamoyl group, and an N-substituted sulfamoyl group.

[4] The colored curable resin composition according to [2] or [3], wherein $B^1$ represents a monovalent heterocyclic group having 3 to 14 carbon atoms and optionally having a substituent, and $-CH_2-$ contained in the heterocyclic group is optionally replaced with -CO-.

[5] The colored curable resin composition according to any one of [1] to [4], wherein the azo dye comprises a compound represented by formula (II):

$$B^{2a}\text{-N=N-}A^{2a}\text{-O-CO-L-CO-O-}A^{2b}\text{-N=N-}B^{2b} \qquad (II)$$

wherein:

$A^{2a}$ and $A^{2b}$ each independently represent a divalent group containing an aromatic hydrocarbon group having 6 to 10 carbon atoms and optionally having a substituent; and

$B^{2a}$ and $B^{2b}$ each independently represent a monovalent aromatic hydrocarbon group having 6 to 14 carbon atoms and optionally having a substituent or a monovalent heterocyclic group having 3 to 14 carbon atoms and optionally having a substituent, and $-CH_2-$ contained in the heterocyclic group is optionally replaced with -CO-; and

L represents a divalent aliphatic hydrocarbon group having 1 to 16 carbon atoms and optionally having a substituent, and $-CH_2-$ contained in the aliphatic hydrocarbon group is optionally replaced with -CO- or -O-

[6] The colored curable resin composition according to [5], wherein $A^{2a}$ and $A^{2b}$ are each independently groups represented by formula ($A_{II}$):

$$*\text{-}A^3\text{-}SO_2NR^{10}Z^1\text{-} \qquad (A_{II})$$

wherein:

$A^3$ represents a divalent aromatic hydrocarbon group having 6 to 10 carbon atoms and optionally having a substituent;

$R^{10}$ each independently represents a hydrogen atom, a monovalent saturated hydrocarbon group having 1 to 16 carbon atoms and optionally having a substituent, or an acyl group having 2 to 18 carbon atoms and optionally having a substituent;

$Z^1$ each independently represents a divalent aliphatic hydrocarbon group having 1 to 16 carbon atoms and optionally having a substituent, and $-CH_2-$ contained in the aliphatic hydrocarbon group is optionally replaced with -CO- or -O-; and

* represents a point of attachment to a nitrogen atom.

[7] The colored curable resin composition according to [5] or [6], wherein $B^{2a}$ and $B^{2b}$ each independently represent a monovalent heterocyclic group having 3 to 14 carbon atoms and optionally having a substituent, and $-CH_2-$ contained in the heterocyclic group is optionally replaced with -CO-.

[8] The colored curable resin composition according to [4] or [7], wherein when a plurality of heterocyclic groups are

present, the heterocyclic groups are each independently groups represented by formula (Ba),

[Formula 3]

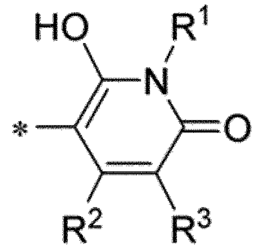

(Ba)

wherein:

$R^1$ and $R^2$ each independently represent a hydrogen atom or a monovalent saturated hydrocarbon group having 1 to 16 carbon atoms and optionally having a substituent;
$R^3$ represents a cyano group or a group represented by $-CO-NR^4R^5$;
$R^4$ and $R^5$ each independently represent a hydrogen atom, a saturated aliphatic hydrocarbon group having 1 to 10 carbon atoms, a saturated aliphatic hydrocarbon group having 1 to 10 carbon atoms and substituted with an alkoxy group having 1 to 8 carbon atoms, an aryl group having 6 to 20 carbon atoms, an aralkyl group having 7 to 20 carbon atoms, or an acyl group having 2 to 10 carbon atoms; and
* represents a point of attachment to a nitrogen atom.

[9] A color filter formed from the colored curable resin composition according to any one of [1] to [8].
[10] A solid-state imaging element comprising the color filter according to [9].

Advantageous Effects of Invention

According to the present invention, a colored curable resin composition having good developability can be provided.

Description of Embodiments

[Red Pigment]

A red pigment contained in a colorant (A) preferably has maximum absorption in a wavelength region of 580 nm or less, and more preferably has maximum absorption in a wavelength region of 480 nm or more and 560 nm or less. The red pigment preferably transmits light having a wavelength region of 610 nm or more.
Known pigments can be used as the red pigment. Examples thereof include a pigment which is classified into a pigment in the Color Index (published by The Society of Dyers and Colourists) and classified into red. Two or more thereof may be combined.
Among the red pigments, preferred are an anthraquinone pigment, an azo pigment, a quinacridone pigment, a perylene pigment, and a diketopyrrolopyrrole pigment, and more preferred are an anthraquinone pigment and a diketopyrrolopyrrole pigment.
Specific examples thereof include C.I. Pigment Reds 9, 97, 105, 122, 123, 144, 149, 166, 168, 176, 177, 179, 180, 192, 208, 209, 215, 216, 224, 242, 254, 255, 264, 265, 266, 268, 269, and 273, and compounds represented by formula (P) described in Japanese Patent Laid-Open No. 2013-014750. Preferred are C.I. Pigment Reds 177, 208, 242, 254, and 269, and compounds represented by formula (P) described in Japanese Patent Laid-Open No. 2013-014750, and more preferred are C.I. Pigment Reds 177 and 254, and compounds represented by formula (P) described in Japanese Patent Laid-Open No. 2013-014750.
The red pigments may be subjected to a rosin treatment, a surface treatment using a pigment derivative or the like having an introduced acidic group or basic group, a pigment surface graft treatment with a polymeric compound or the like, a particle micronization treatment with a sulfuric acid micronization method or the like, a washing treatment with an organic solvent, water or the like for removing impurities, a removing treatment with an ionic exchange method or the like of ionic impurities or the like, if required. Each of the red pigments preferably has a uniform particle diameter.
The content rate of the red pigment in the colorant (A) may be, for example, 10% by mass or more and 99% by mass or less, is more preferably 20% by mass or more and 99% by mass or less, still more preferably 40% by mass

or more and 90% by mass or less, particularly preferably 50% by mass or more and 90% by mass or less, and especially preferably 60% by mass or more and 85% by mass or less, based on the whole amount of the colorant (A).

When a colored curable resin composition contains a solvent (E), a pigment dispersion containing a pigment and a solvent (E) may be previously prepared, followed by preparing the colored curable resin composition using the pigment dispersion. The pigment dispersion may contain the whole of the solvent (E) contained in the colored curable resin composition, or a part thereof.

The content rate of a solid content in the pigment dispersion is preferably 0.1% by mass or more and 99.9% by mass or less, more preferably 1% by mass or more and 90% by mass or less, still more preferably 3% by mass or more and 80% or less, and particularly preferably 5% by mass or more and 50% by mass or less, relative to the whole amount of the pigment dispersion.

The content rate of the pigment in the pigment dispersion is preferably 0.01% by mass or more and 100% by mass or less, more preferably 0.1% by mass or more and 99.9% by mass or less, still more preferably 1% by mass or more and 99% by mass or less, and particularly preferably 30% by mass or more and 90% by mass or less, in the whole amount of the solid content in the pigment dispersion.

Herein, the term "whole amount of solid content in pigment dispersion" means the total amount of components obtained by removing the solvent (E) from the pigment dispersion.

A pigment dispersant is added to the red pigment, followed by performing a dispersion treatment, whereby a pigment dispersion in which the red pigment is uniformly dispersed in a pigment dispersant solution can be produced. The red pigments may be singly subjected to a dispersion treatment, or a mixture of a plurality of kinds of the red pigments may be subjected to a dispersion treatment.

Examples of the pigment dispersant include surfactants, and the pigment dispersant may be, for example, any of cationic, anionic, non-ionic, and amphoteric surfactants. Specific examples thereof include surfactants such as polyester-based, polyamine-based, and acrylic surfactants. These pigment dispersants may be used singly or in combinations of two or more thereof. Examples of the pigment dispersant include KP (trade name) (manufactured by Shin-Etsu Chemical Co., Ltd.), Flowlen (manufactured by Kyoeisha Chemical Co., Ltd.), Solsperse (manufactured by Zeneca Ltd.), EFKA (manufactured by BASF Corporation), AJISPER (manufactured by Ajinomoto Fine-Techno Co., Inc.), Disperbyk (manufactured by BYK-Chemie Corporation), and BYK (registered trademark) (manufactured by BYK-Chemie Corporation).

When the pigment dispersant is used, the amount of the pigment dispersant used is preferably 100 parts by mass or less, and more preferably 5 parts by mass or more and 50 parts by mass or less, relative to 100 parts by mass of the red pigment. When the amount of the pigment dispersant used falls within the above-mentioned range, there is a tendency that the pigment dispersion having a uniform dispersion state is obtained.

In the present invention, the whole amount of the solid content and the content of each of the components with respect thereto can be measured by known analysis means such as liquid chromatography or gas chromatography.

[Xanthene Dye]

A xanthene dye is a dye containing a compound having a xanthene skeleton in its molecule. Examples of the xanthene dye include C.I. Acid Reds 51 (hereinafter, the term "C. I. Acid Red" is omitted and only the number is described, the same applies for the others), 52, 87, 92, 94, 289, and 388, C.I. Acid Violets 9, 30, and 102, C.I. Basic Reds 1 (Rhodamine 6G), 2, 3, 4, and 8, C.I. Basic Reds 10 and 11, C.I. Basic Violets 10 (Rhodamine B), and 11, C.I. Solvent Red 218, C.I. Mordant Red 27, C.I. Reactive Red 36 (Rose Bengal B), Sulforhodamine G, a xanthene dye described in Japanese Patent Laid-Open No. 2010-32999, and a xanthene dye described in Japanese Patent Publication No. 4492760. The xanthene dye is preferably dissolved in an organic solvent.

Among these, the xanthene dye is preferably a dye containing a compound represented by formula (1a) (hereinafter, sometimes referred to as "compound (1a)"). The compound (1a) may be a tautomer of the compound. When the compound (1a) is used, the content of the compound (1a) in the xanthene dye is preferably 50% by mass or more, more preferably 70% by mass or more, and still more preferably 90% by mass or more. In particular, only the compound (1a) is preferably used as the xanthene dye. The compound represented by formula (1a) also includes a tautomer of the compound.

[Formula 4]

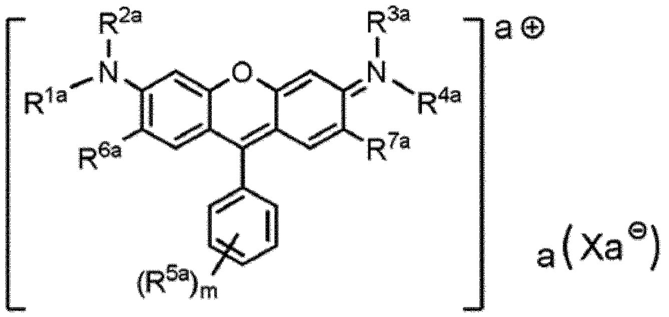

(1a)

wherein

$R^{1a}$ to $R^{4a}$ each independently represent a hydrogen atom, a monovalent saturated hydrocarbon group having 1 to 20 carbon atoms and optionally having a substituent, or a monovalent saturated hydrocarbon group having 6 to 10 carbon atoms and optionally having a substituent, and $-CH_2-$ contained in the saturated hydrocarbon group is optionally replaced with -O-, -CO-, or $-NR^{11a}-$; $R^{1a}$ and $R^{2a}$ together may form a nitrogen atom-containing ring, and $R^{3a}$ and $R^{4a}$ together may form a nitrogen atom-containing ring;

$R^{5a}$ represents a halogen atom, -OH, $-SO_3^-$, $SO_3H$, $-SO_3^-$ $Za^+$, $-CO_2H$, $-CO_2^-Za^+$, $-CO_2R^{8a}$, $-SO_3R^{8a}$, or $-SO_2NR^{9a}R^{10a}$;

$R^{6a}$ and $R^{7a}$ each independently represent a hydrogen atom or an alkyl group having 1 to 6 carbon atoms;

m represents an integer of 0 to 5; when m is 2 or more, a plurality of $R^{5a}$ may be the same or different;

a represents an integer of 0 or 1;

$Xa^-$ represents a counter ion;

$Za^+$ represents $^+N(R^{11a})_4$, $Na^+$, or $K^+$, and four $R^{11a}$ may be the same or different;

$R^{8a}$ represents a monovalent saturated hydrocarbon group having 1 to 20 carbon atoms, and a hydrogen atom contained in the saturated hydrocarbon group is optionally replaced with a halogen atom;

$R^{9a}$ and $R^{10a}$ each independently represent a hydrogen atom or a monovalent saturated hydrocarbon group having 1 to 20 carbon atoms and optionally having a substituent, and $-CH_2-$ contained in the saturated hydrocarbon group is optionally replaced with -O-, -CO-, -NH-, or $-NR^{8a}-$. $R^{9a}$ and $R^{10a}$ may be bonded to each other to form a 3- to 10-membered heterocycle containing a nitrogen atom; and

$R^{11a}$ represents a hydrogen atom, a monovalent saturated hydrocarbon group having 1 to 20 carbon atoms, or an aralkyl group having 7 to 10 carbon atoms.

In formula (1a), when $-SO_3^-$ is present, the number thereof is 1.

Examples of the monovalent aromatic hydrocarbon group having 6 to 10 carbon atoms in $R^{1a}$ to $R^{4a}$ include a phenyl group, a toluyl group, a xylyl group, a mesityl group, a propylphenyl group, and a buthylphenyl group.

Examples of the substituent that the aromatic hydrocarbon group optionally has include a halogen atom, a carboxy group, an organosilicon group, $-R^{8a}$, -OH, - $OR^{8a}$, $-SO_3^-$, $-SO_3H$, $-SO_3^-Za^+$, $-CO_2H$, $-CO_2R^{8a}$, $-SR^{8a}$, $-SO_2R^{8a}$, $-SO_3R^{8a}$, and $-SO_2NR^{9a}R^{10a}$. Among these, the substituent is preferably an organosilicon group, $-SO_3^-$, $-SO_3H$, $-SO_3^-$ $Za^+$, and $-SO_2NR^{9a}R^{10a}$, and more preferably an organosilicon group, $-SO_3^-Za^+$ and $-SO_2NR^{9a}R^{10a}$. In this case, $-SO_3^-$ $Za^+$ is preferably $-SO_3^{-+}N(R^{11a})_4$. When $R^{1a}$ to $R^{4a}$ are these groups, a color filter can be formed, which reduces the occurrence of foreign matters from the colored curable resin composition of the present invention containing the compound (1a) and has excellent heat resistance. The organosilicon group represents a group having a carbonsilicon bond.

The organosilicon group may be a group represented, for example, by formula (ii).

$$-R^{50a}-Si(R^{29a})_3 \qquad (ii)$$

wherein

$R^{29a}$ represents a hydrogen atom, a hydroxy group, an alkyl group having 1 to 4 carbon atoms, or an alkoxy group having 1 to 4 carbon atoms, and a plurality of $R^{29a}$ may be the same or different;

$R^{50a}$ represents an alkanediyl group having 1 to 10 carbon atoms, and $-CH_2-$ constituting the alkanediyl group is optionally replaced with -O-, -CO-, $-NR^{51a}-$, -OCO-, - COO-, -OCONH-, -CONH-, or -NHCO-; and

$R^{51a}$ represents a hydrogen atom or a monovalent saturated hydrocarbon group having 1 to 20 carbon atoms.

$R^{29a}$ is preferably a hydroxy group and an alkoxy group having 1 to 4 carbon atoms; and specific examples of the organosilicon group include a silyloxy group, for example, a trimethylsilyloxy group, a triethylsilyloxy group, a trimethoxysilyl group, and a triethoxysilyl group.

Examples of the group represented by formula (ii) include a group represented by the following formula (ii-13) to a group represented by the following formula (ii-24), and a group represented by the following formula (i-1) to a group represented by the following formula (i-12) .

[Formula 5]

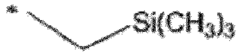
(ii-13)

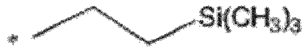
(ii-14)

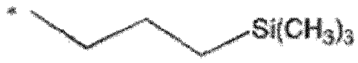
(ii-15)

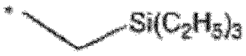
(ii-16)

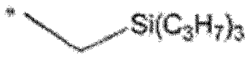
(ii-17)

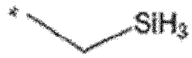
(ii-18)

[Formula 6]

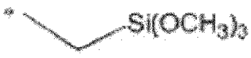
(i-1)

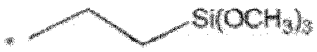
(i-2)

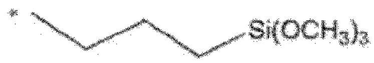
(i-3)

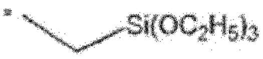
(i-4)

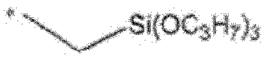
(i-5)

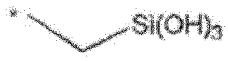
(i-6)

Examples of the group in which $-CH_2-$ constituting $R^{50a}$ in formula (ii) is replaced with -O- include groups represented as follows (* represents a point of attachment).

[Formula 7]

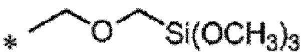
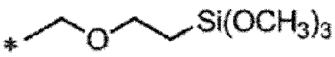
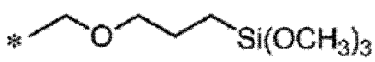

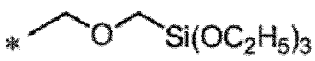
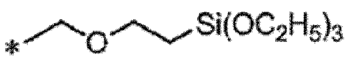
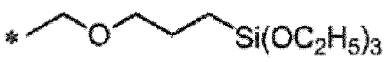

[Formula 8]

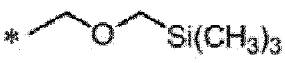
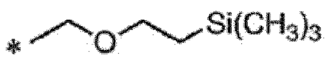
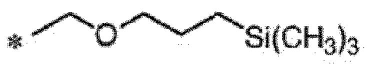

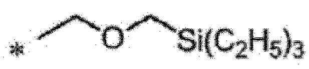
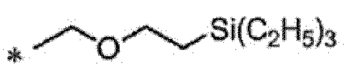
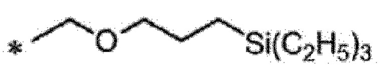

Examples of the group in which $-CH_2-$ constituting $R^{50a}$ in formula (ii) is replaced with -CO- include groups

represented as follows (* represents a point of attachment).

[Formula 9]

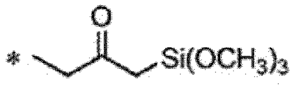 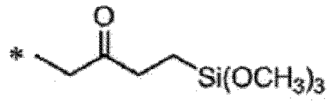 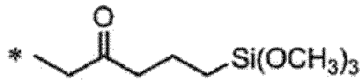

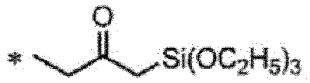 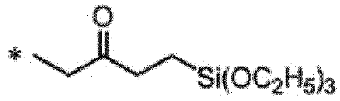 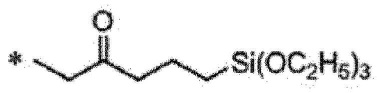

[Formula 10]

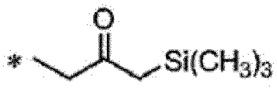 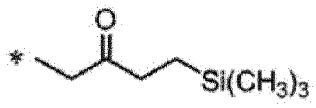 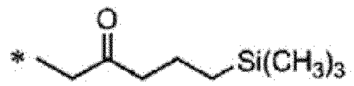

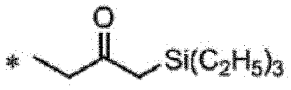 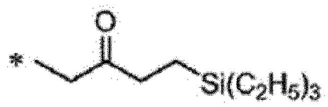 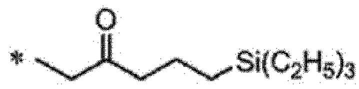

Examples of the group in which $-CH_2-$ constituting $R^{50a}$ in formula (ii) is replaced with $-NR^{11}-$ include groups represented as follows (* represents a point of attachment).

[Formula 11]

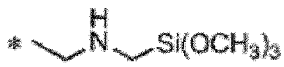 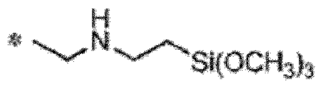 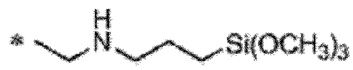

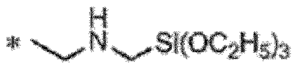 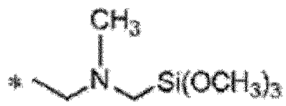 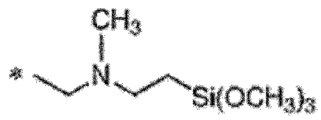

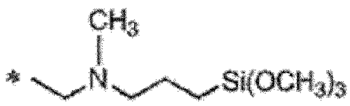 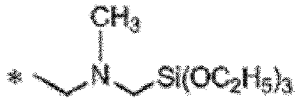 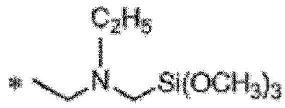

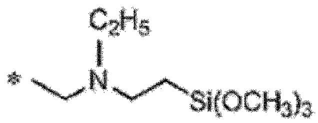 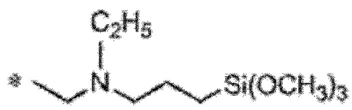 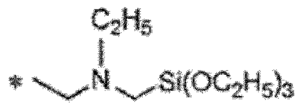

[Formula 12]

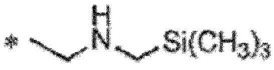
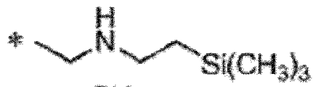
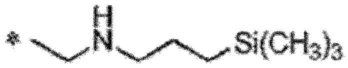
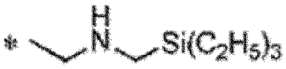
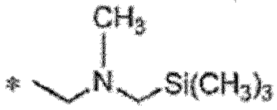
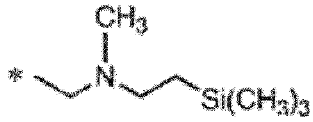
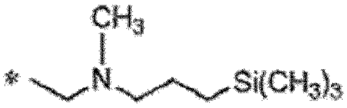
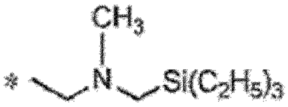
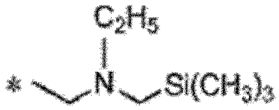
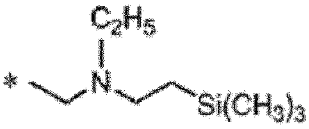
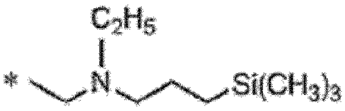
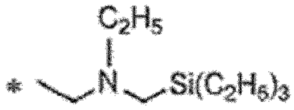

Examples of the group in which $-CH_2-$ constituting $R^{50a}$ in formula (ii) is replaced with -OCO- include groups represented as follows (* represents a point of attachment).

[Formula 13]

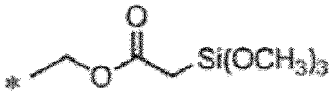
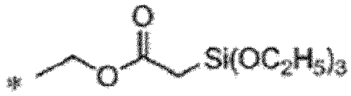
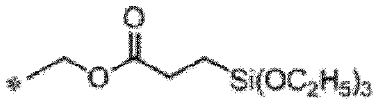
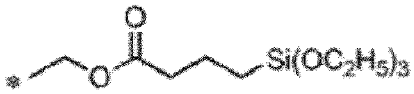

[Formula 14]

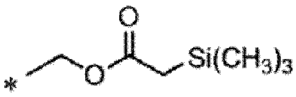
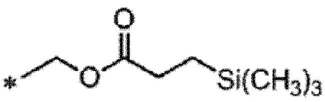
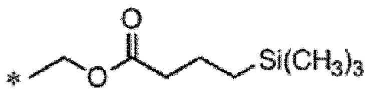
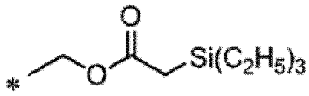
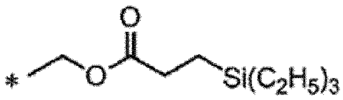
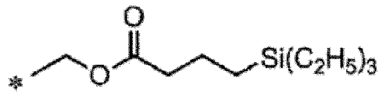

Examples of the group in which $-CH_2-$ constituting $R^{50a}$ in formula (ii) is replaced with -COO- include groups represented as follows (* represents a point of attachment).

[Formula 15]

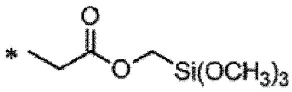
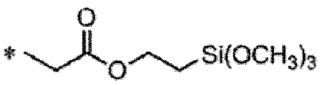
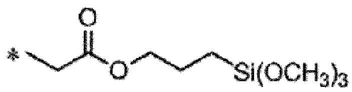
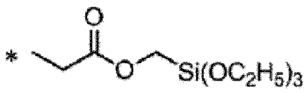
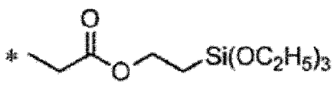
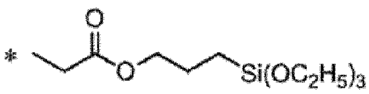

[Formula 16]

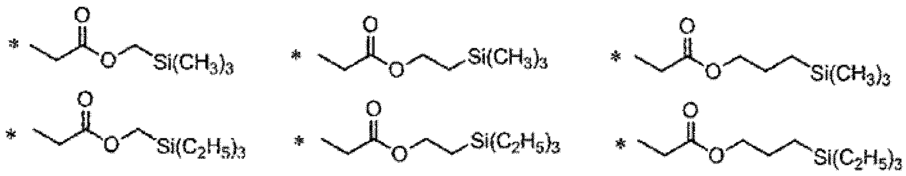

Examples of the group in which $-CH_2-$ constituting $R^{50a}$ in formula (ii) is replaced with -OCONH- include groups represented as follows (* represents a point of attachment).

[Formula 17]

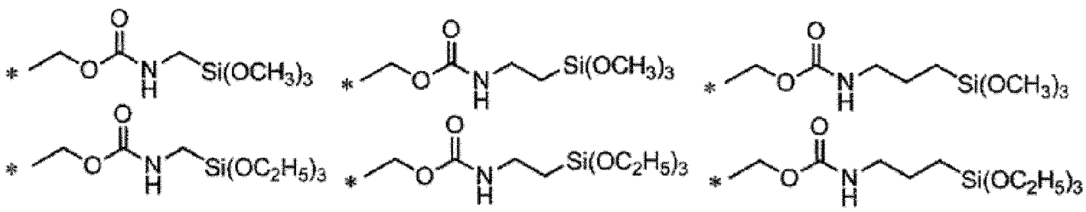

[Formula 18]

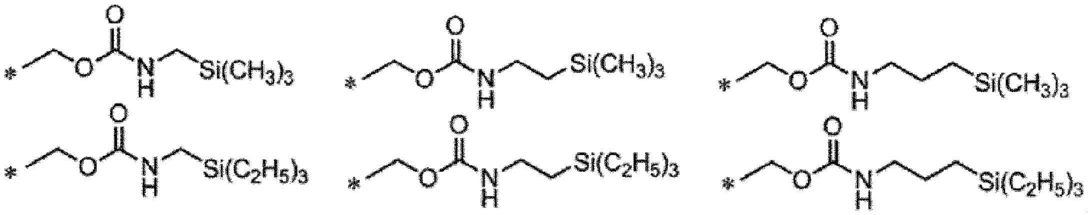

Examples of the group in which $-CH_2-$ constituting $R^{50a}$ in formula (ii) is replaced with -CONH- include groups represented as follows (* represents a point of attachment).

[Formula 19]

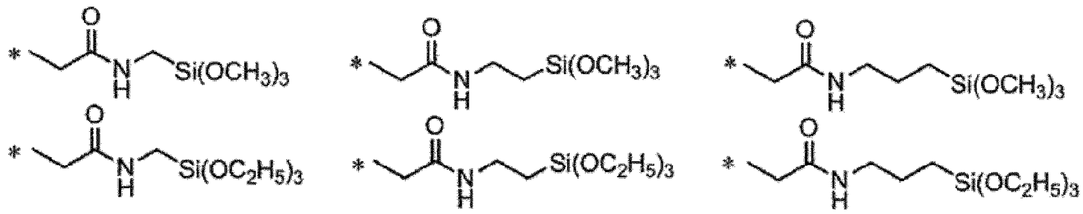

[Formula 20]

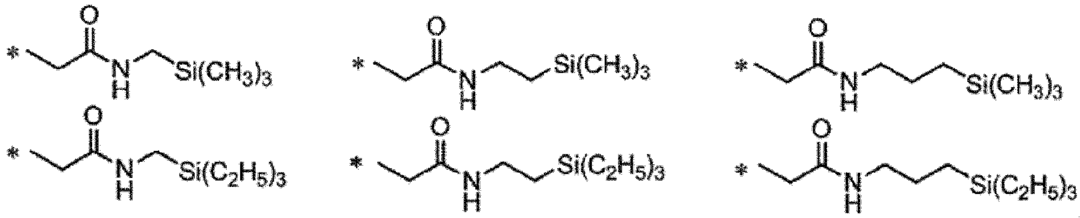

Examples of the group in which $-CH_2-$ constituting $R^{50a}$ in formula (ii) is replaced with -NHCO- include groups

represented as follows (* represents a point of attachment).

[Formula 21]

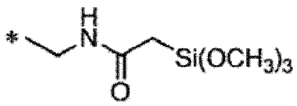 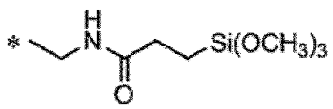 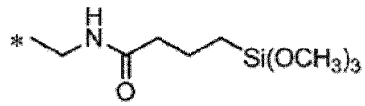

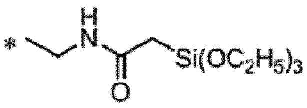 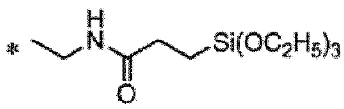 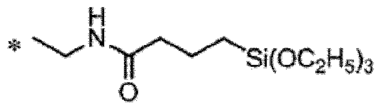

[Formula 22]

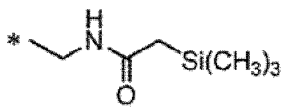 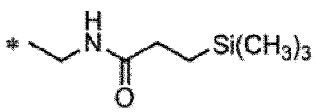 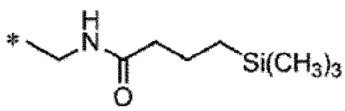

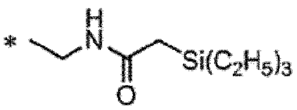 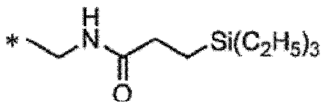 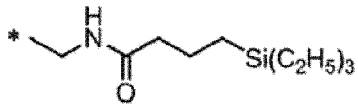

Examples of the monovalent saturated hydrocarbon group having 1 to 20 carbon atoms in $R^{1a}$ to $R^{4a}$ and $R^{8a}$ to $R^{11a}$ include linear alkyl groups such as a methyl group, an ethyl group, a propyl group, a butyl group, a pentyl group, a hexyl group, a heptyl group, an octyl group, a nonyl group, a decyl group, a dodecyl group, a hexadecyl group, and an icosyl group; branched alkyl groups such as an isopropyl group, an isobutyl group, an isopentyl group, a neopentyl group, and a 2-ethylhexyl group; and alicyclic saturated hydrocarbon groups having 3 to 20 carbon atoms such as a cyclopropyl group, a cyclopentyl group, a cyclohexyl group, a cycloheptyl group, a cyclooctyl group, and a cyclodecyl group.

The hydrogen atom contained in the saturated hydrocarbon group in $R^{1a}$ to $R^{4a}$ is optionally replaced with, for example, a carboxy group, an aromatic hydrocarbon group having 6 to 10 carbon atoms, an organosilicon group, or a halogen atom. The exemplification of the aromatic hydrocarbon group having 6 to 10 carbon atoms is the same as that of the above. The exemplification and preferable range of the organosilicon group are the same as those of the above.

The hydrogen atom contained in the saturated hydrocarbon group in $R^{9a}$ and $R^{10a}$ is optionally replaced with, for example, a hydroxy group, an organosilicon group, or a halogen atom. The exemplification of the aromatic hydrocarbon group having 6 to 10 carbon atoms is the same as that of the above. The exemplification and preferable range of the organosilicon group are the same as those of the above.

Examples of the ring that $R^{1a}$ and $R^{2a}$ together form and the ring that $R^{3a}$ and $R^{4a}$ together form include the following.

[Formula 23]

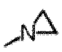 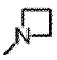 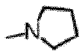 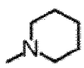 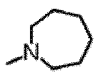 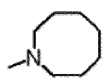 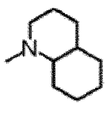 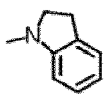 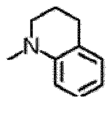

Examples of $-OR^{8a}$ include a methoxy group, an ethoxy group, a propoxy group, a butoxy group, a pentyloxy group, a hexyloxy group, a heptyloxy group, an octyloxy group, a 2-ethylhexyloxy group, and an icosyloxy group.

Examples of $-CO_2R^{8a}$ include a methoxycarbonyl group, an ethoxycarbonyl group, a propoxycarbonyl group, a tert-butoxycarbonyl group, a hexyloxycarbonyl group, and an icosyloxycarbonyl group.

Examples of $-SR^{8a}$ include a methylsulfanyl group, an ethylsulfanyl group, a butylsulfanyl group, a hexylsulfanyl group, a decylsulfanyl group, and an icosylsulfanyl group.

Examples of $-SO_2R^{8a}$ include a methylsulfonyl group, an ethylsulfonyl group, a butylsulfonyl group, a hexylsulfonyl group, a decylsulfonyl group, and an icosylsulfonyl group.

Examples of $-SO_3R^{8a}$ include a methoxysulfonyl group, an ethoxysulfonyl group, a propoxysulfonyl group, a tert-butoxysulfonyl group, a hexyloxysulfonyl group, and an icosyloxysulfonyl group.

Examples of $-SO_2NR^{9a}R^{10a}$ include a sulfamoyl group; N-1-substituted sulfamoyl groups such as an N-methylsulfamoyl group, an N-ethylsulfamoyl group, an N-propylsulfamoyl group, an N-isopropylsulfamoyl group, an N-butylsulfamoyl group, an N-tert-butylsulfamoyl group, an N-pentylsulfamoyl group, an NN-(1,1-dimethylpropyl)sulfamoyl group, an N-(2,2-dimethylpropyl)sulfamoyl group, an NN-(2-methylbutyl)sulfamoyl group, an N-cyclopentylsulfamoyl group, an N-hexylsulfamoyl group, an N-(1,3-dimethylbutyl)sulfamoyl group, an N-heptylsulfamoyl group, an N-(1-methylhexyl)sulfamoyl group, an N-octylsulfamoyl group, an N-(2-ethylhexyl)sulfamoyl group, and an N-(1,1,2,2-tetramethylbutyl)sulfamoyl group; and N,N-2-substituted sulfamoyl groups such as an N,N-dimethylsulfamoyl group, an N,N-ethylmethylsulfamoyl group, an N,N-dietmylsulfamoyl group, an N,N-propylmethylsulfamoyl group, an N,N-isopropylmethylsulfamoyl group, an N,N-tert-butylmethylsulfamoyl group, an N,N-butylethylsulfamoyl group, an N,N-bis(1-methylpropyl)sulfamoyl group, and an N,N-heptylmethylsulfamoyl group.

$R^{5a}$ is preferably $-CO_2H$, $-CO_2^-Za^+$, $-CO_2R^{8a}$, $-SO_3^-$, $-SO_3^-\ Za^+$, $-SO_3H$, or $SO_2NHR^{9a}$, and more preferably $SO_3^-$, $-SO_3^-Za^+$, $-SO_3H$, or $SO_2NHR^{9a}$.

m is preferably 1 to 4, and more preferably 1 or 2.

Examples of the alkyl group having 1 to 6 carbon atoms in $R^{6a}$ and $R^{7a}$ include the alkyl groups having 1 to 6 carbon atoms among the above-mentioned alkyl groups.

Examples of the aralkyl group having 7 to 10 carbon atoms in $R^{11a}$ include a benzyl group, a phenylethyl group, and a phenylbutyl group.

$Za^+$ is $^+N(R^{11a})_4$, $Na^+$, or $K^+$, and preferably $^+N(R^{11a})_4$.

In the above $^+N(R^{11a})_4$, at least two of four $R^{11a}$ are preferably monovalent saturated hydrocarbon groups having 5 to 20 carbon atoms. The total number of carbon atoms of four $R^{11a}$ is preferably 20 to 80, and more preferably 20 to 60. When $^+N(R^{11a})_4$ is present in the compound (1a), and $R^{11a}$ are these groups, a color filter having less foreign matters can be formed from the colored curable resin composition of the present invention containing the compound (1a).

Examples of the counter ion represented by $Xa^-$ include halide ions, and counter ions represented by formula (y1) and formula (y2).

[Formula 24]

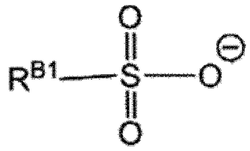

(y1)

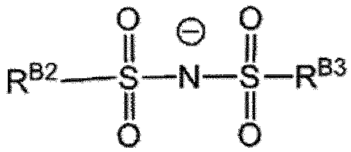

(y2)

In formula (y1), $R^{B1}$ represents a fluorinated alkyl group having 1 to 12 carbon atoms;

In formula (y2), $R^{B2}$ and $R^{B3}$ each independently represent a halogen atom or a fluorinated alkyl group having 1 to 12 carbon atoms; and

Examples of the halide ions include a fluoride ion, a chloride ion, a bromide ion, and an iodide ion.

Specific examples of the fluorinated alkyl group having 1 to 12 carbon atoms and represented by $R^{B1}$ include a fluoromethyl group, a difluoromethyl group, a trifluoromethyl group, a 1,1,2,2,2-pentafluoroethyl group, a 2,2,2-trifluoroethyl group, a 3-(trifluoromethyl)-3,4,4,4-pentafluorobutyl group, a perfluoroethyl group, a perfluoropropyl group, a perfluoroisopropyl group, a perfluorobutyl group, a perfluoro-sec-butyl group, a perfluoro-tert-butyl group, a perfluoropentyl group, and a perfluorohexyl group. Preferred examples thereof include groups in which all hydrogen atoms are replaced with fluorine atoms. More preferred examples thereof include $-CF_3$, $-CF_2CF_3$,$-CF_2CF_2CF_3$, $-\ CF(CF_3)_2$, $-CF_2CF_2CF_2CF_3$, $-CF_2CF\ (CF_3)_2$, and$-C(CF_3)_3$.

Examples of the halogen atom represented by $R^{B2}$ and $R^{B3}$ include a fluorine atom, a chlorine atom, a bromine atom, and an iodine atom, and a fluorine atom is preferred.

Examples of the fluorinated alkyl group having 1 to 12 carbon atoms and represented by $R^{B2}$ and $R^{B3}$ include the same as the fluorinated alkyl group represented by $R^{B1}$. Preferred examples thereof include $-CF_3$, $-CF_2CF_3$,$-CF_2CF_2CF_3$, $-\ CF(CF_3)_2$, $-CF_2CF_2CF_2CF_3$, $-CF_2CF(CF_3)_2$, and$-C(CF_3)_3$.

$R^{B2}$ and $R^{B3}$ may be bonded to each other to form a ring containing $-SO_2-N^--SO_2-$.

The compound (1a) is preferably a compound represented by formula (2a) (hereinafter, sometimes referred to as "compound (2a)"). The compound (2a) may be a tautomer of the compound.

[Formula 25]

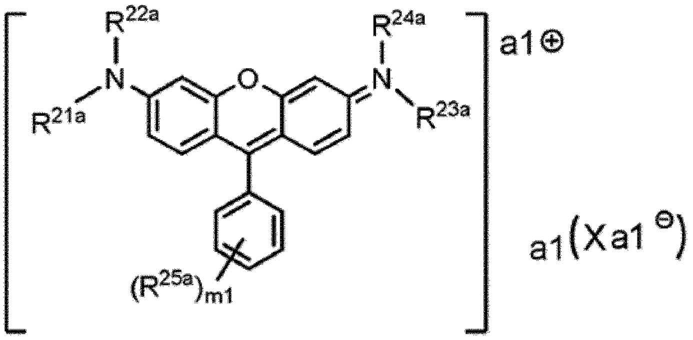

(2a)

wherein

$R^{21a}$ to $R^{24a}$ each independently represent a hydrogen atom, $-R^{26a}$, a monovalent saturated hydrocarbon group having 1 to 20 carbon atoms and optionally having a substituent, or a monovalent aromatic hydrocarbon group having 6 to 10 carbon atoms and optionally having a substituent; $R^{21a}$ and $R^{22a}$ together may form a nitrogen atom-containing ring; and $R^{23a}$ and $R^{24a}$ together may form a nitrogen atom-containing ring;
$R^{25a}$ represents a halogen atom, $-SO_3^-$, $-SO_3H$, $-SO_3^-$ $Za1^+$, or $-SO_2NHR^{26a}$;
m1 represents an integer of 0 to 5; when m1 is 2 or more, a plurality of $R^{25a}$ may be the same or different;
a1 represents an integer of 0 or 1;
$Xa1^-$ represents a counter ion;
$R^{26a}$ represents a halogen atom or a monovalent saturated hydrocarbon group having 1 to 20 carbon atoms and optionally having a carboxy group;
$Za1^+$ represents $^+N(R^{27a})_4$, $Na^+$, or $K^+$, and four $R^{27a}$ may be the same or different; and
$R^{27a}$ represents a monovalent saturated hydrocarbon group having 1 to 20 carbon atoms or a benzyl group.

Examples of the monovalent saturated hydrocarbon group having 6 to 10 carbon atoms in $R^{21a}$ to $R^{24a}$ include the same groups as those exemplified as the aromatic hydrocarbon group of $R^{1a}$ to $R^{4a}$. The hydrogen atom contained in the aromatic hydrocarbon group is optionally replaced with an organosilicon group, $-SO_3^-$, $-SO_3H$, $-SO_3^-$ $Za1^+$, $-SO_3R^{26a}$, or $-SO_2NHR^{26a}$.

In a preferred combination of $R^{21a}$ to $R^{24a}$, $R^{21a}$ and $R^{23a}$ each independently represent a hydrogen atom or a saturated hydrocarbon group having 1 to 10 carbon atoms (the saturated hydrocarbon group may have a halogen atom, an organosilicon group, or a carboxy group) ; $R^{22a}$ and $R^{24a}$ represent a monovalent aromatic hydrocarbon group having 6 to 10 carbon atoms; and the hydrogen atom contained in the aromatic hydrocarbon group is replaced with an organosilicon group, $-SO_3^-$, $-SO_3H$, $-SO_3^-Za1^+$, $-SO_3R^{26a}$, or - $SO_2NHR^{26a}$. In a more preferred combination, $R^{21a}$ and $R^{23a}$ each independently represent a hydrogen atom or an alkyl group having 1 to 8 carbon atoms (the alkyl group may have a halogen atom, an organosilicon group, or a carboxy group) ; $R^{22a}$ and $R^{24a}$ represent a monovalent aromatic hydrocarbon groups having 6 to 10 carbon atoms; and the hydrogen atom contained in the aromatic hydrocarbon group is replaced with an organosilicon group, $-SO_3^-Za1^+$, or - $SO_2NHR^{26a}$. When $R^{21a}$ to $R^{24a}$ are these groups, a color filter having excellent heat resistance can be formed from the colored curable resin composition of the present invention containing the compound (2a). The exemplification and preferable range of the organosilicon group are the same as those in the above-mentioned description of formula (1a).

Examples of the monovalent saturated hydrocarbon group having 1 to 20 carbon atoms and optionally having a substituent in $R^{21a}$ to $R^{24a}$ include the same groups as those exemplified as the above aromatic hydrocarbon group of $R^{1a}$ to $R^{4a}$. The hydrogen atom contained in the aromatic hydrocarbon group is optionally replaced with an organosilicon group, $-SO_3^-$, $SO_3H$, $-SO_3^-Za1^+$, $-SO_3R^{26a}$, or - $SO_2NHR^{26a}$. The exemplification and preferable range of the organosilicon group are the same as those in the above-mentioned description of formula (1a).

Examples of the nitrogen atom-containing ring that $R^{21a}$ and $R^{22a}$ together form and the nitrogen atom-containing ring that $R^{23a}$ and $R^{24a}$ together form include the same as the ring that $R^{1a}$ and $R^{2a}$ together form. Among these, an aliphatic heterocycle is preferred. Examples of the aliphatic heterocycle include the following.

[Formula 26]

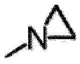 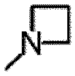 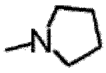 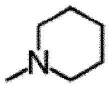 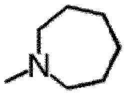 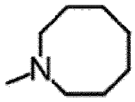 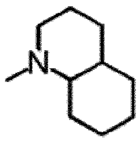

Examples of the monovalent saturated hydrocarbon group having 1 to 20 carbon atoms in $R^{26a}$ and $R^{27a}$ include the same groups as those exemplified as the saturated hydrocarbon group in $R^{8a}$ to $R^{11a}$.

It is preferable that when $R^{21a}$ to $R^{24a}$ are $-R^{26a}$, $-R^{26a}$ each independently represent a methyl group or an ethyl group. $R^{26a}$ in $-SO_3R^{26a}$ and $-SO_2NHR^{26a}$ is preferably a branched alkyl group having 3 to 20 carbon atoms, more preferably a branched alkyl group having 6 to 12 carbon atoms, and still more preferably a 2-ethylhexyl group. When $R^{26a}$ are these groups, a color filter providing less occurrence of foreign matters can be formed from the colored curable resin composition of the present invention containing the compound (2a).

$Za1^+$ is $^+N(R^{27a})_4$, $Na^+$, or $K^+$, and preferably $^+N(R^{27a})_4$.

In the above $^+N(R^{27a})_4$, at least two of four $R^{27a}$ are preferably monovalent saturated hydrocarbon groups having 5 to 20 carbon atoms. The total number of carbon atoms of four $R^{27a}$ is preferably 20 to 80, and more preferably 20 to 60. When $^+N(R^{27a})_4$ is present in the compound (2a), and $R^{27a}$ are these groups, a color filter providing less occurrence of foreign matters can be formed from the colored curable resin composition of the present invention containing the compound (2a).

m1 is preferably 1 to 4, and more preferably 1 or 2.

The exemplification and preferable range of the counter ion represented by $Xa1^-$ are the same as those in the above description of $Xa^-$.

The compound (1a) is also preferably a compound represented by formula (3a) (hereinafter, sometimes referred to as "compound (3a)"). The compound (3a) may be a tautomer of the compound.

[Formula 27]

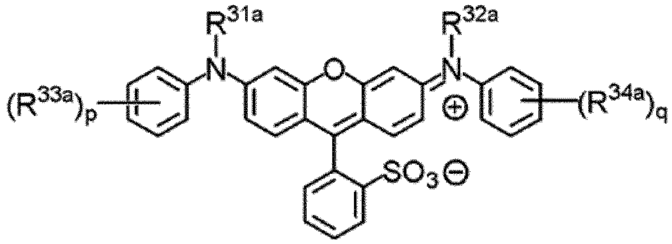

(3a)

wherein

$R^{31a}$ and $R^{32a}$ each independently represent a monovalent saturated hydrocarbon group having 1 to 10 carbon atoms; the hydrogen atom contained in the saturated hydrocarbon group is optionally replaced with an aromatic hydrocarbon group having 6 to 10 carbon atoms, a carboxy group, an organosilicon group, or a halogen atom; the hydrogen atom contained in the aromatic hydrocarbon group is optionally replaced with an organosilicon group or an alkoxy group having 1 to 3 carbon atoms; and $-CH_2-$ contained in the saturated hydrocarbon group is optionally replaced with -O-, -CO-, or $-NR^{11a}-$;

$R^{33a}$ and $R^{34a}$ each independently represent an organosilicon group, an alkyl group having 1 to 4 carbon atoms, an alkylsulfanyl group having 1 to 4 carbon atoms, or an alkylsulfonyl group having 1 to 4 carbon atoms;

$R^{31a}$ and $R^{33a}$ together may form a nitrogen atom-containing ring, and $R^{32a}$ and $R^{34a}$ together may form a nitrogen atom-containing ring;

p and q each independently represent an integer of 0 to 5; when p is 2 or more, a plurality of $R^{33a}$ may be the same or different, and when q is 2 or more, a plurality of $R^{34a}$ may be the same or different; and

$R^{11a}$ represents the same meaning as the above.

Examples of the monovalent saturated hydrocarbon group having 1 to 10 carbon atoms in $R^{31a}$ and $R^{32a}$ include a group having 1 to 10 carbon atoms in $R^{8a}$.

Examples of the aromatic hydrocarbon group having 6 to 10 carbon atoms, and optionally contained as a

substituent include the same groups as those in $R^{1a}$.

Examples of the alkoxy group having 1 to 3 carbon atoms include a methoxy group, an ethoxy group, and a propoxy group.

It is preferable that $R^{31a}$ and $R^{32a}$ each independently represent a monovalent saturated hydrocarbon group having 1 to 3 carbon atoms (the saturated hydrocarbon group may have a halogen atom or a carboxy group).

The exemplification and preferable range of the organosilicon group are the same as those of the above-mentioned description of formula (1a).

Examples of the alkyl group having 1 to 4 carbon atoms in $R^{33a}$ and $R^{34a}$ include a methyl group, an ethyl group, a propyl group, a butyl group, an isopropyl group, an isobutyl group, a sec-butyl group, and a tert-butyl group.

Examples of the alkylsulfanyl group having 1 to 4 carbon atoms in $R^{33a}$ and $R^{34a}$ include a methylsulfanyl group, an ethylsulfanyl group, a propylsulfanyl group, a butylsulfanyl group, and an isopropylsulfanyl group.

Examples of the alkylsulfonyl group having 1 to 4 carbon atoms in $R^{33a}$ and $R^{34a}$ include a methylsulfonyl group, an ethylsulfonyl group, a propylsulfonyl group, a butylsulfonyl group, and an isopropylsulfonyl group.

$R^{33a}$ and $R^{34a}$ are preferably an alkyl group having 1 to 4 carbon atoms, and more preferably a methyl group.

The exemplification and preferable range of the organosilicon group in $R^{33a}$ and $R^{34a}$ are the same as those in the above-mentioned description of formula (1a).

p and q are preferably an integer of 0 to 2, and more preferably 0 or 1.

Examples of the compound (1a) include compounds represented by formula (1-1) to formula (1-97). In formulae, $R^{40a}$ represents a monovalent saturated hydrocarbon group having 1 to 20 carbon atoms, preferably a branched alkyl group having 6 to 12 carbon atoms, and more preferably a 2-ethylhexyl group. $R^{26a}$ has the same meaning as that in formula (2a).

[Formula 28]

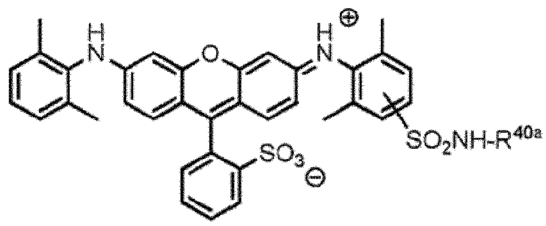

(1-1)

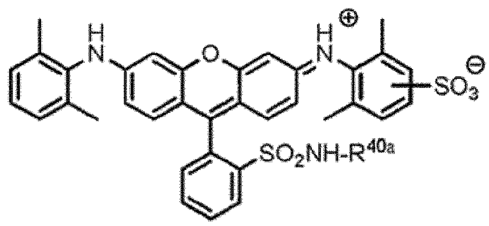

(1-2)

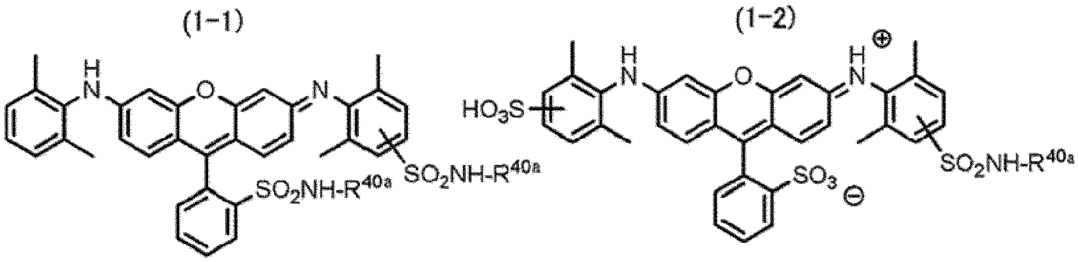

(1-3)

(1-4)

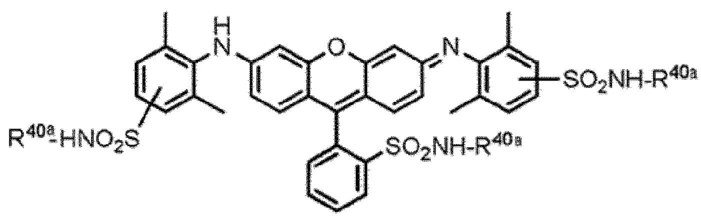

(1-5)

[Formula 29]

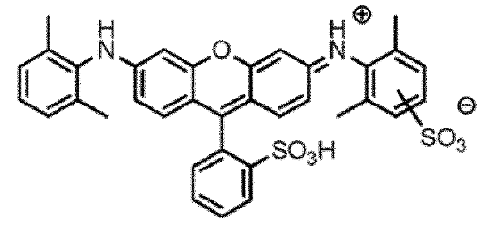

(1-6)

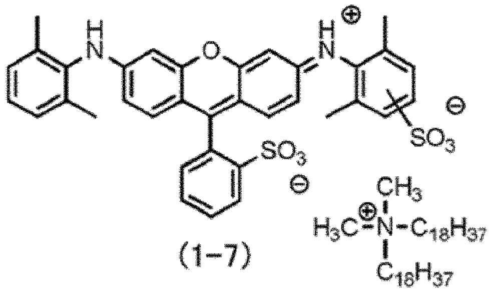

(1-7)

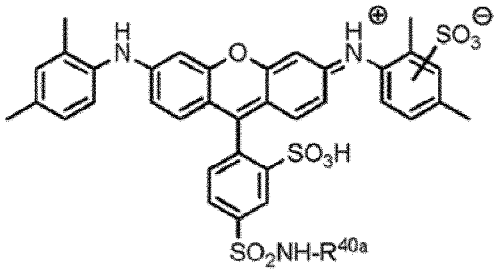

(1-8)

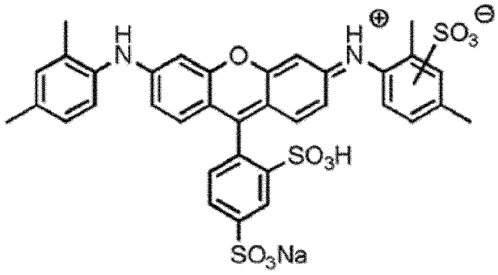

(1-9)

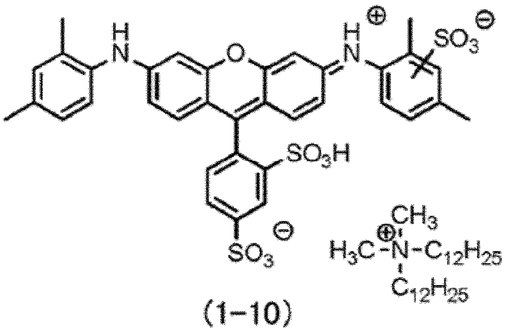

(1-10)

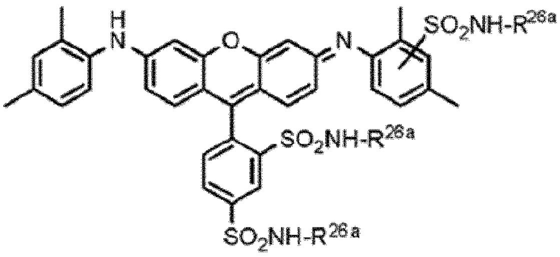

(1-11)

[Formula 30]

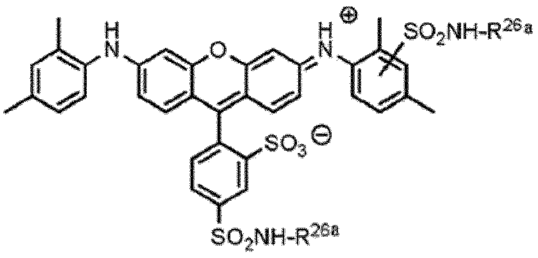

(1-12)

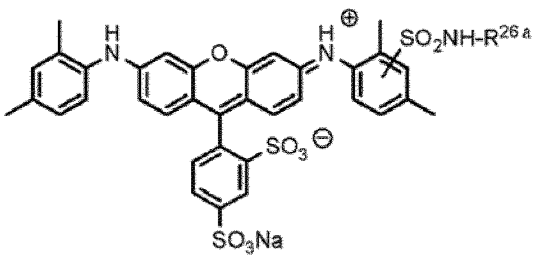

(1-13)

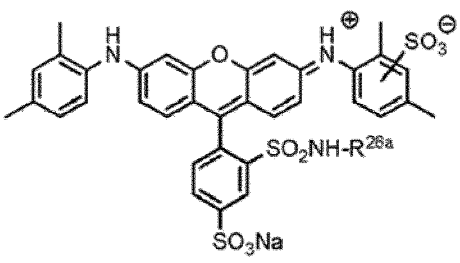

(1-14)

[Formula 31]

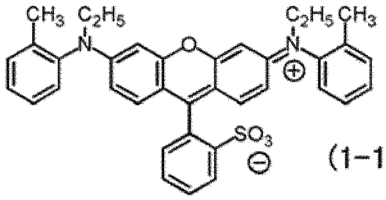
(1-15)

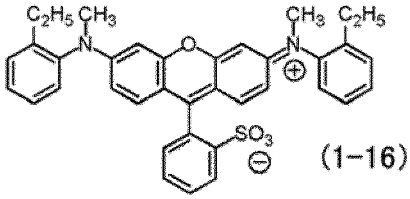
(1-16)

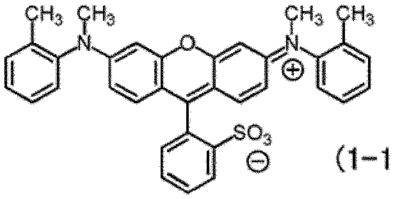
(1-17)

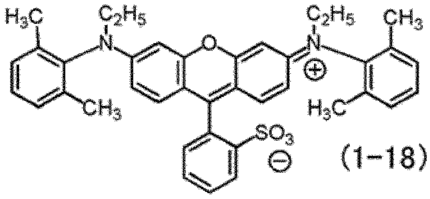
(1-18)

[Formula 32]

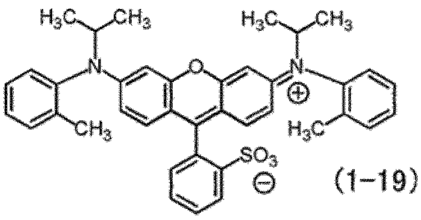
(1-19)

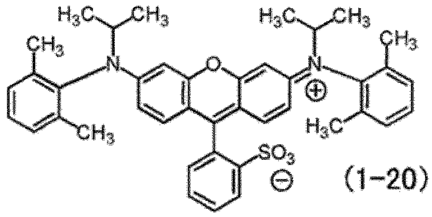
(1-20)

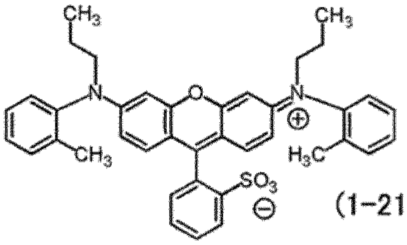
(1-21)

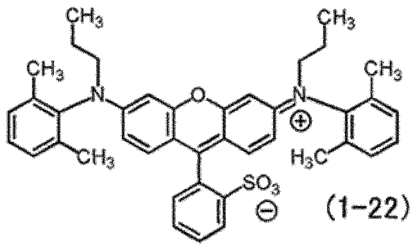
(1-22)

[Formula 33]

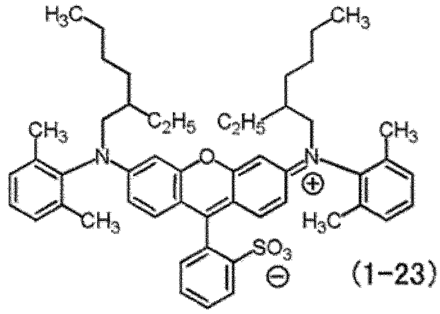

(1-23)

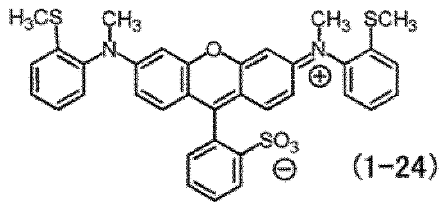

(1-24)

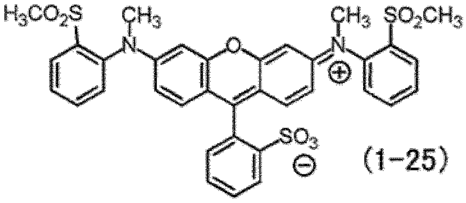

(1-25)

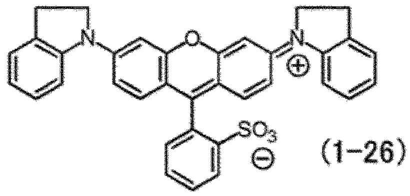

(1-26)

[Formula 34]

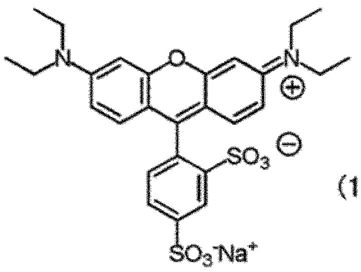

(1-27)

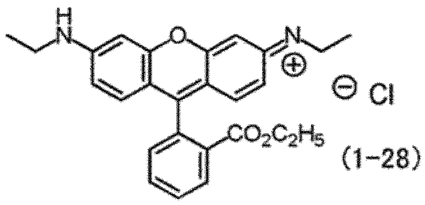

(1-28)

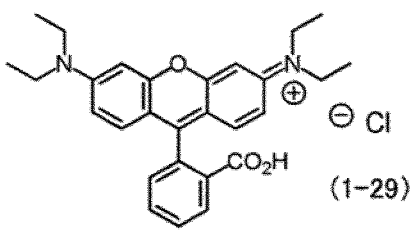

(1-29)

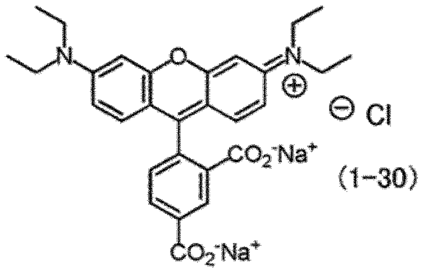

(1-30)

[Formula 35]

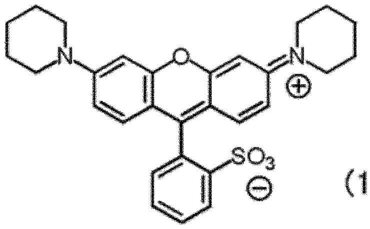

(1-31)

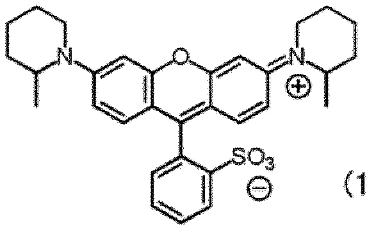

(1-32)

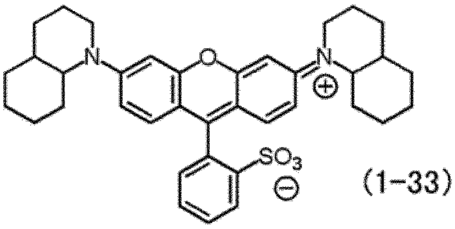

(1-33)

[Formula 36]

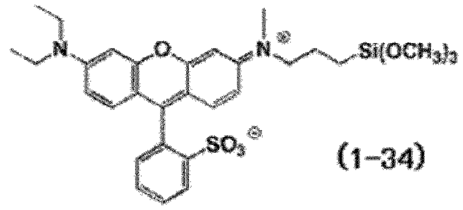
(1-34)

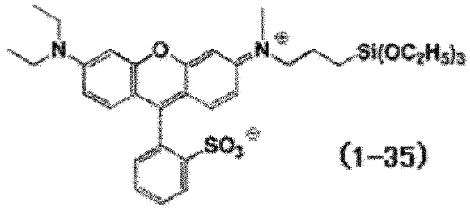
(1-35)

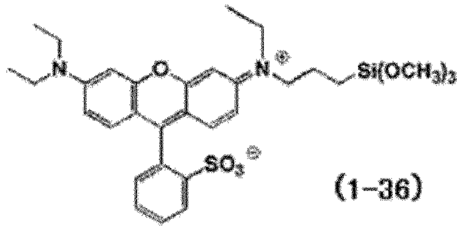
(1-36)

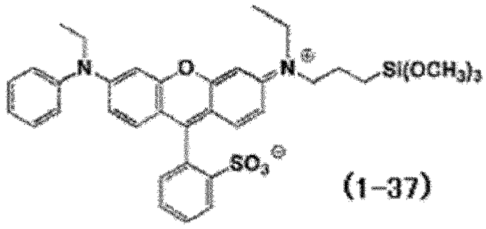
(1-37)

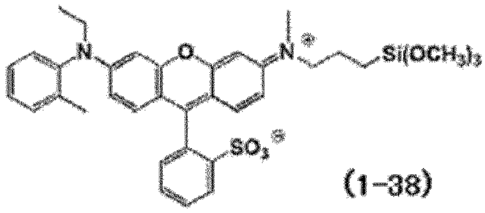
(1-38)

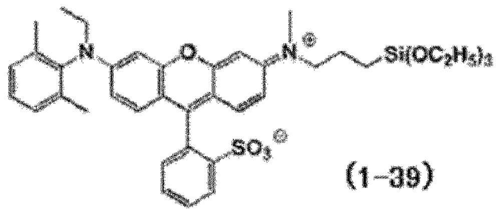
(1-39)

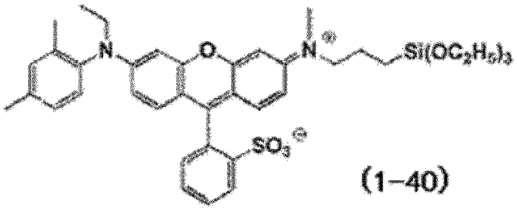
(1-40)

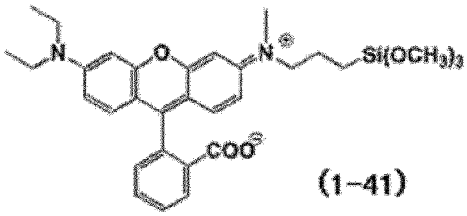
(1-41)

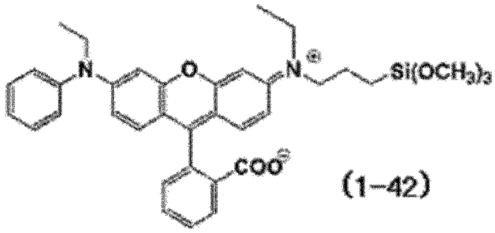
(1-42)

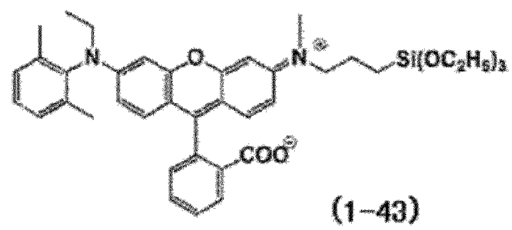
(1-43)

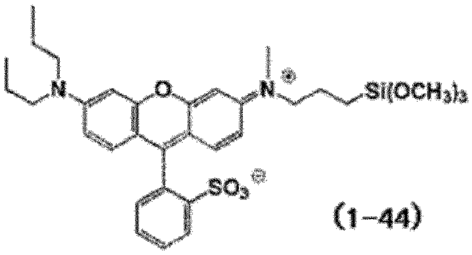
(1-44)

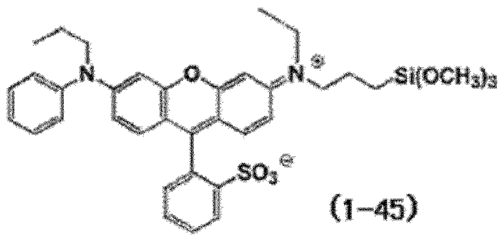
(1-45)

[Formula 37]

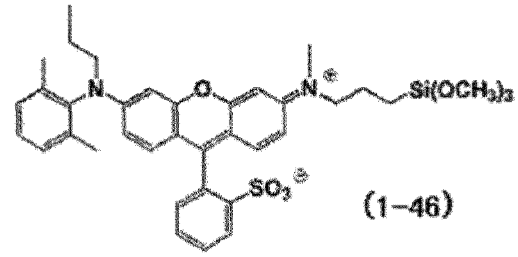
(1-46)

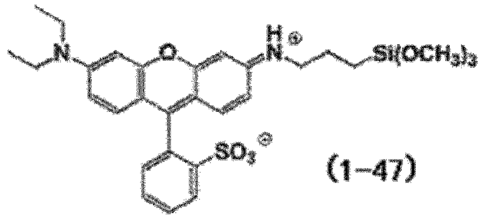
(1-47)

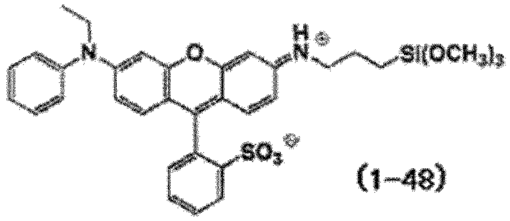
(1-48)

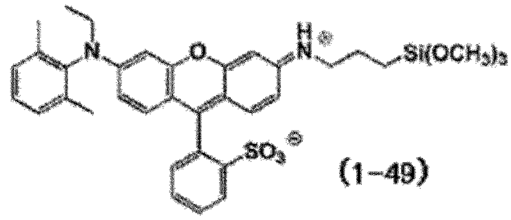
(1-49)

[Formula 38]

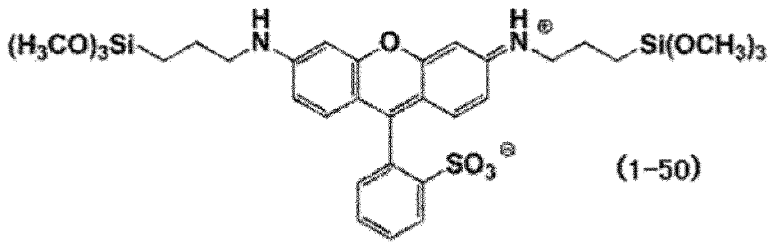
(1-50)

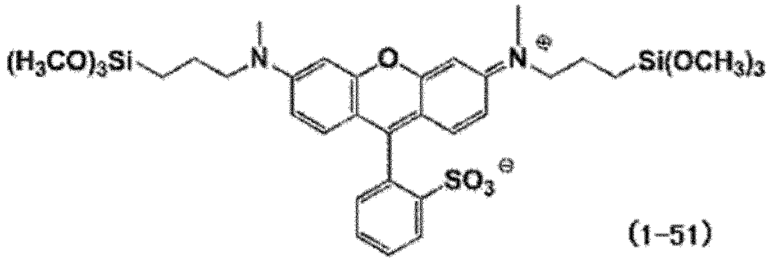
(1-51)

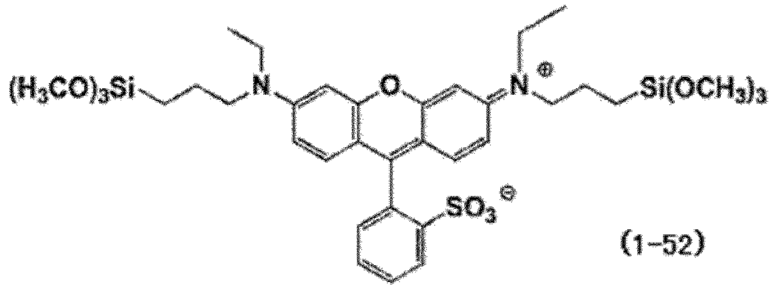
(1-52)

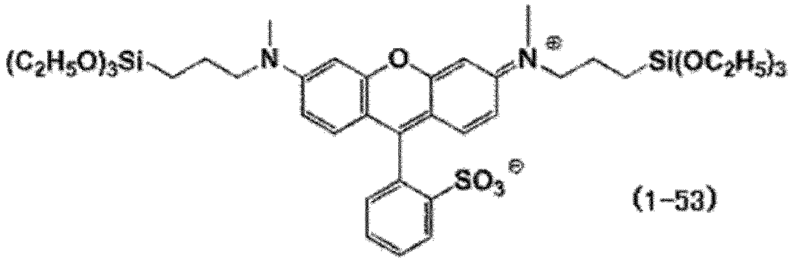
(1-53)

[Formula 39]

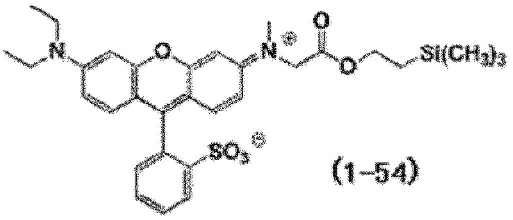

(1-54)

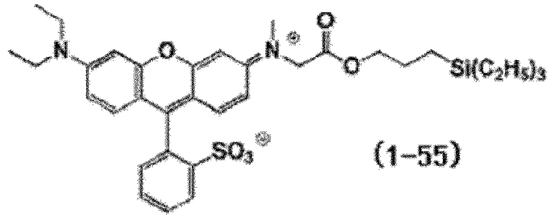

(1-55)

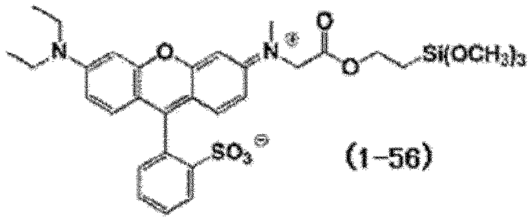

(1-56)

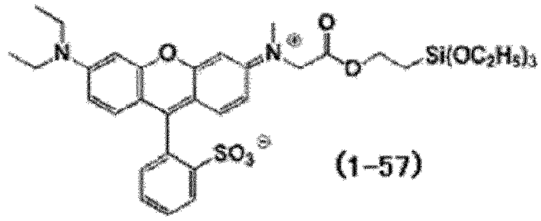

(1-57)

[Formula 40]

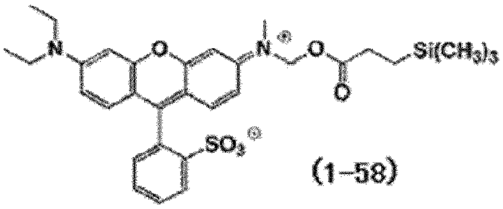

(1-58)

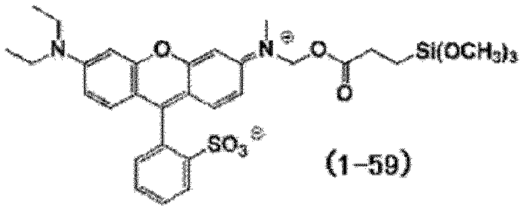

(1-59)

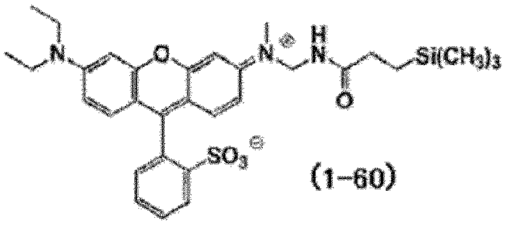

(1-60)

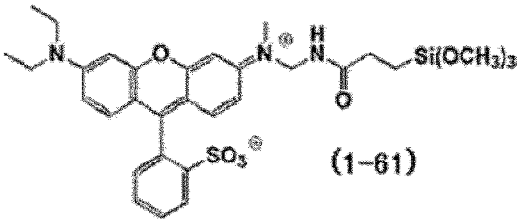

(1-61)

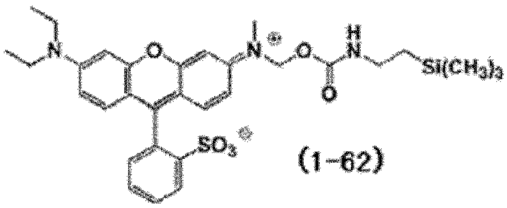

(1-62)

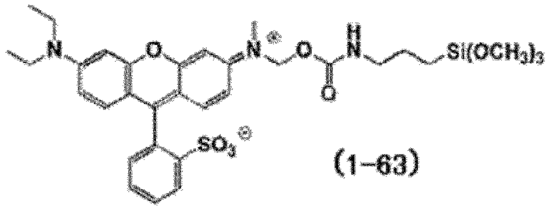

(1-63)

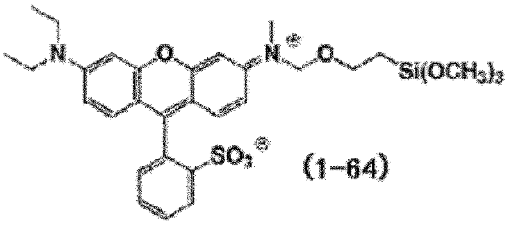

(1-64)

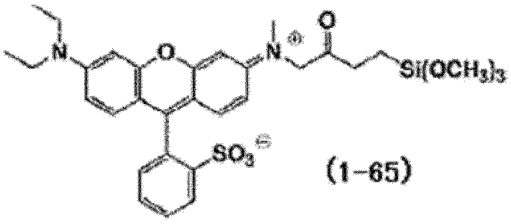

(1-65)

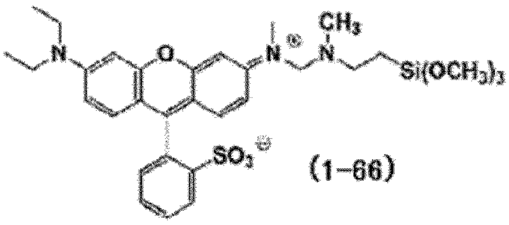

(1-66)

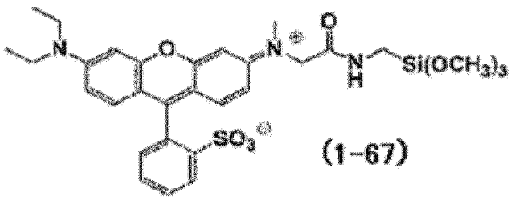

(1-67)

[Formula 41]

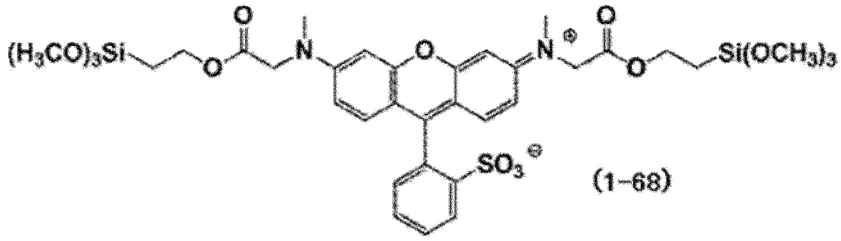

(1-68)

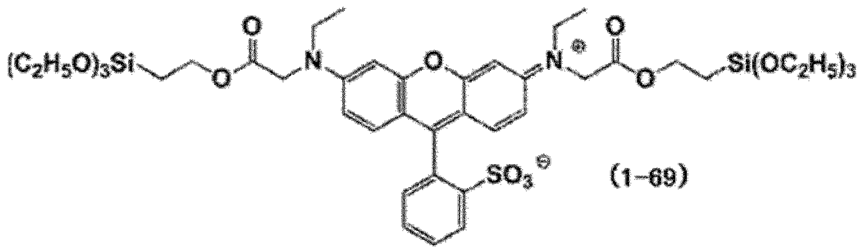

(1-69)

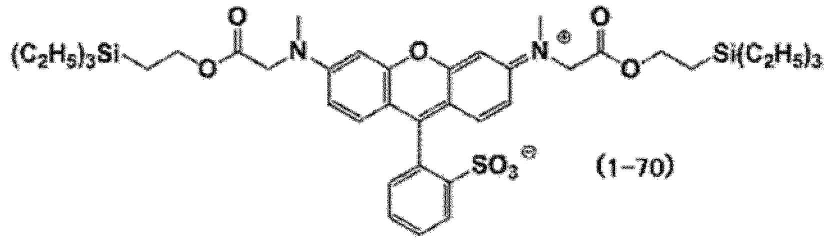

(1-70)

[Formula 42]

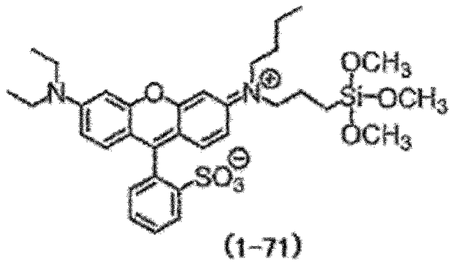

(1-71)

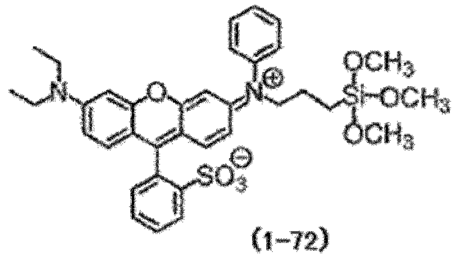

(1-72)

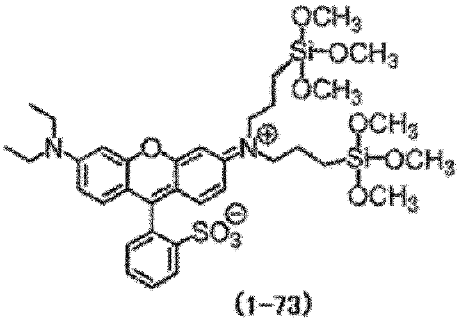

(1-73)

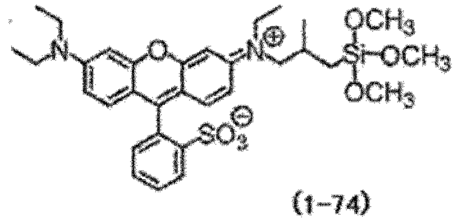

(1-74)

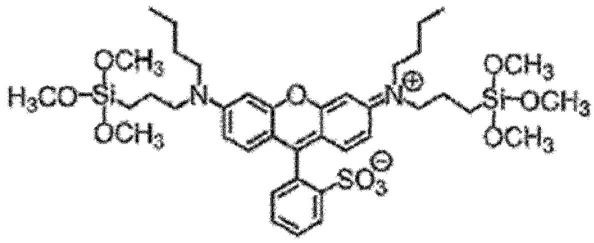

(1-75)

[Formula 43]

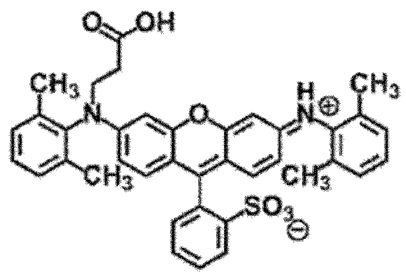

(1-76)

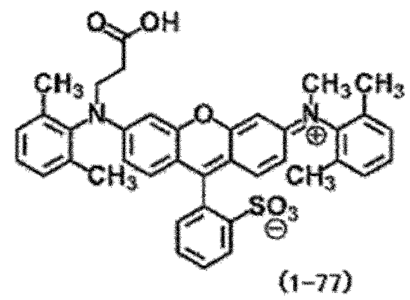

(1-77)

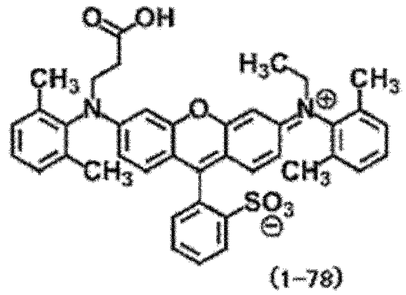

(1-78)

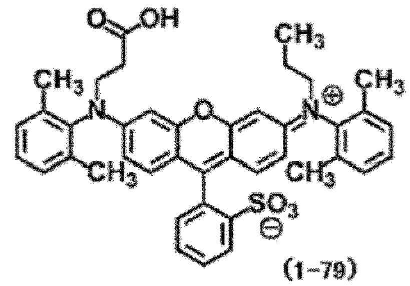

(1-79)

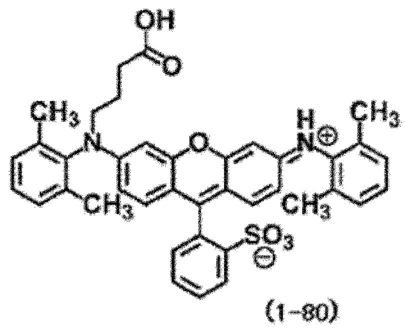

(1-80)

[Formula 44]

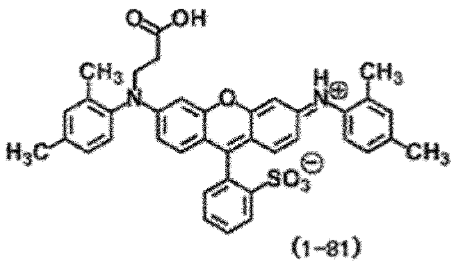

(1-81)

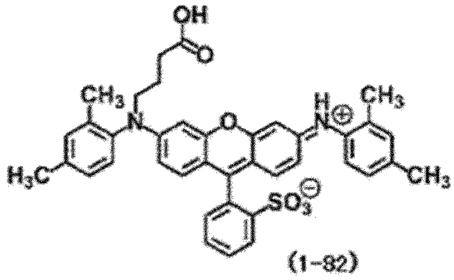

(1-82)

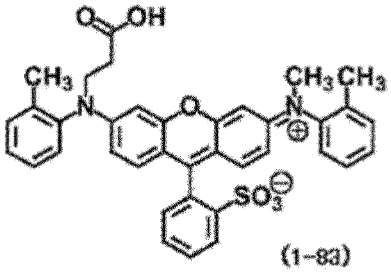

(1-83)

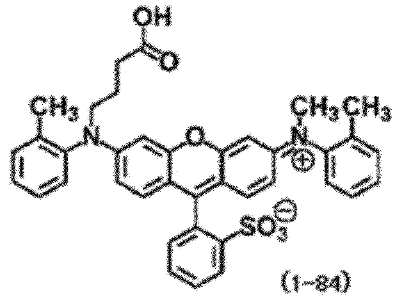

(1-84)

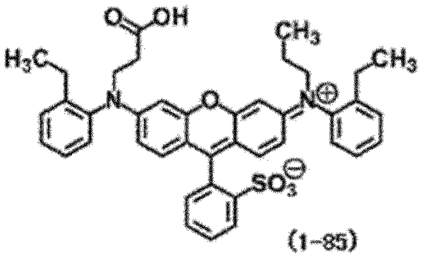

(1-85)

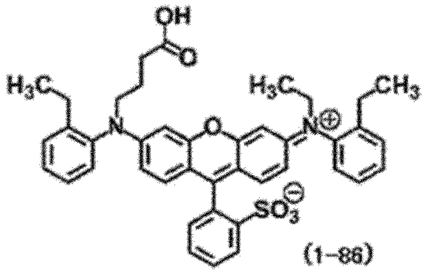

(1-86)

[Formula 45]

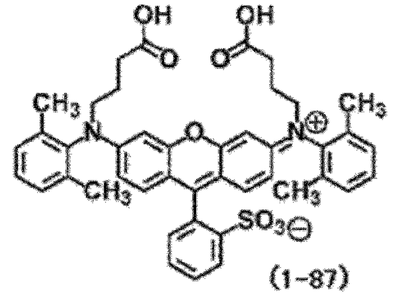

(1-87)

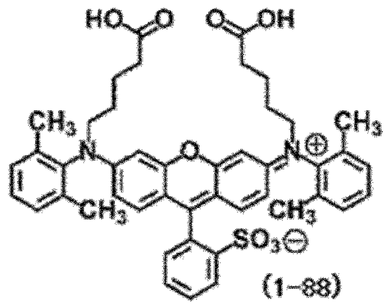

(1-88)

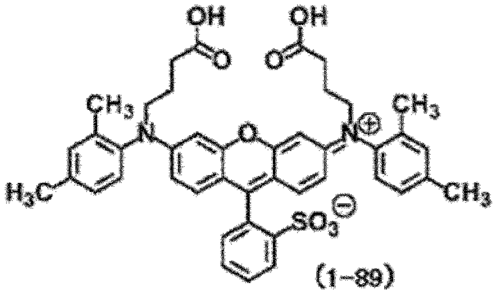

(1-89)

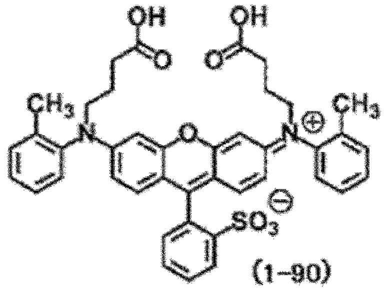

(1-90)

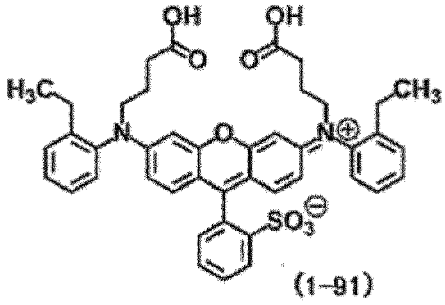

(1-91)

[Formula 46]

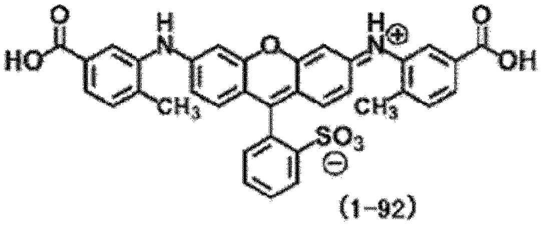

(1-92)

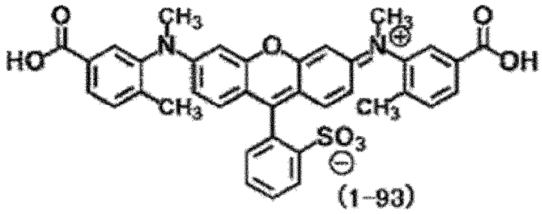

(1-93)

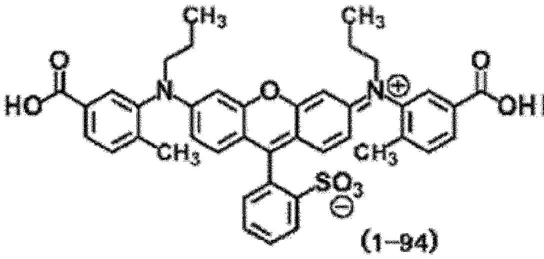

(1-94)

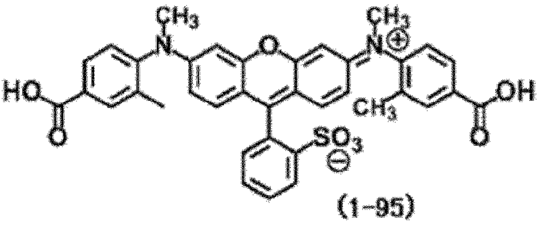

(1-95)

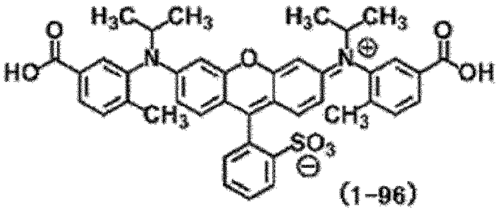

(1-96)

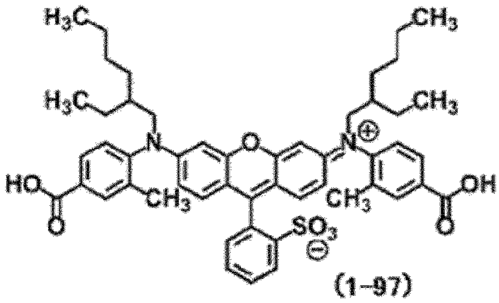

(1-97)

Among the above compounds, compounds represented by formula (1-1) to formula (1-14), formula (1-27) to formula (1-75), and formula (1-92) to formula (1-97) correspond to the compound (2a). Compounds represented by formula (1-15) to formula (1-26) and formula (1-76) to formula (1-91) correspond to the compound (3a).

Among these, the compounds represented by formula (1-22), formula (1-34), and formula (1-87) and the like are preferred.

A commercially available xanthene dye (for example, "Chugai Aminol Fast Pink R-H/C" manufactured by Chugai Kasei Co., Ltd., "Rhodamin 6G" manufactured by Taoka Chemical Co., Ltd.) can be used for the xanthene dye. The xanthene dye can also be synthesized with reference to Japanese Patent Laid-Open No. 2010-32999 using the commercially available xanthene dye as a starting material.

The content rate of the xanthene dye in the colorant (A) may be, for example, 1% by mass or more and 90% by mass or less, and is more preferably 2% by mass or more and 70% by mass or less, still more preferably 3% by mass or more and 50% by mass or less, particularly preferably 4% by mass or more and 40% by mass or less, and especially preferably 5% by mass or more and 30% by mass or less, based on the whole amount of the colorant (A).

[Azo Dye]

An azo dye is a dye containing a compound having an azo group (-N=N-) in its molecule (hereinafter, also referred to as azo compound), and preferably a dye containing an azo compound having at least one of an aromatic hydrocarbon group and a heterocyclic group.

In a preferred embodiment of the present invention, the azo dye contains a compound represented by formula (I) (hereinafter, also referred to as compound (I)).

$$A^1\text{-N=N-}B^1 \qquad (I)$$

wherein

$A^1$ represents a monovalent aromatic hydrocarbon group having 6 to 10 carbon atoms and optionally having a substituent; and

$B^1$ represents a monovalent aromatic hydrocarbon group having 6 to 14 carbon atoms and optionally having a substituent or a monovalent heterocyclic group having 3 to 14 carbon atoms and optionally having a substituent,

and $-CH_2-$ contained in the heterocyclic group is optionally replaced with -CO-.
One or two or more of the compounds (I) may be contained in the azo dye.

Examples of the monovalent aromatic hydrocarbon group having 6 to 10 carbon atoms in $A^1$ include a phenyl group, a toluyl group, a xylyl group, a mesityl group, a propylphenyl group, a buthylphenyl group, and a naphthyl group. Examples of the substituent that the monovalent aromatic hydrocarbon group having 6 to 10 carbon atoms in $A^1$ optionally has include a sulfo group, a sulfamoyl group, an N-substituted sulfamoyl group, a hydroxy group, a carboxy group, a nitro group, an alkoxy group having 1 to 8 carbon atoms, an alkylcarbonyloxy group having 1 to 10 carbon atoms, and a halogen atom. When the monovalent aromatic hydrocarbon group having 6 to 10 carbon atoms has substituents, the number of the substituents may be, for example, 1 or 2.

Examples of the N-substituted sulfamoyl group include a $-SO_2NHR^6$ group or a $-SO_2NR^6R^7$ group. $R^6$ and $R^7$ each independently represent a monovalent saturated hydrocarbon group having 1 to 16 carbon atoms and optionally having a substituent, an acyl group having 2 to 18 carbon atoms, an aryl group having 6 to 20 carbon atoms, or an aralkyl group having 7 to 20 carbon atoms.

The monovalent saturated hydrocarbon group having 1 to 16 carbon atoms may be, for example, a monovalent saturated aliphatic hydrocarbon group or saturated alicyclic hydrocarbon group having 1 to 16 carbon atoms. The saturated aliphatic hydrocarbon group may be linear, branched, or cyclic. The number of carbon atoms of the saturated aliphatic hydrocarbon group does not include the number of carbon atoms of the substituent, and the number of carbon atoms of the substituent is usually 1 to 10, and preferably 1 to 8. Examples of the saturated aliphatic hydrocarbon group include saturated aliphatic hydrocarbon groups such as a methyl group, an ethyl group, an n-propyl group, an isopropyl group, an n-butyl group, an isobutyl group, a sec-butyl group, a tert-butyl group, a methylbutyl group (a 1,1,3,3-tetramethylbutyl group or the like), a methylhexyl group (a 1-methylhexyl group, a 1,5-dimethylhexyl group or the like), and an ethylhexyl group (a 2-ethylhexyl group or the like), and saturated alicyclic hydrocarbon groups such as a cyclopentyl group, a cyclohexyl group, a methylcyclohexyl group (a 2-methylcyclohexyl group or the like), and a cyclohexylalkyl group. The hydrogen atom contained in the saturated hydrocarbon group is optionally replaced with an alkoxy group having 1 to 8 carbon atoms, an alkylcarbonyloxy group having 1 to 10 carbon atoms, or a carboxy group. Examples of the alkoxy group having 1 to 8 carbon atoms include a propoxy group and a 2-ethylhexyloxy group. Examples of the alkylcarbonyloxy group having 1 to 10 carbon atoms include an ethylcarbonyloxy group, a butyloxycarbonyl group, and an octylcarbonyloxy group. $-CH_2-$ contained in the saturated hydrocarbon group and the alkylcarbonyloxy group is optionally replaced with -O- or -CO-, and furthermore, the hydrogen atom is optionally replaced with a sulfonylamino group having an aromatic hydrocarbon group. When the aromatic hydrocarbon group has $-N=N-A^1$, the compound (I) is a compound having two azo groups, and may be a compound represented by formula (II) to be described later.

The aryl group having 6 to 20 carbon atoms may be unsubstituted, or may have a substituent such as a halogen atom or a hydroxy group. The number of carbon atoms of the aryl group includes the number of carbon atoms of the substituent, and is usually 6 to 20, and preferably 6 to 10. Examples of the aryl group include unsubstituted or substituted phenyl groups such as a phenyl group, a toluyl group, a hydroxyphenyl group (a 4-hydroxyphenyl group or the like), and a trifluoromethylphenyl group (a 4-trifluoromethylphenyl group or the like).

The alkyl moiety of the aralkyl group having 7 to 20 carbon atoms may be linear, branched, or cyclic. The number of carbon atoms of the aralkyl group is usually 7 to 20, and preferably 7 to 10. The aralkyl group is typically a phenylalkyl group such as a benzyl group, a phenylpropyl group (a 1-methyl-3-phenylpropyl group or the like), or a phenylbutyl group (a 3-amino-1-phenylbutyl group or the like).

The acyl group having 2 to 18 carbon atoms may be unsubstituted, or may have a substituent such as a saturated aliphatic hydrocarbon group or alkoxyl group bonded thereto. The number of carbon atoms of the acyl group includes the number of carbon atoms of the substituent, and is usually 2 to 10, and preferably 6 to 10. Examples of the acyl group having 2 to 18 carbon atoms and optionally having a substituent include an acetyl group, a benzoyl group, and a methoxybenzoyl group (a p-methoxybenzoyl group or the like).

From the viewpoint of further increasing color density and oil solubility and the like, preferred examples of $R^6$ and $R^7$ include saturated aliphatic hydrocarbon groups having branched carbons such as a methylbutyl group (a 1,1,3,3-tetramethylbutyl group or the like), a methylhexyl group (a 1,5-dimethylhexyl group or the like), an ethylhexyl group (a 2-ethylhexyl group or the like), a methylcyclohexyl group (a 2-methylcyclohexyl group or the like), a phenylpropyl group (a 1-methyl-3-phenylpropyl group), and a phenylbutyl group (a 3-amino-1-phenylbutyl group or the like.), or an aralkyl group.

Examples of the alkyl group having 1 to 8 carbon atoms include a methyl group, an ethyl group, a propyl group, an isopropyl group, a butyl group, an isobutyl group, a sec-butyl group, a tert-butyl group, a pentyl group, and a hexyl group. An alkyl group having 1 to 4 carbon atoms is preferred; a methyl group and an ethyl group are more preferred; and a methyl group is particularly preferred.

Examples of the alkoxy group having 1 to 8 carbon atoms include a methoxy group, an ethoxy group, a propoxy group, an isopropoxy group, a butoxy group, an isobutoxy group, a sec-butoxy group, a tert-butoxy group, a pentyloxy

group, and a hexyloxy group. An alkoxy group having 1 to 4 carbon atoms is preferred; a methoxy group and an ethoxy group are more preferred; and a methoxy group is particularly preferred.

Examples of the halogen atom include a fluorine atom, a chlorine atom, an iodine atom, and a bromine atom.

$A^1$ is preferably a phenyl group having two or more of at least one group selected from the group consisting of a carboxy group, a sulfo group, a sulfamoyl group, and an N-substituted sulfamoyl group, or a naphthyl group having two or more of at least one group selected from the group consisting of a sulfo group, a sulfamoyl group, and an N-substituted sulfamoyl group. Examples thereof include a phenyl group and a naphthyl group having one or both of a sulfo group and an N-substituted sulfamoyl group, and a phenyl group and a naphthyl group having only a sulfo group or only an N-substituted sulfamoyl group.

When the N-substituted sulfamoyl group is present, the compound (I) has excellent water solubility and oil solubility, which provides increased utility as a dye. $A^1$ is preferably a phenyl group having one N-substituted sulfamoyl group or a naphthyl group having two N-substituted sulfamoyl groups, and particularly preferably a phenyl group having one N-substituted sulfamoyl group.

Specific examples of the phenyl group having a sulfo group include a phenyl group having a sulfo group and a carboxy group, that is, a carboxy-sulfophenyl group (2-carboxy-4-sulfophenyl or the like); a phenyl group having only a sulfo group, for example, a phenyl group having one sulfo group (a 2-, 3-, or 4-sulfophenyl group), a phenyl group having two sulfo groups (a 2,4-disulfophenyl group or the like); a phenyl group having a sulfo group and one other substituent, for example, a methyl-sulfophenyl group (a 4-methyl-2-sulfophenyl group, a 4-methyl-3-sulfophenyl group, a 2-methyl-3-sulfophenyl group, a 2-methyl-5-sulfophenyl group or the like), a dimethyl-sulfophenyl group (a 4,6-diemthyl-2-sulfophenyl group, a 2,4-dimethyl-6-sulfophenyl group or the like), a methoxy-sulfophenyl group (a 4-methoxy-2-sulfophenyl group, a 4-methoxy-3-sulfophenyl group, a 2-methoxy-3-sulfophenyl group, a 2-methoxy-4-sulfophenyl group or the like), a hydroxyl-sulfophenyl group (a 2-hydroxy-3-sulfophenyl group, a 2-hydroxy-4-sulfophenyl group, 2-hydroxy-5-sulfophenyl group or the like); and a phenyl group having a sulfo group and two or more other substituents, for example, a hydroxyl-nitro-sulfophenyl group (a 2-hydroxyl-3-nitro-5-sulfophenyl group or the like). Among these, from the viewpoint of color density and water solubility, preferred are a phenyl group having one sulfo group (also referred to as monosulfophenyl group); a phenyl group having a sulfo group and a hydroxy group; a phenyl group having a sulfo group and a methyl group; and a phenyl group having a sulfo group and a methoxy group; more preferred are a 3-sulfophenyl group, a 4-sulfophenyl group, and a 4-methyl-3-sulfophenyl group; and particularly preferred is a 4-sulfophenyl group.

Specific examples of the naphthyl group having a sulfo group include a naphthyl group having one sulfo group (a 5-, 6-, 7-, or 8-sulfo-2-naphthyl group, a 4-, 5-, 6-, or 7-sulfo-1-naphthyl group or the like), a naphthyl group having two sulfophenyl groups (a 6,8-, 4,8-, 5,7- or 3,6-disulfo-2-naphthyl group, a 3,6- or 4,6-disulfo-1-naphthyl group or the like), and a naphthyl group having three sulfo groups (a 3,6,8- or 4,6,8-trisulfo-2-naphthyl group or the like). Among these, a naphthyl group having two sulfophenyl groups (also referred to as disulfonaphthyl group) is preferred; a disulfo-2-naphthyl group is more preferred; and a 6,8-disulfo-2-naphthyl group is still more preferred.

Examples of the phenyl or naphthyl group having a sulfamoyl group or an N-substituted sulfamoyl group include a phenyl or naphthyl group in which a sulfo group is replaced with a sulfamoyl group or an N-substituted sulfamoyl group in the example of the phenyl or naphthyl group having a sulfo group.

Examples of the monovalent aromatic hydrocarbon group having 6 to 14 carbon atoms in $B^1$ include a phenyl group and a naphthyl group. The number of carbon atoms of the aromatic hydrocarbon group does not include the number of carbon atoms of the substituent.

Examples of the monovalent heterocyclic group having 3 to 14 carbon atoms in $B^1$ include groups represented by the following formulae, wherein R represents a hydrogen atom or an organic group.

[Formula 47]

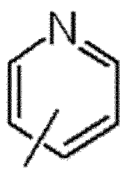 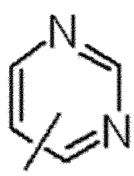 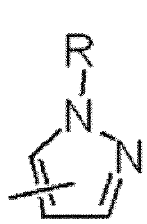 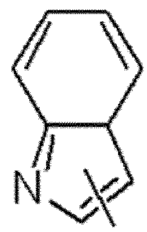 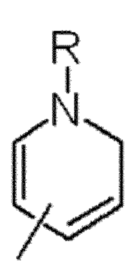

Examples of the organic group represented by R include the same groups as those of $R^1$ to be described later.

The hydrogen atom contained in the monovalent aromatic hydrocarbon group having 6 to 14 carbon atoms and the monovalent heterocyclic group having 3 to 14 carbon atoms is optionally replaced with a hydroxy group, an

aliphatic hydrocarbon group having 1 to 16 carbon atoms, a cyano group, an amino group, or an N-substituted amino group. The hydrogen atom contained in the aromatic hydrocarbon group is optionally replaced with an oxo group. $-CH_2-$ contained in the heterocyclic group is optionally replaced with -CO-.

Examples of the N-substituted amino group include a $-NHR^8$ group and a $-SO_2NR^8R^9$ group. $R^8$ and $R^9$ each independently represent a monovalent aliphatic hydrocarbon group having 1 to 16 carbon atoms and optionally having a substituent or a monovalent heterocyclic group having 3 to 14 carbon atoms and optionally having a substituent. Examples of the monovalent aliphatic hydrocarbon group having 1 to 16 carbon atoms and optionally having a substituent and the monovalent heterocyclic group having 3 to 14 carbon atoms and optionally having a substituent include the same groups as those exemplified as the heterocyclic group.

$B^1$ preferably represents a monovalent heterocyclic group having 3 to 14 carbon atoms and optionally having a substituent, and $-CH_2-$ contained in the heterocyclic group is optionally replaced with -CO-. More preferably, $B^1$ is a group represented by formula (Ba).

[Formula 48]

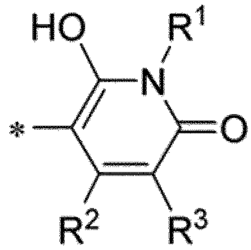

(Ba)

wherein

$R^1$ and $R^2$ each independently represent a hydrogen atom or a monovalent saturated hydrocarbon group having 1 to 16 carbon atoms and optionally having a substituent;
$R^3$ represents a cyano group or a group represented by $-CO-NR^4R^5$;
$R^4$ and $R^5$ each independently represent a hydrogen atom, a saturated aliphatic hydrocarbon group having 1 to 10 carbon atoms, a saturated aliphatic hydrocarbon group having 1 to 10 carbon atoms and substituted with an alkoxy group having 1 to 8 carbon atoms, an aryl group having 6 to 20 carbon atoms, an aralkyl group having 7 to 20 carbon atoms, or an acyl group having 2 to 10 carbon atoms; and
* represents a point of attachment to a nitrogen atom.

The exemplification and preferable range of the monovalent saturated hydrocarbon group having 1 to 16 carbon atoms and representing $R^1$ and $R^2$ are the same as those in the description of $R^6$ and $R^7$.

$R^1$ is preferably a branched saturated hydrocarbon group such as a methylbutyl group (a 1,1,3,3-tetrametylbutyl group or the like), a methylhexyl group (a 1,5-dimethylhexyl group or the like), an ethylhexyl group (a 2-ethylhexyl group or the like), a methylcyclohexyl group (a 2-methylcyclohexyl group or the like), or an alkoxypropyl group (a 3-(2-ethylhexyloxy)propyl group or the like).

$R^2$ is preferably a methyl group.

The exemplifications and preferable ranges of the saturated aliphatic hydrocarbon group, the aryl group, the aralkyl group, and the acyl group of $R^4$ and $R^5$ are the same as those in the description of $R^6$ and $R^7$. In order to increase color density, a saturated aliphatic hydrocarbon group having carbon atoms of 3 or less (for example, a methyl group, an ethyl group or the like, particularly a methyl group) or a hydrogen atom is preferably selected as at least one (preferably all) of $R^4$ and $R^5$. In order to increase solubility, an acetyl group is preferably selected as at least one of $R^4$ and $R^5$.

Specific examples of $B^1$ include structural units represented by the following formulae.

**[0122]** * represents a point of attachment to a nitrogen atom.

[Formula 49]

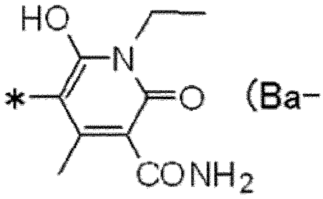

(Ba-1)

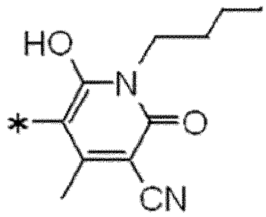

(Ba-2)

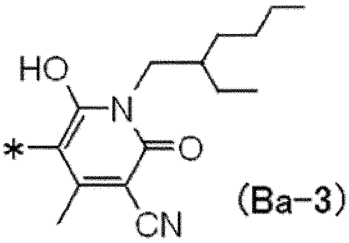

(Ba-3)

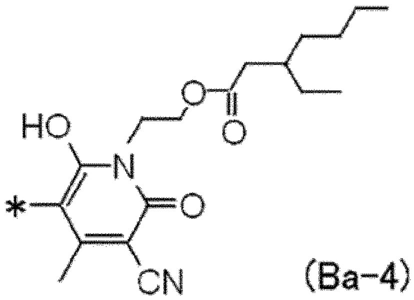

(Ba-4)

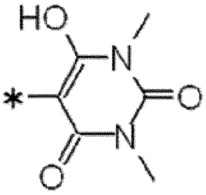

(Bb-1)

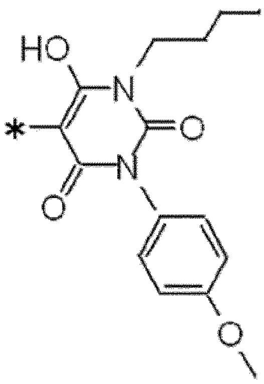

(Bb-2)

wherein preferred examples when $A^1$ has a sulfo group include formulae (I-1) to (I-14) .

[Formula 50]

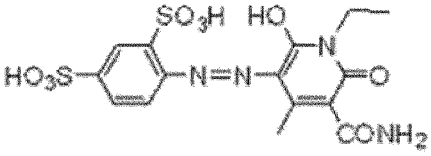 (I-1)

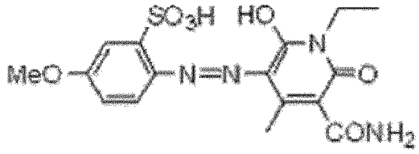 (I-8)

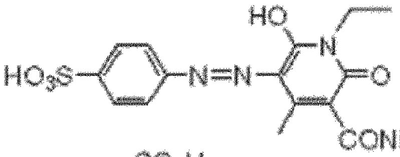 (I-2)

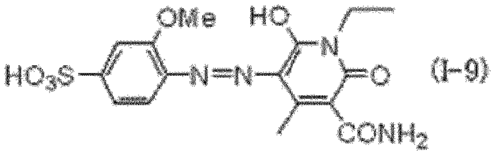 (I-9)

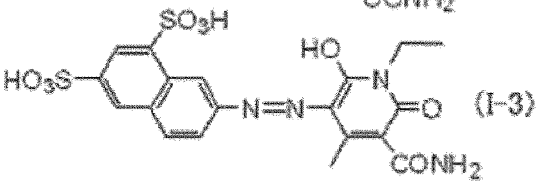 (I-3)

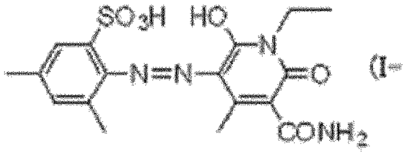 (I-10)

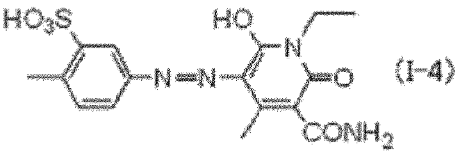 (I-4)

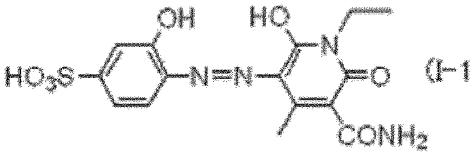 (I-11)

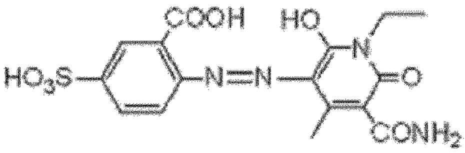 (I-5)

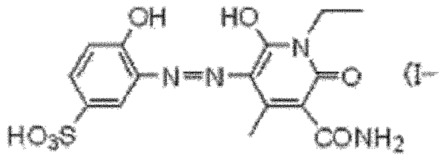 (I-12)

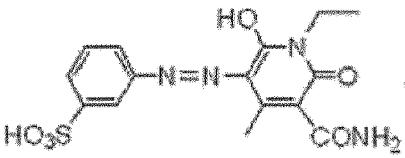 (I-6)

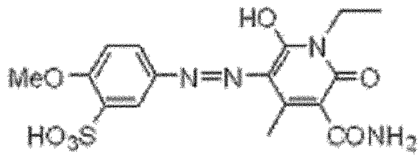 (I-13)

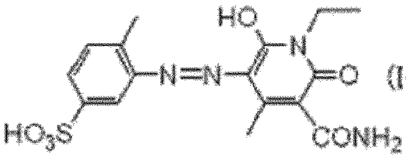 (I-7)

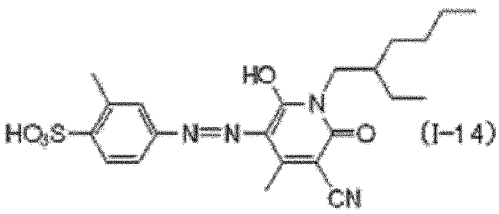 (I-14)

wherein preferred examples when $A^1$ has an N-substituted sulfamoyl group include formulae (1-15) to (1-18).

[Formula 51]

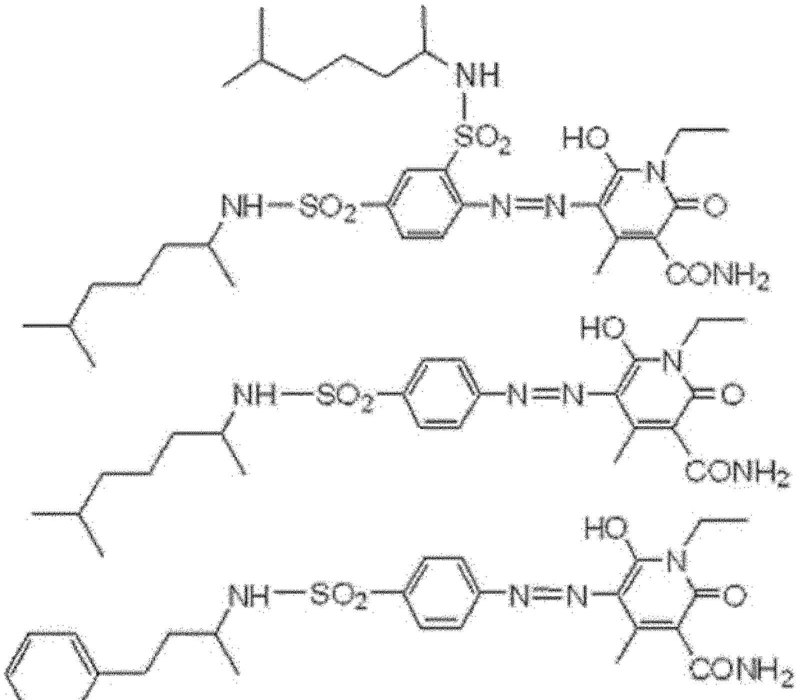

(I-15)

(I-16)

(I-17)

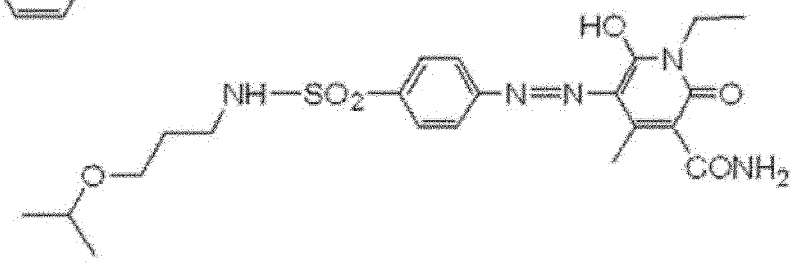

(I-18)

The compound (I) can be produced, for example, by methods described in Japanese Patent Laid-Open Nos. 2010-152160 and 2012-031218 and the like.

In another preferred embodiment of the present invention, the azo dye contains a compound represented by formula (II).

$$B^{2a}\text{-N=N-}A^{2a}\text{-O-CO-L-CO-O-}A^{2b}\text{-N=N-}B^{2b} \qquad \text{(II)}$$

wherein

$A^{2a}$ and $A^{2b}$ each independently represent a divalent group containing an aromatic hydrocarbon having 6 to 10 carbon atoms and optionally having a substituent;
$B^{2a}$ and $B^{2b}$ each independently represent a monovalent aromatic hydrocarbon group having 6 to 14 carbon atoms and optionally having a substituent or a monovalent heterocyclic group having 3 to 14 carbon atoms and optionally having a substituent; and $-CH_2-$ contained in the heterocyclic group is optionally replaced with -CO-; and
L represents a divalent aliphatic hydrocarbon group having 1 to 16 carbon atoms and optionally having a substituent; and $-CH_2-$ contained in the aliphatic hydrocarbon group is optionally replaced with -CO- or -O-

One or two or more of the compounds (II) may be contained in the azo dye.

Examples of the divalent aromatic hydrocarbon having 6 to 10 carbon atoms in the structural unit represented by $A^{2a}$ and $A^{2b}$ include benzene and naphthalene, and benzene is preferred. The number of carbon atoms of the aromatic hydrocarbon does not include the number of carbon atoms of the substituent. The exemplification and preferable range of the substituent that the aromatic hydrocarbon group optionally has are the same as those of the substituent that the monovalent aromatic hydrocarbon group having 6 to 10 carbon atoms in $A^1$ of the above-mentioned formula (I) optionally has.

The exemplification and preferable range of the monovalent aromatic hydrocarbon group having 6 to 10 carbon atoms and optionally having a substituent in $A^{2a}$ and $A^{2b}$ are the same as those of the above-mentioned monovalent

aromatic hydrocarbon group having 6 to 10 carbon atoms, optionally having a substituent, and represented by $A^1$. $A^{2a}$ and $A^{2b}$ are preferably a group represented by formula ($A_{II}$).

$$*\text{-}A^3\text{-}SO_2NR^{10}Z^1\text{-} \qquad (A_{II})$$

wherein

$A^3$ represents a divalent aromatic hydrocarbon group having 6 to 10 carbon atoms and optionally having a substituent;
$R^{10}$ each independently represents a hydrogen atom, a monovalent saturated hydrocarbon group having 1 to 16 carbon atoms and optionally having a substituent, or an acyl group having 2 to 18 carbon atoms and optionally having a substituent;
$Z^1$ each independently represents a divalent aliphatic hydrocarbon group having 1 to 16 carbon atoms and optionally having a substituent, and $-CH_2-$ contained in the aliphatic hydrocarbon group is optionally replaced with -CO- or -O-; and
* represents a point of attachment to a nitrogen atom.

Examples of the divalent aromatic hydrocarbon group having 6 to 10 carbon atoms in $A^3$ include a phenylene group and a naphthalenediyl group, and a phenylene group is preferred. The number of carbon atoms of the aromatic hydrocarbon group does not include the number of carbon atoms of the substituent. The exemplification and preferable range of the substituent that the aromatic hydrocarbon group optionally has are the same as those of the substituent described in the above description of $A^1$.

The exemplification and preferable range of the monovalent saturated hydrocarbon group having 1 to 16 carbon atoms and represented by $R^{10}$ or the acyl group having 2 to 18 carbon atoms and optionally having a substituent are the same as those described in the above-mentioned description of $R^6$ and $R^7$.

The number of carbon atoms of the divalent aliphatic hydrocarbon group having 1 to 16 carbon atoms and represented by $Z^1$ does not include the number of carbon atoms of the substituent, and the number of carbon atoms of the substituent is preferably 2 to 10, and more preferably 2 to 8. Examples of the divalent aliphatic hydrocarbon group having 1 to 16 carbon atoms include alkanediyl groups having 1 to 16 carbon atoms such as a methylene group, an ethylene group, a propanediyl group, a butanediyl group, a pentanediyl group, a hexanediyl group, a heptanediyl group, an octanediyl group, a decanediyl group, a tetradecanediyl group, and a hexadecanediyl group; and alkenediyl groups having 1 to 16 carbon atoms such as $-CH_2=CH_2-$, $CH_2-C(=CH_2)-$, and $-(CH_2)_2-C(=CH_2)-$.

$-CH_2-$ contained in the divalent aliphatic hydrocarbon group having 1 to 16 carbon atoms is optionally replaced with -CO- or -O-, and the hydrogen atom contained in the divalent aliphatic hydrocarbon group having 1 to 16 carbon atoms is optionally replaced with a halogen atom such as a fluorine atom.

$Z^1$ is preferably an alkanediyl group having 1 to 8 carbon atoms in which $-CH_2-$ is optionally replaced with -O-, and more preferably an alkanediyl group having 5 to 7 carbon atoms in which $-CH_2-$ is optionally replaced with -O-. Preferred examples of the group include $-(CH_2)^3-$, $-(CH_2)_2-O-(CH_2)_2-$, $-(CH_2)_2-O-(CH_2)_2-O-(CH_2)_2-$, and $-CH_2-CH(CH_3)-$.

Specific examples of the structural unit represented by formula ($A_{II}$) include structural units represented by the following formulae.

[Table 1]

Table 1

| | $A^3$ | $R^{10}$ | $Z^1$ |
|---|---|---|---|
| ($A_{II}$-1) | 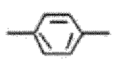 | —H | 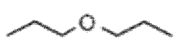 |
| ($A_{II}$-2) | 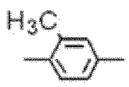 | -H | 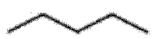 |
| ($A_{II}$-3) | 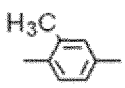 | 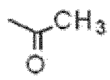 | 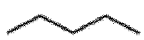 |
| ($A_{II}$-4) | 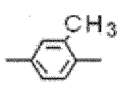 | —H | 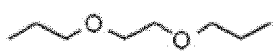 |

(continued)

| | $A^3$ | $R^{10}$ | $Z^1$ |
|---|---|---|---|
| ($A_{II}$-5) | 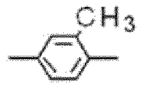 | —H | 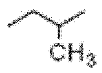 |
| ($A_{II}$-6) | 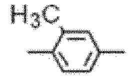 | —H | 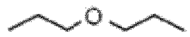 |
| ($A_{II}$-7) | 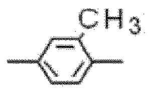 | 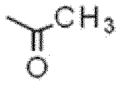 | 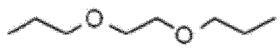 |
| ($A_{II}$-8) | 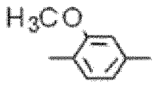 | 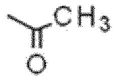 | 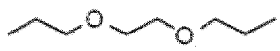 |
| ($A_{II}$-9) | 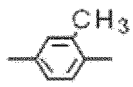 | - H | 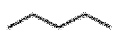 |
| ($A_{II}$-10) | 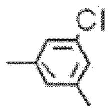 | —H | 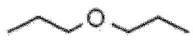 |
| ($A_{II}$-11) | 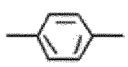 | -H | 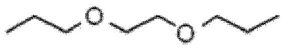 |

The exemplification and preferable range of the monovalent aromatic hydrocarbon group having 6 to 14 carbon atoms and optionally having a substituent or the monovalent heterocyclic group having 3 to 14 carbon atoms and optionally having a substituent of $B^{2a}$ and $B^{2b}$ are the same as those in the above $B^1$. $B^{2a}$ and $B^{2b}$ are preferably the above-mentioned structural unit (Ba-3) from the viewpoint of the solubility of the compound.

The divalent aliphatic hydrocarbon group having 1 to 16 carbon atoms and optionally having a substituent in L does not include the number of carbon atoms of the substituent, and the number of carbon atoms of the substituent is preferably 2 to 10, and more preferably 2 to 8. Examples of the divalent aliphatic hydrocarbon group having 1 to 16 carbon atoms include alkanediyl groups having 1 to 16 carbon atoms such as a methylene group, an ethylene group, a propanediyl group, a butanediyl group [$-(CH_2)_4-$], a pentanediyl group, a hexanediyl group, a heptanediyl group, an octanediyl group, a decanediyl group, a tetradecanediyl group, and a hexadecanediyl group; and alkenediyl groups having 1 to 16 carbon atoms such as $-CH_2=CH_2-$, $CH_2-C(=CH_2)-$, and $-(CH_2)_2-C(=CH_2)-$.

$-CH_2-$ contained in the divalent aliphatic hydrocarbon group having 1 to 16 carbon atoms is optionally replaced with -CO- or -O-, and the hydrogen atom contained in the divalent aliphatic hydrocarbon group having 1 to 16 carbon atoms is optionally replaced with a halogen atom such as a fluorine atom.

Specific examples of the compound represented by formula (II) include the following compounds.

[Table 2]

Table 2

| Number of compound | Number of $B^{2a}$ | Number of $A^{2a}$ | L | Number of $A^{2b}$ | Number of $B^{2b}$ |
|---|---|---|---|---|---|
| (II-1) | (Ba-3) | ($A_{II}$-1) | $-(CH_2)_4-$ | ($A_{II}$-1) | (Ba-3) |
| (II-2) | (Ba-3) | ($A_{II}$-2) | $-(CH_2)_4-$ | ($A_{II}$-2) | (Ba-3) |
| (II-3) | (Ba-3) | ($A_{II}$-3) | $(CH_2)_4-$ | ($A_{II}$-3) | (Ba-3) |
| (II-4) | (Ba-3) | ($A_{II}$-4) | $-(CH_2)_4-$ | ($A_{II}$-4) | (Ba-3) |
| (II-5) | (Ba-3) | ($A_{II}$-5) | $-(CH_2)_4-$ | ($A_{II}$-5) | (Ba-3) |
| (II-6) | (Ba-3) | ($A_{II}$-6) | $-(CH_2)_4-$ | ($A_{II}$-6) | (Ba-3) |

(continued)

| Number of compound | Number of $B^{2a}$ | Number of $A^{2a}$ | L | Number of $A^{2b}$ | Number of $B^{2b}$ |
|---|---|---|---|---|---|
| (II-7) | (Ba-3) | ($A_{II}$-7) | - $(CH_2)_4$- | ($A_{II}$-7) | (Ba-3) |
| (II-8) | (Ba-3) | ($A_{II}$-8) | - $(CH_2)_4$- | ($A_{II}$-8) | (Ba-3) |
| (II-9) | (Ba-3) | ($A_{II}$-9) | - $(CH_2)_4$- | ($A_{II}$-9) | (Ba-3) |
| (II-10) | (Ba-3) | ($A_{II}$-10) | - $(CH_2)_4$- | ($A_{II}$-10) | (Ba-3) |
| (II-11) | (Ba-3) | ($A_{II}$-11) | - $(CH_2)_4$- | ($A_{II}$-11) | (Ba-3) |
| (II-12) | (Ba-3) | ($A_{II}$-1) | - $(CH_2)_8$- | ($A_{II}$-1) | (Ba-3) |
| (II-13) | (Ba-3) | ($A_{II}$-2) | -$(CH_2)_8$- | ($A_{II}$-2) | (Ba-3) |
| (II-14) | (Ba-3) | ($A_{II}$-3) | - $(CH_2)_8$- | ($A_{II}$-3) | (Ba-3) |
| (II-15) | (Ba-3) | ($A_{II}$-4) | - $(CH_2)_8$- | ($A_{II}$-4) | (Ba-3) |
| (II-18) | (Ba-3) | ($A_{II}$-5) | - $(CH_2)_8$- | ($A_{II}$-5) | (Ba-3) |
| (11-17) | (Ba-3) | ($A_{II}$-6) | -$(CH_2)_8$- | ($A_{II}$-6) | (Ba-3) |
| (II-18) | (Ba-3) | ($A_{II}$-7) | -$(CH_2)_8$- | ($A_{II}$-7) | (Ba-3) |
| (II-19) | (Ba-3) | ($A_{II}$-8) | -$(CH_2)_8$- | ($A_{II}$-8) | (Ba-3) |
| (II-20) | (Ba-3) | ($A_{II}$-9) | - $(CH_2)_8$- | ($A_{II}$-9) | (Ba-3) |
| (II-21) | (Ba-3 ) | ($A_{II}$-10) | -$(CH_2)_8$- | ($A_{II}$-10) | (Ba-3) |
| (II-22) | (Ba-3) | ($A_{II}$-11 ) | - $(CH_2)_8$- | ($A_{II}$-11) | (Ba-3) |

The compounds represented by formula (II) are preferably compounds represented by formulae (II-1) to (II-22) from the viewpoint of solubility, and more preferably compounds represented by formulae (II-6) and (II-16).

B2a and B2b are preferably the same type of group from the viewpoint of the ease of production of the compound (II), and A2a and A2b are more preferably the same type of group.

The compound (II) can be produced by subjecting a compound represented by formula (II-C), a compound represented by formula (II-D), and a compound represented by formula (II-D') to a coupling reaction. The compound (II) can be produced by causing a salt of the compound represented by formula (II-C) to react with the compound represented by formula (II-D) and the compound represented by formula (II-D'), for example, in an aqueous solvent at 20 to 60°C.

[Formula 52]

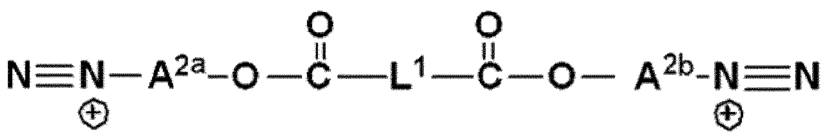 $X^-$ (II-C)

$H-B^{2a}$ (II-D)

$H-B^{2b}$ (II-D')

wherein

$A^{2a}$, $A^{2b}$, $B^{2a}$, $B^{2b}$, and $L^1$ represent the same meaning as the above in formula (II-C), formula (II-D), and formula (II-D'); and

$X^-$ represents an inorganic anion or an organic anion.

Examples of the inorganic anion or the organic anion include a fluoride ion, a chloride ion, a bromide ion, an iodide ion, a perchlorate ion, a hypochlorite ion, $CH_3$-$COO^-$, and Ph-$COO^-$, and preferred examples thereof include a chloride ion, a bromide ion, and $CH_3$-$COO^-$.

The content rate of the azo dye in the colorant (A) may be, for example, 1% by mass or more and 90% by mass or less, and is more preferably 2% by mass or more and 70% by mass or less, still more preferably 3% by mass or more and 50% by mass or less, particularly preferably 4% by mass or more and 40% by mass or less, and especially preferably 5% by mass or more and 30% by mass or less, based on the whole amount of the colorant (A).
The compound (II) can be produced, for example, by methods described in Japanese Patent Laid-Open No. 2012-031218 and Japanese Patent Laid-Open No. 2009-013112 and the like.

<Colorant (A)>

The total content rate of the red pigment, the xanthene dye, and the azo dye in the colorant (A) may be, for example, 50% by mass or more and 100% by mass or less, and is preferably 60% by mass or more and 100% by mass or less, and more preferably 80% by mass or more and 100% by mass or less, based on the whole amount of the colorant (A).
The ratio between the red pigment and the xanthene dye in the colorant (A) may be, for example, 1:99 to 99:1, and is preferably 10:90 to 95:5, more preferably 30:70 to 95:15, and still more preferably 70:30 to 95:15.
The ratio between the red pigment and the azo dye in the colorant (A) may be, for example, 1:99 to 99:1, and is preferably 10:90 to 95:5, more preferably 30:70 to 90:10, and still more preferably 70:30 to 90:10.
The ratio between the xanthene dye and the azo dye in the colorant (A) may be, for example, 1:99 to 99:1, and is preferably 10:90 to 90:10, more preferably 30:70 to 70:30, and still more preferably 40:60 to 60:40.
The content rate of the colorant (A) in the colored curable resin composition is preferably 5% by mass or more and 80% by mass or less, more preferably 5% by mass or more and 70% by mass or less, and still more preferably 5% by mass or more and 60% by mass or less, relative to the whole amount of the solid content in the colored curable resin composition. When the content rate of the colorant (A) falls within the above range, desired spectroscopy and color density can be obtained.
The term "whole amount of the solid content in the colored curable resin composition" as used herein means the total amount of components obtained by removing the solvent (E) from the colored curable resin composition.
The colorant (A) may further contain a colorant other than the red pigment, the xanthene dye, and the azo dye [hereinafter, also referred to as colorant (A1)].
The colorant (A1) may contain at least one selected from the group consisting of dyes other than the above-mentioned dyes and pigments other than the above-mentioned red pigments.
Any known dye can be used as the dye contained in the colorant (A1). Examples of the dye include a solvent dye, an acid dye, a direct dye, and a mordant dye. Examples of the dye include a compound classified into a dye of solvent, acid, basic, reactive, direct, disperse, mordant, or vat type or the like in the Color Index (published by The Society of Dyers and Colourists), and a known dye as described in Dying note (Shikisensha Co., Ltd.). These dyes may be appropriately selected depending on the spectral spectrum of a desired color filter. These dyes may be used singly or in combinations of two or more thereof. Dyes soluble in an organic solvent are preferable as the dye.
Specific examples of the dye include

C. I. Solvent dyes such as:

C. I. Solvent Yellows 4 (hereinafter, the term "C. I. Solvent Yellow" is omitted and only the number is described), 14, 15, 23, 24, 38, 62, 63, 68, 82, 94, 98, 99, 117, 162, 163, 167, and 189;
C. I. Solvent Reds 45, 49, 111, 125, 130, 143, 145, 146, 150, 151, 155, 168, 169, 172, 175, 181, 207, 218, 222, 227, 230, 245, and 247;
C. I. Solvent Oranges 2, 7, 11, 15, 26, 56, 77, and 86; C. I. Solvent Violets 11, 13, 14, 26, 31, 36, 37, 38, 45, 47, 48, 51, 59, and 60;
C. I. Solvent Blues 4, 5, 14, 18, 35, 36, 37, 45, 58, 59, 59:1, 63, 67, 68, 69, 70, 78, 79, 83, 90, 94, 97, 98, 100, 101, 102, 104, 105, 111, 112, 122, 128, 132, 136, and 139;
C. I. Solvent Greens 1, 3, 4, 5, 7, 28, 29, 32, 33, 34, and 35,

C. I. Acid dyes such as:

C. I. Acid Yellows 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, and 251;
C. I. Acid Reds 1, 4, 8, 14, 17, 18, 26, 27, 29, 31, 33, 34, 35, 37, 40, 42, 44, 50, 51, 52, 57, 66, 73, 76, 80, 87, 88, 91, 92, 94, 95, 97, 98, 103, 106, 111, 114, 129, 133, 134, 138, 143, 145, 150, 151, 155, 158, 160, 172, 176,

182, 183, 195, 198, 206, 211, 215, 216, 217, 227, 228, 249, 252, 257, 258, 260, 261, 266, 268, 270, 274, 277, 280, 281, 289, 308, 312, 315, 316, 339, 341, 345, 346, 349, 382, 383, 388, 394, 401, 412, 417, 418, 422, and 426;
C. I. Acid Oranges 6, 7, 8, 10, 12, 26, 50, 51, 52, 56, 62, 63, 64, 74, 75, 94, 95, 107, 108, 169, and 173;
C. I. Acid Violets 6B, 7, 9, 15, 16, 17, 19, 21, 23, 24, 25, 30, 34, 38, 49, 72, and 102;
C.I. Acid Blues 1, 3, 5, 7, 9, 11, 13, 15, 17, 18, 22, 23, 24, 25, 26, 27, 29, 34, 38, 40, 41, 42, 43, 45, 48, 51, 54, 59, 60, 62, 70, 72, 74, 75, 78, 80, 82, 83, 86, 87, 88, 90, 90:1, 91, 92, 93, 93:1, 96, 99, 100, 102, 103, 104, 108, 109, 110, 112, 113, 117, 119, 120, 123, 126, 127, 129, 130, 131, 138, 140, 142, 143, 147, 150, 151, 154, 158, 161, 166, 167, 168, 170, 171, 175, 182, 183, 184, 187, 192, 199, 203, 204, 205, 210, 213, 229, 234, 236, 242, 243, 256, 259, 267, 269, 278, 280, 285, 290, 296, 315, 324:1, 335, and 340;
C. I. Acid Greens 1, 3, 5, 6, 7, 8, 9, 11, 13, 14, 15, 16, 22, 25, 27, 28, 41, 50, 50:1, 58, 63, 65, 80, 104, 105, 106, and 109,

C. I. Direct dyes such as:

C. I. Direct Yellows 2, 33, 34, 35, 38, 39, 43, 47, 50, 54, 58, 68, 69, 70, 71, 86, 93, 94, 95, 98, 102, 108, 109, 129, 136, 138, and 141;
C. I. Direct Reds 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, and 250;
C. I. Direct Oranges 26, 34, 39, 41, 46, 50, 52, 56, 57, 61, 64, 65, 68, 70, 96, 97, 106, and 107;
C. I. Direct Violets 47, 52, 54, 59, 60, 65, 66, 79, 80, 81, 82, 84, 89, 90, 93, 95, 96, 103, and 104;
C. I. Direct Blues 1, 2, 3, 6, 8, 15, 22, 25, 28, 29, 40, 41, 42, 47, 52, 55, 57, 71, 76, 77, 78, 80, 81, 84, 85, 86, 90, 93, 94, 95, 97, 98, 99, 100, 101, 106, 107, 108, 109, 113, 114, 115, 117, 119, 120, 137, 149, 150, 153, 155, 156, 158, 159, 160, 161, 162, 163, 164, 165, 166, 167, 168, 170, 171, 172, 173, 188, 189, 190, 192, 193, 194, 195, 196, 198, 199, 200, 201, 202, 203, 207, 209, 210, 212, 213, 214, 222, 225, 226, 228, 229, 236, 237, 238, 242, 243, 244, 245, 246, 247, 248, 249, 250, 251, 252, 256, 257, 259, 260, 268, 274, 275, and 293;
C. I. Direct Greens 25, 27, 31, 32, 34, 37, 63, 65, 66, 67, 68, 69, 72, 77, 79, and 82,

C. I. Disperse dyes such as:

C. I. Disperse Yellows 51, 54, and 76;
C. I. Disperse Violets 26 and 27;
C. I. Disperse Blues 1, 14, 56, and 60,

C. I. Basic dyes such as:

C. I. Basic Reds 1 and 10;
C. I. Basic Blues 1, 3, 5, 7, 9, 19, 21, 22, 24, 25, 26, 28, 29, 40, 41, 45, 47, 54, 58, 59, 60, 64, 65, 66, 67, 68, 81, 83, 88, and 89;
C. I. Basic Violet 2;
C. I. Basic Red 9;
C. I. Basic Green 1,

C. I. Reactive dyes such as:

C. I. Reactive Yellows 2, 76, and 116;
C. I. Reactive Orange 16;
C. I. Reactive Red 36,

C. I. Mordant dyes such as:

C. I. Mordant Yellows 5, 8, 10, 16, 20, 26, 30, 31, 33, 42, 43, 45, 56, 61, 62, and 65;
C. I. Mordant Reds 1, 2, 3, 4, 9, 11, 12, 14, 17, 18, 19, 22, 23, 24, 25, 26, 27, 29, 30, 32, 33, 36, 37, 38, 39, 41, 42, 43, 45, 46, 48, 52, 53, 56, 62, 63, 71, 74, 76, 78, 85, 86, 88, 90, 94, and 95;
C. I. Mordant Oranges 3, 4, 5, 8, 12, 13, 14, 20, 21, 23, 24, 28, 29, 32, 34, 35, 36, 37, 42, 43, 47, and 48;
C. I. Mordant Violets 1, 1:1, 2, 3, 4, 5, 6, 7, 8, 10, 11, 14, 15, 16, 17, 18, 19, 21, 22, 23, 24, 27, 28, 30, 31, 32, 33, 36, 37, 39, 40, 41, 44, 45, 47, 48, 49, 53, and 58;
C. I. Mordant Blues 1, 2, 3, 7, 8, 9, 12, 13, 15, 16, 19, 20, 21, 22, 23, 24, 26, 30, 31, 32, 39, 40, 41, 43, 44, 48, 49, 53, 61, 74, 77, 83, and 84;

C. I. Mordant Greens 1, 3, 4, 5, 10, 13, 15, 19, 21, 23, 26, 29, 31, 33, 34, 35, 41, 43, and 53; and

C. I. Vat dyes such as:
C. I. Vat Green 1.

According to chemical structures, examples of the dye include an anthraquinone dye, a tetraazaporphyrin dye, a triallylmethane-based dye, a cyanine dye, a triphenylmethane dye, a phthalocyanine dye, a naphthoquinone dye, a quinonimine dye, a methine dye, an azomethine dye, a squarylium dye, an acridine dye, a styryl dye, a coumarin dye, a quinoline dye, and a nitro dye.
Examples of the pigment contained in the colorant (A1) include an organic pigment and an inorganic pigment, and specific examples thereof include a compound classified into a pigment in the Color Index (published by The Society of Dyers and Colourists). The pigments may be used singly or in combinations of two or more thereof.
Examples of the pigment include yellow pigments such as C.I. Pigment Yellows 1, 3, 12, 13, 14, 15, 16, 17, 20, 24, 31, 53, 83, 86, 93, 94, 109, 110, 117, 125, 128, 137, 138, 139, 147, 148, 150, 153, 154, 166, 173, 180, 185, 194, and 214;

orange pigments such as C.I. Pigment Oranges 13, 31, 36, 38, 40, 42, 43, 51, 55, 59, 61, 64, 65, 71, and 73;
red pigments such as C.I. Pigment Reds 9, 97, 105, 122, 123, 144, 149, 166, 168, 176, 177, 180, 192, 209, 215, 216, 224, 242, 254, 255, 264, and 265;
blue pigments such as C.I. Pigment Blues 15, 15:3, 15:4, 15:6, 21, 28, 60, 64, and 76;
violet pigments such as C.I. Pigment Violets 1, 14, 19, 23, 29, 32, 33, 36, 37, and 38;
green pigments such as C.I. Pigment Greens 7, 10, 15, 25, 36, 47, 58, and 59;
brown pigments such as C.I. Pigment Browns 23, 25, and 28; and
black pigments such as C.I. Pigment Blacks 1 and 7.

When the colorant (A) contains the colorant (A1), the content rate of the colorant (A1) in the colorant (A) may be, for example, 0.1% by mass or more and 99.9% by mass or less, and is more preferably 1% by mass or more and 50% by mass or less, based on the whole amount of the solid content of the colorant (A).
<Resin (B)>
The resin (B) is not particularly limited, and is preferably an alkali soluble resin. Examples of the resin (B) include the following resins [K1] to [K6].
Resin [K1]; a copolymer having a structural unit derived from at least one (a) selected from the group consisting of an unsaturated carboxylic acid and an unsaturated carboxylic anhydride (hereinafter, sometimes referred to as "(a)") and a structural unit derived from a monomer (b) having a cyclic ether structure having 2 to 4 carbon atoms and an ethylenically unsaturated bond (hereinafter, sometimes referred to as "(b)");
Resin [K2]; a copolymer having a structural unit derived from (a), a structural unit derived from (b), and a monomer (c) copolymerizable with (a) (provided that (c) is different from (a) and (b)) (hereinafter, sometimes referred to as "(c)");
Resin [K3]; a copolymer having a structural unit derived from (a) and a structural unit derived from (c);
Resin [K4]; a copolymer having a structural unit produced by adding (b) to a structural unit derived from (a) and a structural unit derived from (c);
Resin [K5]; a copolymer having a structural unit produced by adding (a) to a structural unit derived from (b) and a structural unit derived from (c); and
Resin [K6]; a copolymer having a structural unit produced by adding (a) to a structural unit derived from (b) and further adding a carboxylic anhydride thereto and a structural unit derived from (c).
Specific examples of (a) include unsaturated monocarboxylic acids such as acrylic acid, methacrylic acid, crotonic acid, and o-, m- or p-vinylbenzoic acid;

unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;
carboxy group-containing bicyclo unsaturated compounds such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;
unsaturated dicarboxylic anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride;

unsaturated mono[(meth)acryloyloxyalkyl]esters of a polyvalent carboxylic acid having a valence of 2 or more such as succinic acid mono[2-(meth)acryloyloxyethyl], and phthalic acid mono[2-(meth)acryloyloxyethyl]; and unsaturated acrylates containing a hydroxy group and a carboxy group in the same molecule such as α-(hydroxymethyl)acrylic acid.

Among these, from the viewpoint of copolymerization reactivity and solubility of a resin to be produced to an alkaline aqueous solution, acrylic acid, methacrylic acid, maleic anhydride and the like are preferable.

(b) means a polymerizable compound having, for example, a cyclic ether structure having 2 to 4 carbon atoms (for example, at least one selected from the group consisting of an oxirane ring, an oxetane ring, and a tetrahydrofuran ring) and an ethylenically unsaturated bond. (b) is preferably a monomer having a cyclic ether having 2 to 4 carbon atoms and a (meth)acryloyloxy group.

As used herein, "(meth)acrylic acid" represents at least one selected from the group consisting of acrylic acid and methacrylic acid. The terms "(meth)acryloyl", "(meth)acrylate" and the like also have similar meanings.

Examples of (b) include a monomer having an oxiranyl group and an ethylenically unsaturated bond (b1) (hereinafter, sometimes referred to as "(b1)"), a monomer having an oxetanyl group and an ethylenically unsaturated bond (b2) (hereinafter, sometimes referred to as "(b2)"), and a monomer having a tetrahydrofuryl group and an ethylenically unsaturated bond (b3) (hereinafter, sometimes referred to as "(b3)").

Examples of (b1) include a monomer having a structure where a linear or branched aliphatic unsaturated hydrocarbon is epoxidized (b1-1) (hereinafter, sometimes referred to as "(b1-1)") and a monomer having a structure where an alicyclic unsaturated hydrocarbon is epoxidized (b1-2) (hereinafter, sometimes referred to as "b1-2").

Examples of (b1-1) include glycidyl(meth)acrylate, β-methylglycidyl(meth)acrylate, β-ethylglycidyl(meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl)styrene, 2,6-bis(glycidyloxymethyl)styrene, 2,3,4-tris(glycidyloxymethyl)styrene, 2,3,5-tris(glycidyloxymethyl)styrene, 2,3,6-tris(glycidyloxymethyl)styrene, 3,4,5-tris(glycidyloxymethyl)styrene, and 2,4,6-tris(glycidyloxymethyl) styrene.

Examples of (b1-2) include vinylcyclohexene monoxide, 1,2-epoxy-4-vinylcyclohexane (for example, CELLOXIDE 2000; manufactured by Daicel Corporation), 3,4-epoxycyclohexylmethyl(meth)acrylate (for example, Cyclomer A400; manufactured by Daicel Corporation), 3,4-epoxycyclohexylmethyl(meth)acrylate (for example, Cyclomer M100; manufactured by Daicel Corporation), a compound represented by formula (B-I), and a compound represented by formula (B-II):

[Formula 53]

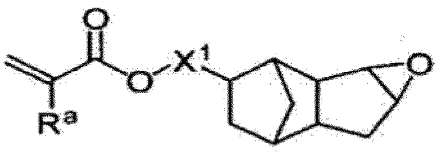

(B-I)

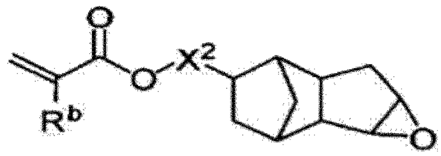

(B-II)

wherein

$R^a$ and $R^b$ represent a hydrogen atom or an alkyl group having 1 to 4 carbon atoms; the hydrogen atom contained in the alkyl group is optionally replaced with a hydroxy group;
$X^a$ and $X^b$ represent a single bond, *-$R^c$-, *-$R^c$-O-, *-$R^c$-S-, or *-$R^c$-NH-;
$R^c$ represents an alkanediyl group having 1 to 6 carbon atoms; and
* represents a point of attachment to O.

Examples of the alkyl group having 1 to 4 carbon atoms include a methyl group, an ethyl group, a n-propyl group, an isopropyl group, a n-butyl group, a sec-butyl group, and a tert-butyl group.

Examples of the alkyl group in which the hydrogen atom is replaced with the hydroxy group include a hydroxymethyl group, a 1-hydroxyethyl group, a 2-hydroxyethyl group, a 1-hydroxypropyl group, a 2-hydroxypropyl group, a 3-hydroxypropyl group, a 1-hydroxy-1-methylethyl group, a 2-hydroxy-1-methylethyl group, a 1-hydroxybutyl group, a 2-hydroxybutyl group, a 3-hydroxybutyl group, and a 4-hydroxybutyl group.

Preferably, examples of $R^a$ and $R^b$ include a hydrogen atom, a methyl group, a hydroxymethyl group, a 1-hydroxyethyl group, and a 2-hydroxyethyl group. More preferably, examples thereof include a hydrogen atom and a methyl group.

Examples of the alkanediyl group include a methylene group, an ethylene group, a propane-1,2-diyl group, a propane-1,3-diyl group, a butane-1,4-diyl group, a pentane-1,5-diyl group, and a hexane-1,6-diyl group.

Preferably, examples of $X^a$ and $X^b$ include a single bond, a methylene group, an ethylene group, *-$CH_2$-O-, and *-$CH_2CH_2$-O-. More preferably, examples thereof include a single bond and *-$CH_2$-O- (* represents a point of attachment to O).

Examples of the compound represented by formula (BI) include a compound represented by any of formulas (BI-1) to (B-I-15). Among these, the compound represented by formula (B-I-1), formula (B-I-3), formula (B-I-5), formula (B-I-7), formula (B-I-9), or formula (B-I-11) to formula (B-I-15) is preferable, and the compound represented by formula (B-I-1), formula (B-I-7), formula (B-I-9), or formula (B-I-15) is more preferable.

[Formula 54]

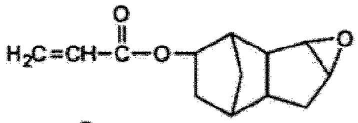
(B-I-1)

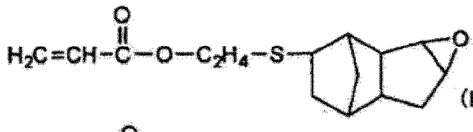
(B-I-2)

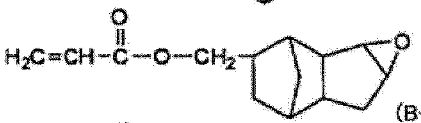
(B-I-3)

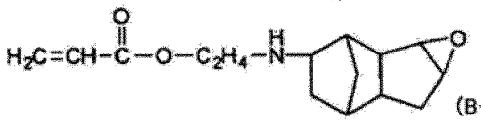
(B-I-4)

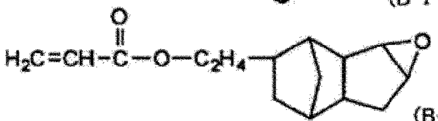
(B-I-5)

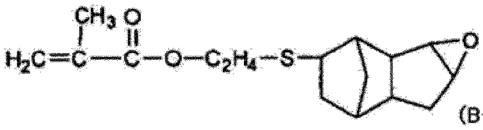
(B-I-6)

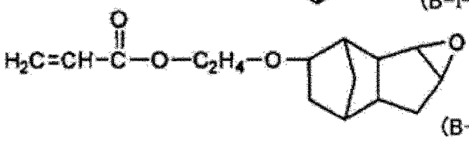
(B-I-7)

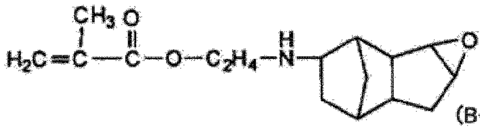
(B-I-8)

[Formula 55]

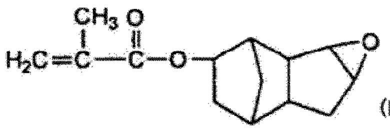
(B-I-9)

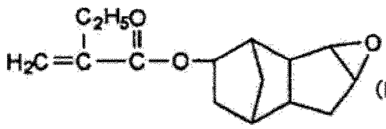
(B-I-10)

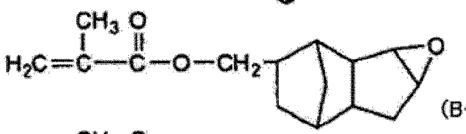
(B-I-11)

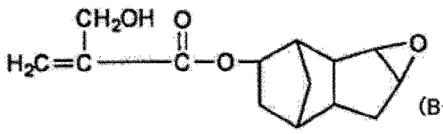
(B-I-12)

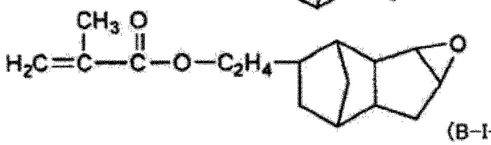
(B-I-13)

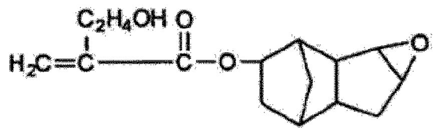
(B-I-14)

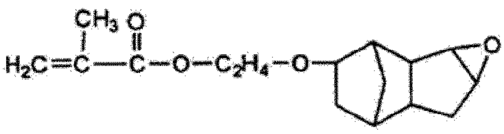
(B-I-15)

Examples of the compound represented by formula (B-II) include a compound represented by any of formula (B-II-1) to formula (B-II-15). Among these, the compound represented by formula (B-II-1), formula (B-II-3), formula (B-II-5), formula (B-II-7), formula (B-II-9), or formula (B-II-11) to formula (B-II-15) is preferable, and the compound represented by formula (B-II-1), formula (B-II-7), formula (B-II-9), or formula (B-II-15) is more preferable.

[Formula 56]

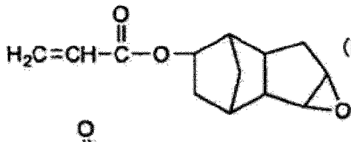
(B-II-1)

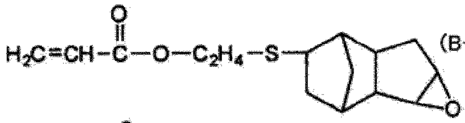
(B-II-2)

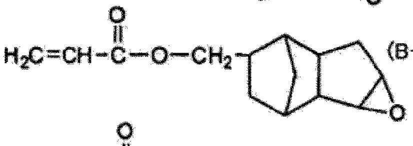
(B-II-3)

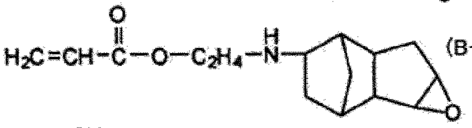
(B-II-4)

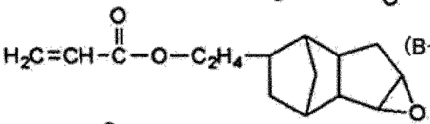
(B-II-5)

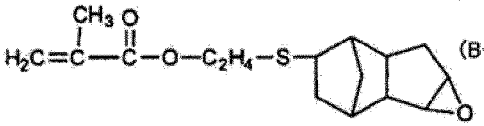
(B-II-6)

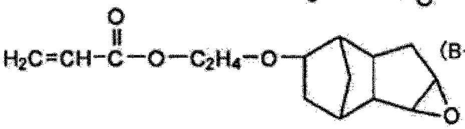
(B-II-7)

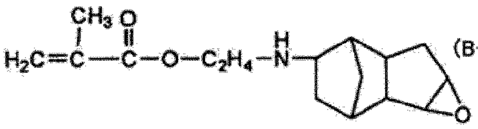
(B-II-8)

[Formula 57]

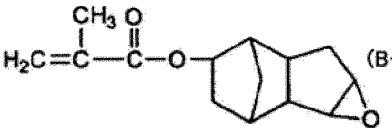
(B-II-9)

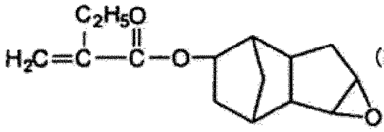
(B-II-10)

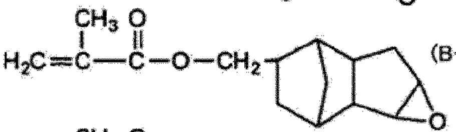
(B-II-11)

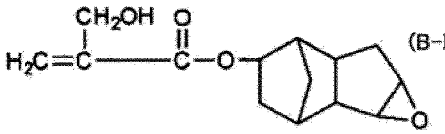
(B-II-12)

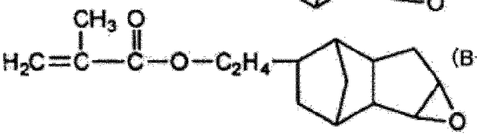
(B-II-13)

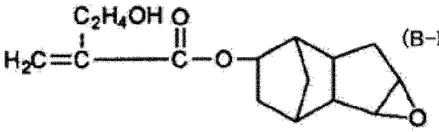
(B-II-14)

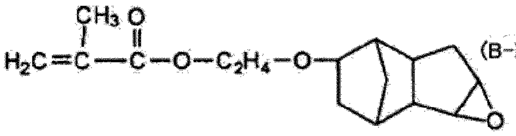
(B-II-15)

The compound represented by formula (B-I) and the compound represented by formula (B-II) may be used singly or in combinations of two or more thereof. When the compound represented by formula (B-I) and the compound represented by formula (B-II) are used in combination, the content ratio thereof [compound represented by formula (B-I) : compound represented by formula (B-II)] is preferably 5:95 to 95:5, and more preferably 20:80 to 80:20, on a molar basis.

(b2) is more preferably a monomer having an oxetanyl group and a (meth)acryloyloxy group. Examples of (b2) include 3-methyl-3-methacryloyloxy methyl oxetane, 3-methyl-3-acryloyloxy methyl oxetane, 3-ethyl-3-methacryloyloxy methyl oxetane, 3-ethyl-3-acryloyloxy methyl oxetane, 3-methyl-3-methacryloyloxy ethyl oxetane, 3-methyl-3-acryloyloxy ethyl oxetane, 3-ethyl-3-methacryloyloxy ethyl oxetane, and 3-ethyl-3-acryloyloxy ethyl oxetane.

(b3) is more preferably a monomer having a tetrahydrofuryl group and a (meth)acryloyloxy group. Specific examples of (b3) include tetrahydrofurfuryl acrylate (for example, Viscoat V#150, manufactured by Osaka Organic Chemical Industry Ltd.) and tetrahydrofurfuryl methacrylate.

(b) is preferably (b1) since reliabilities such as heat resistance and chemical resistance of a color filter to be produced can be further improved. Furthermore, (b1-2) is more preferable since the storage stability of the colored curable resin composition is excellent.

Examples of (c) include (meth)acrylic esters such as methyl(meth)acrylate, ethyl(meth)acrylate, n-butyl(meth)acrylate, sec-butyl(meth)acrylate, tert-butyl(meth)acrylate, 2-ethylhexyl(meth)acrylate, dodecyl(meth)acrylate, lauryl(meth)acrylate, stearyl(meth)acrylate, cyclopentyl(meth)acrylate, cyclohexyl(meth)acrylate, 2-methylcyclohexyl(meth)acrylate, tricyclo[5.2.1.0$^{2,6}$]decan-8-yl(meth)acrylate (referred to as "dicyclopentanyl(meth)acrylate" (common name) in the art or sometimes referred to as "tricyclodecyl(meth)acrylate"), tricyclo [5.2.1.0$^{2,6}$] decene-8-yl (meth) acrylate (which is referred to as "dicyclopentenyl(meth)acrylate" (common name) in the art), dicyclopentanyloxyethyl(meth)acrylate, isobornyl(meth)acrylate, adamantyl(meth)acrylate, allyl(meth)acrylate, propargyl(meth)acrylate, phenyl(meth)acrylate, naphthyl(meth)acrylate, and benzyl(meth)acrylate;

hydroxy group-containing (meth)acrylic esters such as 2-hydroxyethyl(meth)acrylate and 2-hydroxypropyl(meth)acrylate;
dicarboxylic diesters such as diethyl maleate, diethyl fumarate, and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;
dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide;
styrene, $\alpha$-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance, styrene, vinyltoluene, N-phenylmaleimide, N-cyclohexylmaleimide, N-benzylmaleimide, bicyclo[2.2.1]hept-2-ene and the like are preferable.
In the resin [K1], the ratio of the structural unit derived from each of (a) and (b) in the total structural units constituting the resin [K1] is preferably the following:

the structural unit derived from (a); 2 to 60 mol%; and the structural unit derived from (b); 40 to 98 mol%,
and more preferably the following:

the structural unit derived from (a); 10 to 50 mol%; and the structural unit derived from (b); 50 to 90 mol%.

When the ratio of the structural unit of the resin [K1] falls within the above-mentioned range, there is a tendency that the storage stability of the colored curable resin composition, that the developability thereof during the formation of a colored pattern, and that the solvent resistance of a color filter to be produced are excellent.
The resin [K1] can be produced with reference to the method described in for example, a document "Experimental Method for Polymer Synthesis" (edited by Takayuki Otsu, published by Kagaku Dojin Publishing Co., Ltd., First Edition, First Printed on Mar. 1, 1972) and cited documents described in the above-mentioned document.
Specific examples thereof include the following method: predetermined amounts of (a) and (b), a polymerization initiator, a solvent and the like are placed in a reaction vessel; for example, a deoxidization atmosphere is formed by substituting oxygen with nitrogen; and these are heated or kept warm during stirring. The polymerization initiator, the solvent and the like which are used here are not particularly limited, and those commonly used in the art can be used. Examples of the polymerization initiator include azo compounds (2,2'-azobisisobutyronitrile, 2,2'-azobis(2,4-dimethylvaleronitrile) and the like) and organic peroxides (benzoyl peroxide and the like). The solvent may be a solvent capable of dissolving each monomer, and examples of the solvent (E) for the colored curable resin composition of the present invention include solvents to be described later.
A solution after a reaction, of the resultant copolymer may be used as it is; a concentrated or diluted solution of the copolymer may be used; or a solid (powder) taken out from the copolymer by a method such as reprecipitation may be used. In particular, the solution after the reaction can be used as it is for preparing the colored curable resin composition of the present invention by using the solvent contained in the colored curable resin composition of the present invention as the solvent during the polymerization, whereby the producing process of the colored curable resin composition of the present invention can be simplified.
In the resin [K2], the ratio of the structural unit derived from each of (a) to (c) in the total structural units constituting

the resin [K2] is preferably the following:

the structural unit derived from (a); 2 to 45 mol%;
the structural unit derived from (b); 2 to 95 mol%; and
the structural unit derived from (c); 1 to 65 mol%, and more preferably the following:

the structural unit derived from (a); 5 to 40 mol%;
the structural unit derived from (b); 5 to 80 mol%; and
the structural unit derived from (c); 5 to 60 mol%.

When the ratio of the structural unit of the resin [K2] falls within the above-mentioned range, there is a tendency that the storage stability of the colored curable resin composition, the developability thereof during the formation of a colored pattern, and the solvent resistance, heat resistance, and mechanical strength of a color filter to be produced are excellent.

The resin [K2] can be produced in the same manner as in the method described as the producing method of the resin [K1], for example.

In the resin [K3], the ratio of the structural unit derived from each of (a) and (c) in the total structural units constituting the resin [K3] is preferably the following:

the structural unit derived from (a); 2 to 60 mol%; and
the structural unit derived from (c); 40 to 98 mol%,
and more preferably the following:

the structural unit derived from (a); 10 to 50 mol% and
the structural unit derived from (c); 50 to 90 mol%.

The resin [K3] can be produced in the same manner as in the method described as the producing method of the resin [K1], for example.

The resin [K4] can be produced by producing a copolymer of (a) and (c) and then adding a cyclic ether having 2 to 4 carbon atoms contained in (b) to a carboxylic acid and/or a carboxylic anhydride contained in (a).

The copolymer of (a) and (c) is first produced in the same manner as in the method described as the producing method of the resin [K1]. In this case, the ratio of the structural unit derived from each of (a) and (c) is preferably the same ratio as that described in the resin [K3].

Next, a cyclic ether having 2 to 4 carbon atoms contained in (b) is reacted with a part of the carboxylic acid and/or the carboxylic anhydride derived from (a) in the copolymer.

Subsequent to the production of the copolymer of (a) and (c), a nitrogen atmosphere in a flask is replaced with air, and (b), a reaction catalyst for a carboxylic acid or a carboxylic anhydride and a cyclic ether (for example, tris(dimethylaminomethyl)phenol and the like), and a polymerization inhibitor (for example, hydroquinone and the like) are placed in a flask, followed by reacting, for example, at 60 to 130°C for 1 to 10 hours, whereby the resin [K4] can be produced.

The amount of (b) used is preferably 5 to 80 mol, and more preferably 10 to 75 mol, relative to 100 mol of (a). The amount of (b) used falls within the above-mentioned range, whereby there is a tendency that the storage stability of the colored curable resin composition, the developability thereof during the formation of a pattern, and the balance of the solvent resistance, heat resistance, mechanical strength, and sensitivity of the pattern obtained are good. Since the reactivity of the cyclic ether is high, and the unreacted (b) is less likely to remain, (b) used for the resin [K4] is preferably (b1), and more preferably (b1-1).

The amount of the reaction catalyst used is preferably 0.001 to 5 parts by mass relative to 100 parts by mass of the total amount of (a), (b), and (c). The amount of the polymerization inhibitor used is preferably 0.001 to 5 parts by mass relative to 100 parts by mass of the total amount of (a), (b), and (c).

Reaction conditions such as a feeding method, a reaction temperature, and time can be appropriately adjusted in consideration of a production equipment, an amount of heat generation due to polymerization, and the like. In consideration of the production equipment, the amount of heat generation due to polymerization, and the like, the feeding method and the reaction temperature can be appropriately adjusted like the polymerization conditions.

The resin [K5] is produced by producing a copolymer of (b) and (c) in the same manner as in the above-mentioned method for producing the resin [K1] as a first step. In the same manner as in the above, a solution after a reaction, of the resultant copolymer may be used as it is; a concentrated or diluted solution of the copolymer may be used; or a solid (powder) taken out from the copolymer by a method such as reprecipitation may be used.

The ratio of the structural unit derived from each of (b) and (c) relative to the total number of moles of the total structural units constituting the copolymer is preferably the following:

the structural unit derived from (b); 5 to 95 mol%; and
the structural unit derived from (c); 5 to 95 mol%, and more preferably the following:

the structural unit derived from (b); 10 to 90 mol%; and
the structural unit derived from (c); 10 to 90 mol%.

Furthermore, the resin [K5] can be produced by reacting a carboxylic acid or a carboxylic anhydride contained in (a) with the cyclic ether derived from (b) contained in the copolymer of (b) and (c) under the same conditions as those of the producing method of the resin [K4] .

The amount of (a) used which is reacted with the copolymer is preferably 5 to 80 mol relative to 100 mol of (b). Since the reactivity of the cyclic ether is high, and the unreacted (b) is less likely to remain, (b) used for the resin [K5] is preferably (b1), and more preferably (b1-1).

The resin [K6] is a resin produced by further reacting a carboxylic anhydride with the resin [K5]. A carboxylic anhydride is reacted with a hydroxy group generated by a reaction between a cyclic ether and a carboxylic acid or a carboxylic anhydride.

Examples of the carboxylic anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride. The amount of the carboxylic anhydride used is preferably 0.5 to 1 mol relative to 1 mol of the amount of (a) used.

Specific examples of the resin (B) include a resin [K1] such as a 3,4-epoxycyclohexylmethyl(meth)acrylate/(meth)acrylic acid copolymer or a 3,4-epoxytricyclo[5.2.1.$0^{2,6}$]decyl acrylate/(meth)acrylic acid copolymer; a resin [K2] such as a glycidyl(meth)acrylate/benzyl(meth)acrylate/(meth)acrylic acid copolymer, a glycidyl(meth)acrylate/styrene/(meth)acrylic acid copolymer, a 3,4-epoxytricyclo[5.2.1.$0^{2,6}$]decyl acrylate/(meth)acrylic acid/N-cyclohexylmaleimide copolymer, 3,4-epoxytricyclo[5.2.1.$0^{2,6}$]decyl acrylate/(meth)acrylic acid/N-cyclohexylmaleimide/2-hydroxyethyl(meth)acrylate copolymer, or a 3-methyl-3-(meth)acryloyloxymethyl oxetane/(meth)acrylic acid/styrene copolymer; a resin [K3] such as a benzyl(meth)acrylate/(meth)acrylic acid copolymer or a styrene/(meth)acrylic acid copolymer; a resin [K4] such as a resin produced by adding glycidyl(meth)acrylate to a benzyl(meth)acrylate/(meth)acrylic acid copolymer, a resin produced by adding glycidyl(meth)acrylate to a tricyclodecyl(meth)acrylate/styrene/(meth)acrylic acid copolymer, or a resin produced by adding glycidyl(meth)acrylate to a tricyclodecyl(meth)acrylate/benzyl(meth)acrylate/(meth)ac rylic acid copolymer; a resin [K5] such as a resin produced by reacting a tricyclodecyl(meth)acrylate/glycidyl(meth)acrylate copolymer with (meth)acrylic acid or a resin produced by reacting a tricyclodecyl(meth)acrylate/styrene/glycidyl(meth)acrylat e copolymer with (meth)acrylic acid; and a resin [K6] such as a resin produced by reacting a tricyclodecyl(meth)acrylate/glycidyl(meth)acrylate copolymer with (meth)acrylic acid to produce a resin and then reacting this resin with tetrahydrophthalic anhydride.

Among these, the resin (B) is preferably the resin [K1] and the resin [K2], and particularly preferably the resin [K2].

The weight average molecular weight of the resin (B) in terms of polystyrene content is preferably 3,000 to 100,000, more preferably 5,000 to 50,000, and still more preferably 5,000 to 30,000. When the molecular weight falls within the above-mentioned range, there is a tendency that the hardness of the color filter is improved, that the residual film ratio is increased, that the solubility of an unexposed area in a developing solution becomes good, and that the resolution of a colored pattern is improved.

The degree of dispersion [weight average molecular weight (Mw)/number average molecular weight (Mn)] of the resin (B) is preferably 1.1 to 6, and more preferably 1.2 to 4.

The acid value of the resin (B) is preferably 50 to 170 mg-KOH/g, more preferably 60 to 150 mg-KOH/g, and still more preferably 70 to 135 mg-KOH/g, in terms of solid content. The acid value as used herein is a value which is measured as an amount (mg) of potassium hydroxide required for neutralizing 1 g of the resin (B), and which can be determined by, for example, titration with an aqueous potassium hydroxide solution.

The content rate of the resin (B) is preferably 7 to 65% by mass, more preferably 13 to 60% by mass, and still more preferably 17 to 55% by mass, relative to the whole amount of the solid content. When the content rate of the resin (B) falls within the above-mentioned range, there is a tendency that the colored pattern can be formed, and that the resolution of the colored pattern and the residual film ratio are improved.

<Polymerizable Compound (C) >

The polymerizable compound (C) is a compound capable of being polymerized by the action of an active radical and/or an acid generated from the polymerization initiator (D). Examples of the polymerizable compound (C) include a compound having a polymerizable ethylenically unsaturated bond, and is preferably a (meth)acrylic acid ester compound.

Among these, the polymerizable compound (C) is preferably a polymerizable compound having three or more ethylenically unsaturated bonds. Examples of the polymerizable compound include trimethylolpropane tri(meth)acrylate,

pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, and caprolactone-modified dipentaerythritol hexa(meth)acrylate.

Among these, dipentaerythritol penta(meth)acrylate and dipentaerythritol hexa(meth)acrylate are preferable.

The weight average molecular weight of the polymerizable compound (C) is preferably 150 or more and 2,900 or less, and more preferably 250 or more and 1,500 or less.

The content rate of the polymerizable compound (C) is preferably 7 to 65% by mass, more preferably 13 to 60% by mass, and still more preferably 17 to 55% by mass, relative to the whole amount of the solid content. When the content rate of the polymerizable compound (C) falls within the above-mentioned range, there is a tendency that the residual film ratio during the formation of the colored pattern and the chemical resistance of the color filter are improved.

<Polymerization Initiator (D) >

The polymerization initiator (D) is not particularly limited, as long as the polymerization initiator (D) is a compound capable of generating active radicals, an acid or the like by the action of light or heat to initiate polymerization. Any known polymerization initiator can be used. Examples of the polymerization initiator capable of generating active radicals include an alkylphenone compound, a triazine compound, an acylphosphine oxide compound, an O-acyloxime compound, and a biimidazole compound.

The O-acyloxime compound is a compound having a partial structure represented by formula (d1). Hereinafter, * represents a point of attachment.

[Formula 58]

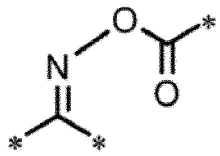

(d1)

Examples of the O-acyloxime compound include N-benzoyloxy-1-(4-phenylsulfanylphenyl)butane-1-one-2-imine, N-benzoyloxy-1-(4-phenylsulfanylphenyl)octane-1-one-2-imine, N-benzoyloxy-1-(4-phenylsulfanylphenyl)-3-cyclopentylpropane-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, and N-benzoyloxy-1-[9-ethyl-6-(2-methylbenzoyl)-9H-carbazole-3-yl]-3-cyclopentylpropane-1-one-2-imine. Commercially available products such as Irgacures OXE01 and OXE02 (all manufactured by BASF Corporation), and N-1919 (manufactured by ADEKA Corporation) may be used. Among these, the O-acyloxime compound is preferably at least one selected from the group consisting of N-benzoyloxy-1-(4-phenylsulfanylphenyl)butane-1-one-2-imine, N-benzoyloxy-1-(4-phenylsulfanylphenyl)octane-1-one-2-imine, and N-benzoyloxy-1-(4-phenylsulfanylphenyl)-3-cyclopentylpropane-1-one-2-imine, and more preferably N-benzoyloxy-1-(4-phenylsulfanylphenyl)octane-1-one-2-imine. There is a tendency that these O-acyloxime compounds provide a color filter having a high brightness.

The alkylphenone compound is a compound having a partial structure represented by formula (d2) or a partial structure represented by formula (d3). In these partial structures, the benzene ring optionally has a substituent.

[Formula 59]

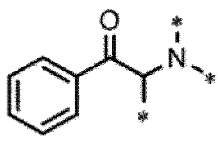

(d2)

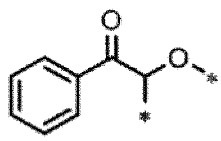

(d3)

Examples of the compound having a partial structure represented by formula (d2) include 2-methyl-2-morpholino-1-(4-methylsulfanylphenyl)propane-1-one, 2-dimethylamino-1-(4-morpholinophenyl)-2-benzylbutane-1-one, and 2-(dimethylamino)-2-[(4-methylphenyl)methyl]-1-[4-(4-morpholinyl)phenyl]butane-1-one. Commercially available products such as Irgacures 369, 907, and 379 (all manufactured by BASF Corporation) may be used.

Examples of the compound having a partial structure represented by formula (d3) include 2-hydroxy-2-methyl-1-phenylpropane-1-one, 2-hydroxy-2-methyl-1-[4-(2-hydroxyethoxy)phenyl]propane-1-one, 1-hydroxycyclohexylphenylketone, an oligomer of 2-hydroxy-2-methyl-1-(4-isopropenylphenyl)propane-1-one, $\alpha,\alpha$-diethoxyacetophenone, and benzyl dimethyl ketal.

The alkylphenone compound is preferably a compound having a partial structure represented by formula (d2) from the viewpoint of sensitivity.

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine.

Examples of the acylphosphine oxide compound include 2,4,6-trimethylbenzoyldiphenylphosphine oxide. Commercially available products such as Irgacure (registered trademark) 819 (manufactured by BASF Corporation) may be used.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. 6-75372 and Japanese Patent Laid-Open No. 6-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent No. 48-38403 and Japanese Patent Laid-Open No. 62-174204), and an imidazole compound in which a phenyl group at the 4,4',5,5' position is substituted with a carboalkoxy group (for example, see Japanese Patent Laid-Open No. 7-10913).

Furthermore, examples of the polymerization initiator (D) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenonne, 4-benzoyl-4'-methyldiphenyl sulfide, 3,3',4,4'-tetra(tert-butylperoxycarbonyl)benzophenone, and 2,4,6-trimethylbenzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound. These are preferably used in combination with a polymerization initiation aid (D1) (particularly, amines) to be described later.

Examples of an acid generator include onium salts such as 4-hydroxyphenyldimethylsulfonium p-toluenesulfonate, 4-hydroxyphenyldimethylsulfoniumhexafluoroantimonate, 4-acetoxyphenyldimethylsulfonium p-toluenesulfonate, 4-acetoxyphenyl-methyl-benzylsulfoniumhexafluoroantimonate, triphenylsulfonium p-toluenesulfonate, triphenylsulfonium hexafluoroantimonate, diphenyliodonium p-toluenesulfonate, and diphenyliodoniumhexafluoroantimonate, nitrobenzyl tosylates, and benzoin tosylates.

The polymerization initiator (D) is preferably a polymerization initiator containing at least one selected from the group consisting of an alkylphenone compound, a triazine compound, an acylphosphine oxide compound, an O-acyloxime compound, and a biimidazole compound, and more preferably a polymerization initiator containing an O-acyloxime compound.

The content of the polymerization initiator (D) is preferably 0.1 to 30 parts by mass, and more preferably 1 to 20 parts by mass, relative to 100 parts by mass of the whole amount of the resin (B) and the polymerizable compound (C). When the content of the polymerization initiator (D) falls within the above-mentioned range, there is a tendency that the sensitivity is increased and that the time of exposure to light is shortened, resulting in the improvement in productivity of the color filter.

<Solvent (E)>

The colored curable resin composition of the present invention preferably contains one or two or more of the solvents (E). Examples of the solvent (E) include an ester solvent (a solvent containing -COO-), an ether solvent other than the ester solvent (a solvent containing -O-), an ether ester solvent (a solvent containing -COO- and -O-), a ketone solvent other than the ester solvent (a solvent containing -CO-), an alcohol solvent, an aromatic hydrocarbon solvent, an amide solvent, and dimethyl sulfoxide.

Examples of the ester solvent include methyl lactate, ethyl lactate, butyl lactate, methyl 2-hydroxy isobutanoate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate, and $\gamma$-butyrolactone.

Examples of the ether solvent include ethylene glycol monomethyl ether, ethylene glycol monoethyl ether,

ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-butyl methoxyacetate, 3-methyl-3-butyl methoxyacetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, diethylene glycol monobutyl ether acetate, and dipropylene glycol methyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin. Examples of the aromatic hydrocarbon solvent include benzene, toluene, xylene, and mesitylene. Examples of the above amide solvent include N,N-dimethylformamide, N,N-dimethylacetamide, and N-methylpyrrolidone.

The solvent (E) preferably contains an organic solvent having a boiling point of 120°C or higher and 180°C or lower at 1 atm from the viewpoint of applicability and drying performance. Above all, the solvent (E) preferably contains at least one selected from the group consisting of propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 3-methoxybutyl acetate, 3-methoxy-1-butanol, 4-hydroxy-4-methyl-2-pentanone, and N,N-dimethylformamide, and more preferably at least one selected from the group consisting of propylene glycol monomethyl ether acetate, propylene glycol monomethyl ether, dipropyleneglycol methyl ether acetate, ethyl lactate, 3-methoxybutyl acetate, 3-methoxy-1-butanol, and ethyl 3-ethoxypropionate.

The content of the solvent (E) is preferably 70% by mass or more and 95% by mass or less, and more preferably 75% by mass or more and 92% by mass or less, in the colored curable resin composition. In other words, the solid content of the colored curable resin composition is preferably 5% by mass or more and 30% by mass or less, and more preferably 8% by mass or more and 25% by mass or less. When the content of the solvent (E) falls within the above-mentioned range, there is a tendency that the flatness during application becomes good and the color density of the color filter formed becomes not insufficient, resulting in the achievement of good displaying properties.

<Leveling Agent (F) >

The curable resin composition of the present invention can contain one or two or more of leveling agents (F). Examples of the leveling agent (F) include a silicone-based surfactant (having no fluorine atom), a fluorine-based surfactant, and a silicone-based surfactant having a fluorine atom. These may have a polymerizable group at its side chain.

Examples of the silicone-based surfactant include a surfactant having a siloxane bond in its molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (trade name: manufactured by Dow Corning Toray Co., Ltd.); KP321, KP322, KP323, KP324, KP326, KP340, and KP341 (manufactured by Shin-Etsu Chemical Co., Ltd.); and TSF400, TSF401, TSF410, TSF4300, TSF4440, TSF4445, TSF-4446, TSF4452, and TSF4460 (manufactured by Momentive Performance Materials Inc.).

Examples of the fluorine-based surfactant include a surfactant having a fluorocarbon chain in its molecule. Specific examples thereof include Fluorad (registered trademark) FC430 and Fluorad FC431 (manufactured by Sumitomo 3M, Ltd.); Megafac (registered trademark) F142D, Megafac F171, Megafac F172, Megafac F173, Megafac F177, Megafac F183, Megafac F554, Megafac R30, and Megafac RS-718-K (manufactured by DIC Corporation); Eftop (registered trademark) EF301, Eftop EF303, Eftop EF351, and Eftop EF352 (manufactured by Mitsubishi Materials Electronic Chemicals Co., Ltd.); Surflon (registered trademark) S381, Surflon S382, Surflon SC101, and Surflon SC105 (manufactured by Asahi Glass Co., Ltd.); and E5844 (manufactured by Daikin Finechemical Laboratory).

Examples of the silicone-based surfactant having a fluorine atom include a surfactant having a siloxane bond and a fluorocarbon chain in its molecule. Specific examples thereof include Megafac (registered trademark) R08, Megafac BL20, Megafac F475, Megafac F477, and Megafac F443 (manufactured by DIC Corporation).

The content of the leveling agent (F) is usually 0.001% by mass or more and 0.6% by mass or less, preferably 0.002% by mass or more and 0.4% by mass or less, and more preferably 0.005% by mass or more and 0.2% by mass

or less, in the curable resin composition. The content does not include the content of the pigment dispersant.

<Other Components>

If required, the colored curable resin composition may contain one or two or more of additives such as a filler, a polymeric compound other than the resin (B), an antioxidant, a polymerization initiation aid, an adhesion promoter, an ultraviolet ray absorbent, an aggregation inhibitor, an organic acid, an organic amine compound, and a curing agent.

<Method for Producing Colored Curable Resin Composition>

The curable resin composition of the present invention can be prepared by, for example, mixing a colorant (A), a resin (B), a polymerizable compound (C), and a polymerization initiator (D), and a solvent (E), a leveling agent (F), and other component used if required.

<Color Filter, Method for Producing Color Filter, and Solid-State Imaging Element>

The colored curable resin composition of the present invention is useful as the material of the color filter. The color filter formed from the colored curable resin composition of the present invention is also in the category of the present invention. The color filter may form the colored pattern.

Examples of the method for producing the colored pattern from the colored curable resin composition of the present invention include a photolithography method, an inkjet method, and a printing method. A photolithography method is preferable. The photolithography method is a method in which the colored curable resin composition is applied onto a substrate and then dried to form a coloring composition layer, and the coloring composition layer is then developed by exposing the coloring composition layer to light through a photomask. In the photolithography method, the photomask is not used during the exposure to light, and/or the coloring composition layer is not developed, whereby a colored coating film which is a cured product of the coloring composition layer can be formed. The colored pattern and the colored coating film which have been formed from the colored curable resin composition of the present invention are the color filter of the present invention. The color filter according to the present invention is typically used as a color pixel.

Examples of the substrate to be used include glass substrates such as quartz glass, borosilicate glass, alumina silicate glass, and soda lime glass of which the surface is coated with silica; resin substrates such as polycarbonate, poly(methyl methacrylate), and polyethylene terephthalate; silicon; and substrates on which aluminum, silver, or a silver/copper/palladium alloy thin film or the like is formed. On these substrates, other color filter layer, a resin layer, a transistor, a circuit, and a transparent electrode and the like may be formed.

The formation of each color pixel using a photolithography method can be carried out using a known or conventional device or under known or conventional conditions. For example, the color pixel can be prepared in the following manner. First, a colored curable resin composition is applied onto a substrate, and then dried by heat-drying (pre-baking) and/or drying under reduced pressure to remove volatile components such as a solvent from the composition, thereby producing a smooth coloring composition layer. Examples of the application method include a spin coat method, a slit coat method, and a slit-and-spin coat method.

The temperature to be employed when heat-drying is carried out is preferably 30 or higher and 120°C or lower, and more preferably 50°C or higher and 110°C or lower. The time for the heating is preferably 10 seconds to 5 minutes, and more preferably 30 seconds to 3 minutes. When drying under reduced pressure is carried out, the drying procedure is preferably carried out at a temperature range of 20°C or higher and 25°C or lower under a pressure of 50 Pa or more and 150 Pa or less. The film thickness of the coloring composition layer is not particularly limited, and may be selected appropriately depending on the desired film thickness of the color filter.

Next, the coloring composition layer is exposed to light through a photomask for forming a desired colored pattern. The pattern on the photomask is not particularly limited, and a pattern suitable for the intended application is used. A light source to be used for the exposure to light is preferably a light source capable of generating light having a wavelength of 250 nm or more and 450 nm or less. For example, light having a wavelength of shorter than 350 nm may be cut with a filter capable of cutting light having this wavelength region, or light having a wavelength of around 436 nm, around 408 nm, or around 365 nm may be extracted selectively with a band-pass filter capable of extracting light having those wavelength region. Specific examples of the light source include a mercury lamp, a light-emitting diode, a metal halide lamp, and a halogen lamp.

A light-exposing device such as a mask aligner and a stepper is preferably used because the device is capable of emitting a parallel light beam uniformly over the whole area of the exposed surface or accurately aligning the photomask to the substrate which has the coloring composition layer formed thereon.

A colored pattern is formed on the substrate by bringing the exposed coloring composition layer into contact with a developing solution to develop the coloring composition layer. By developing, an unexposed area in the coloring

composition layer is dissolved in the developing solution and therefore removed.

The developing solution is preferably an aqueous solution of an alkaline compound such as potassium hydroxide, sodium hydrogen carbonate, sodium carbonate, or tetramethylammonium hydroxide. The concentration of the alkaline compound in the aqueous solution is preferably 0.01% by mass or more and 10% by mass or less, and more preferably 0.03% by mass or more and 5% by mass or less. The developing solution may further contain a surfactant.

The developing method may be any of a paddle method, a dipping method, a spray method and the like. Furthermore, during the developing process, the substrate may be inclined at any angle. After the developing process, the resultant product is preferably washed with water.

The colored curable resin composition of the present invention provides little residue of a portion in which the unexposed area in the coloring composition layer is dissolved and therefore removed in the developing solution on the substrate.

Furthermore, the resultant colored pattern is preferably subjected to post-baking. The temperature for the post-baking is preferably 100°C or higher and 250°C or lower, and more preferably 150°C or higher and 240°C or less. The time for the post-baking is preferably 1 to 60 minutes, and more preferably 3 to 30 minutes.

In the colored curable resin composition of the present invention, the percentage of the film thickness of the coloring composition layer after exposure to light, developing, and post-baking to the film thickness of the coloring composition layer [after dried by heat-drying (pre-baking) and/or dried under reduced pressure] before exposure to light is high, and may be, for example, 50% or more.

Since the film thickness of the color filter influences color separability with a neighboring pixel, the color filter is preferably thin. The film thickness of the color filter is preferably 1.0 μm or less, more preferably 0.1 μm or more and 0.9 μm or less, and still more preferably 0.2 μm or more and 0.8 μm or less. Since the color filter can exhibit excellent developability, the color filter is excellent as the material of the solid-state imaging element.

When the color filter of the present invention is used for a display device, the film thickness of the color filter is preferably 3 μm or less, and more preferably 2.8 μm or less. The lower limit of the film thickness of the color filter is not particularly limited, and is usually 1 μm or more, and may be 1.5 μm or more. Examples of the display device include a liquid crystal display, an organic EL device, and an electronic paper.

The solid-state imaging element of the present invention contains the above-mentioned color filter of the present invention. The constitution of the solid-state imaging element of the present invention is not particularly limited as long as it contains the color filter in the present invention, and functions as the solid-state imaging element, and examples thereof include the following constitution. Examples of the solid-state imaging element include a CCD image sensor and a CMOS image sensor.

A plurality of photodiodes and transfer electrodes are provided on a support. The photodiodes constitute a light receiving area of the solid-state imaging element, and the transfer electrodes are composed of polysilicon or the like. A light shielding film composed of tungsten or the like and having openings through only light receiving parts of the photodiodes is provided on the photodiodes and the transfer electrodes. A device protection film composed of silicon nitride or the like is formed on the light shielding film so as to cover the whole surface of the light shielding film and the light receiving parts of the photodiodes. The color filter for solid-state imaging element of the present invention is provided on the device protection film.

Furthermore, a configuration in which light collecting means is provided above the device protection film and below the color filter (on a side thereof close the support), or a configuration in which light collecting means is provided on the color filter may be adopted. Examples of the light collecting means include a microlens.

The color filter according to the present invention is used for the display device and the solid-state imaging element, and is particularly useful as the color filter used for the solid-state imaging element.

## Examples

Hereinafter, a curable resin composition of the present invention will be described with reference to specific Examples, but the present invention is not limited to the following Examples without departing from the scope of the invention. Unless otherwise specified, "part (s)" means "part (s) by mass", and "%" means "% by mass". Unless otherwise specified, a reaction was carried out under a nitrogen atmosphere.

Hereinafter, the structures of the compounds were confirmed by mass spectrometry (LC; model 1200, manufactured by Agilent, MASS; model LC/MSD, manufactured by Agilent).

The weight average molecular weight (Mw) and the number average molecular weight (Mn) of the resin in terms of polystyrene content were measured using the GPC method under the following conditions.

Device; HLC-8120GPC (manufactured by Tosoh Corporation)

Column; TSK-GELG2000HXL
Column temperature; 40°C

Solvent; THF
Flow rate; 1.0 mL/min
Solid content concentration of suspected solution; 0.001 to 0.01% by mass
Injected amount; 50 μL
Detector; RI
Reference substance for correction; TSK STANDARD POLYSTYRENE F-40, F-4, F-288, A-2500, A-500 (manufactured by Tosoh Corporation)

The ratio (Mw/Mn) of the weight average molecular weight to the number average molecular weight in terms of polystyrene content as determined above was defined as a degree of dispersion.

The acid value of the resin in terms of solid content was a value measured as an amount (mg) of potassium hydroxide required for neutralizing 1 g of the resin by titration of a solution containing the resin with an aqueous potassium hydroxide solution.

[Synthetic Example 1]

A compound represented by formula (I-14) was obtained according to the description of Example 1 of Japanese Patent Laid-Open No. 2012-31218.

[Formula 60]

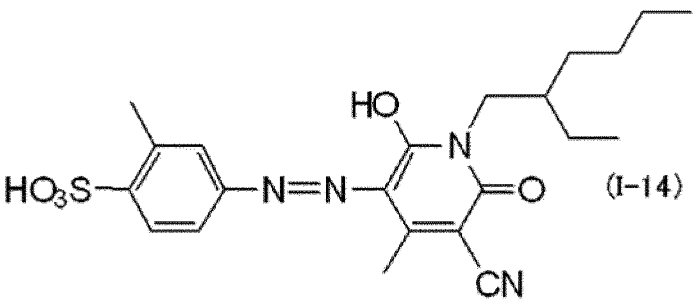

(I-14)

[Synthetic Example 2]

A dye (A) was obtained according to the description of Example 1 of Japanese Patent Laid-Open No. 2012-31218.

[Formula 61]

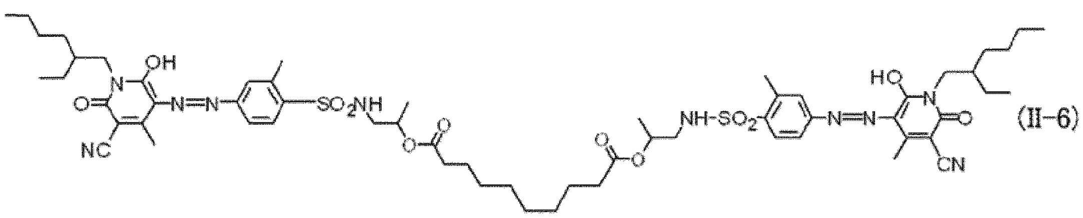

(II-6)

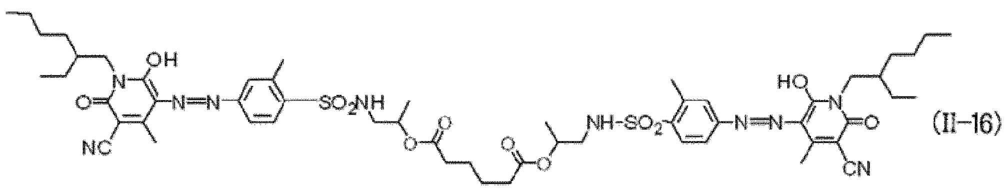

(II-16)

In the dye (A), the content ratio of a compound represented by formula (II-6) to a compound represented by formula (II-16) was measured according to a method described in Japanese Patent Laid-Open No. 2012-31218 using liquid chromatography (HPLC), and as a result, the compound represented by formula (II-6)/the compound represented by formula (II-16) was 44.7/55.3.

[Synthetic Example 3]

A compound represented by formula (II-23) was obtained according to the description of Example 4 of Japanese Patent Laid-Open No. 2009-013112.

[Formula 62]

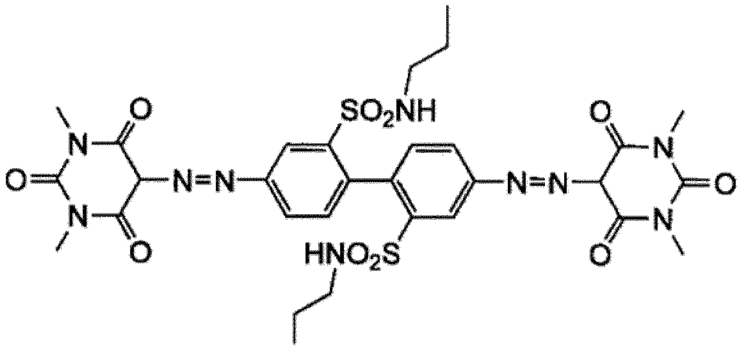

(II-23)

[Synthetic Example 4]

A compound represented by formula (1-87) was obtained according to a method described in Example 2 of Japanese Patent Laid-Open No. 2017-226814.

[Formula 63]

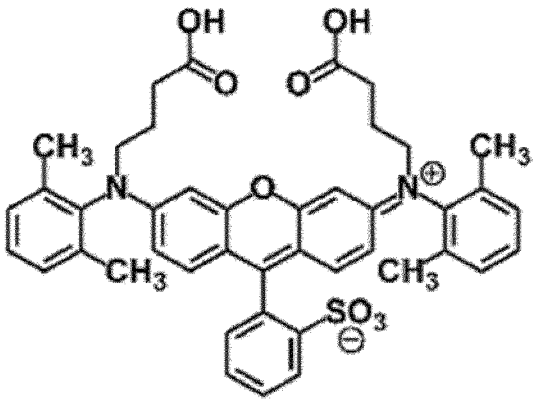

(1-87)

[Synthetic Example 5]

A compound represented by the following formula was obtained according to a method described in Paragraph 0142 of Japanese Patent Laid-Open No. 2016-11419.

[Formula 64]

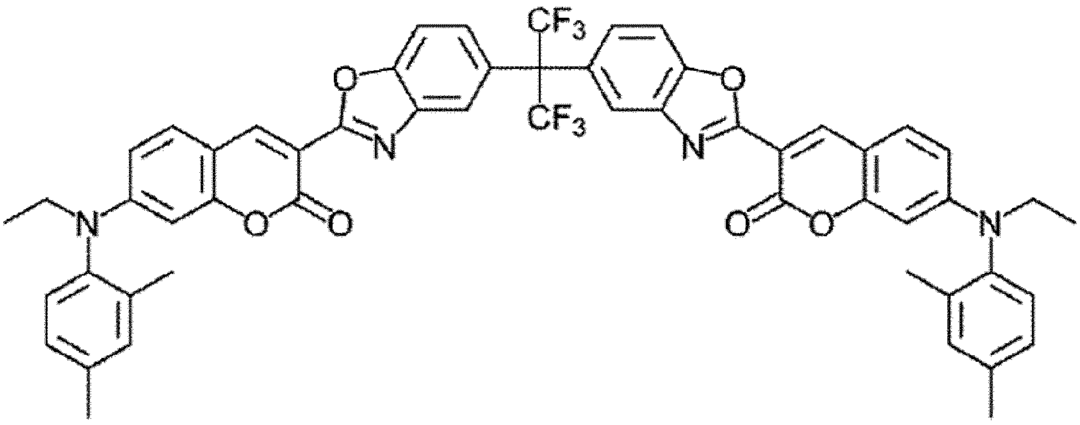

[Synthetic Example 6]

A proper amount of nitrogen was flown into a flask equipped with a reflux condenser, a dropping funnel, and a stirrer to purge the inside of the flask with a nitrogen atmosphere. 340 parts of propylene glycol monomethyl ether acetate were placed in the flask, and then heated to 80°C while being stirred. Then, a mixed solution of 57 parts of acrylic acid, 54 parts of a mixture (content rate: 1:1 at molar ratio) of 3,4-epoxytricyclo[5.2.1.$0^{2,6}$]decan-8-yl acrylate, and 3,4-epoxytricyclo[5.2.1.$0^{2,6}$]decan-9-yl acrylate, 239 parts of benzyl methacrylate, and 73 parts of propylene glycol monomethyl ether acetate was added dropwise thereto over 5 hours. Meanwhile, a solution containing 40 parts of 2,2-azobis(2,4-dimethylvaleronitrile) as a polymerization initiator dissolved in 197 parts of propylene glycol monomethyl ether acetate was added dropwise thereto over 6 hours. After the completion of the dropwise addition of the initiator solution, the resultant solution was held at 80°C for 3 hours, and then cooled to room temperature to obtain a copolymer (resin B1) solution having a solid content of 36.8% by weight and a viscosity of 137 mPas as measured with a Type-B viscometer (23°C). The produced copolymer had a weight average molecular weight Mw of $1.0 \times 10^3$, a degree of dispersion of 1.97, and an acid value of 111 mg-KOH/g in terms of solid content. The resin B1 has the following structural units.

[Formula 65]

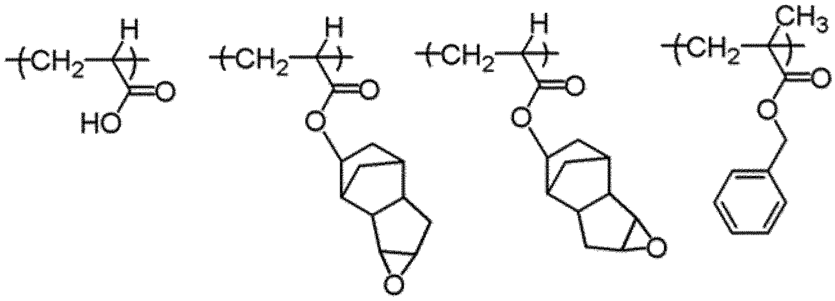

[Synthetic Example 7]

In a flask equipped with a condenser tube and a stirrer, 15 parts of a mixture of a compound represented by formula (A0-1) and a compound represented by formula (A0-2) (trade name: Chugai Aminol Fast Pink R; manufactured by Chugai Kasei Co., Ltd.), 150 parts of chloroform, and 8.9 parts of N,N-dimethylformamide were placed, and 10.9 parts of thionyl chloride was then added dropwise to the mixture under stirring while the mixture was maintained at 20°C or lower. After the completion of the dropwise addition, the mixture was heated to 50°C, and the reaction was performed while the mixture was maintained at the same temperature for 5 hours. The reaction solution was then cooled to 20°C. A mixed solution of 12.5 parts of 2-ethylhexylamine and 22.1 parts of triethylamine was added dropwise to the cooled reaction solution while the reaction solution was maintained at 20°C or lower under stirring. Then, the reaction was performed while the mixture was stirred at the same temperature for 5 hours. Then, the solvent in the resulting reaction mixture was distilled off using a rotary evaporator, and a small amount of methanol was then added to the reaction mixture, followed by vigorous stirring. The mixture thus obtained was added into a mixed solution containing 375 parts of ion-exchange water while being stirred, thereby precipitating a crystal.

The precipitated crystal was separated by filtration, sufficiently washed with ion-exchange water, and then dried at 60°C under reduced pressure to obtain a compound represented by formula (A1-1).

[Formula 66]

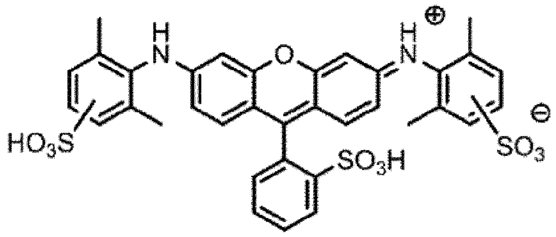

(A0-1)

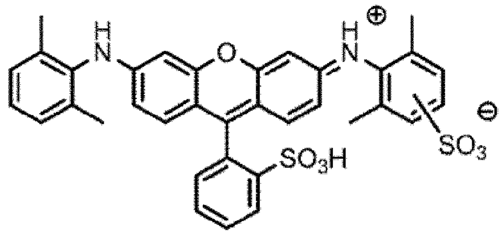

(A0-2)

[Formula 67]

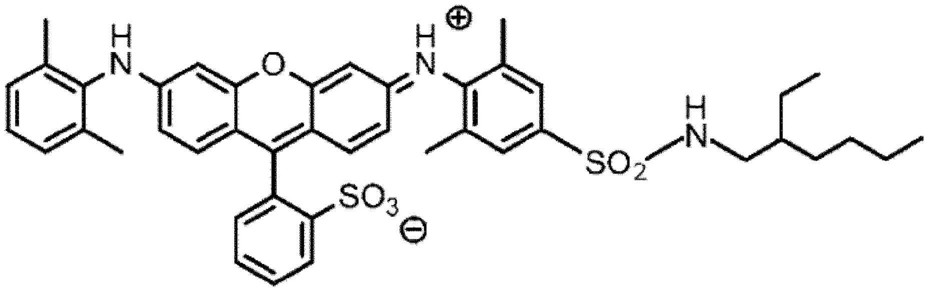

(A1-1)

<Preparation of Pigment Dispersion>

110 parts of C.I. Pigment Red 254 as a red pigment, 33 parts of an acrylic pigment dispersant (in terms of solid content), 38 parts of the resin B1 (in terms of solid content) obtained in [Synthetic Example 6], 534 parts of propylene glycol monomethyl ether acetate, and 80 parts of propylene glycol monomethyl ether were mixed, and the pigment was sufficiently dispersed using a bead mill, to obtain a pigment dispersion 1 containing C.I. Pigment Red 254.

[Example 1]

[Preparation of Colored Curable Resin Composition]

The pigment dispersion 1, the azo dye obtained in Synthetic Example 2, the xanthene dye obtained in Synthetic Example 4, a resin solution containing a resin (B), a polymerizable compound (C), a polymerization initiator (D), a solvent (E), and a leveling agent (F) were mixed so that the following parts were set, to obtain a colored curable resin composition.
**[0290]** - Colorant (A):

C. I. Pigment Red 254: 110 parts
Azo dye obtained in [Synthetic Example 2]: 14 parts
Xanthene dye obtained in [Synthetic Example 4]: 14 parts

**[0291]** - Resin (B)
Resin B1 obtained in [Synthetic Example 6]: (in terms of solid content) 60 parts
**[0292]** - Polymerizable compound (C)
**[0293]** Dipentaerythritol polyacrylate (A9550 manufactured by Shin-Nakamura Chemical Co., Ltd.): 40 parts
**[0294]** - Polymerization initiator (D):

N-benzoyloxy-1-(4-phenylsulfanylphenyl)octane-1-one-2-imine (Irgacure (registered trademark) OXE-01; manufactured by BASF Corporation; oxime compound): 4 parts

**[0295]** - Solvent (E):

Propylene glycol monomethyl ether acetate: 1726 parts
Propylene glycol monomethyl ether: 547 parts
Diacetone alcohol: 192 parts

**[0296]** - Leveling agent (F):

Polyether-modified silicone oil (in terms of solid content): 0.1 parts
(Toray silicone SH8400; manufactured by Dow Corning Toray Co., Ltd.)

The obtained colored curable resin composition was evaluated by the following method.

<Formation of Color Filter (Colored Pattern)>

Onto a 4-inch silicon wafer, a resist solution for planarization film FDER-HQ2 (manufactured by Fuji Chemicals Industrial Co., Ltd.) was applied by spin coating, and heat-treated in an oven at 100°C for 3 minutes. Furthermore, the resist solution was cured by heat-treating in an oven at 230°C for 10 minutes to form a planarization film.

Each colored curable resin composition was applied onto the planarization film by a spin coating method, and then heat-treated (pre-baked) on a hot plate for 80°C 120 seconds, to form a coloring composition layer. After cooling, the film thickness of the coloring composition layer was measured using a film thickness measuring device (OPTM-A3; manufactured by Otsuka Electronics Co., Ltd.), and referred to as FA (μm).

Then, the coloring composition layer was exposed to light in an exposure amount of 2000 $mJ/cm^2$ through a photomask to form a square pattern having a 2.0-μm square size using an i-ray stepper NSR-1755i7A [manufactured by Nikon Corporation].

The coloring composition layer exposed to light was developed by a paddle method using a 0.1% tetramethylammonium hydroxide aqueous solution at 23°C for 90 seconds, and washed with pure water for 30 seconds.

Then, a heat treatment (post-baking) was performed at 230°C for 600 seconds using a hot plate, to form a color filter (colored pattern). The film thickness of the color filter was measured using a scanning electron microscope ("S-4000" manufactured by Hitachi High-Tech Corporation), and referred to as FB (μm).

<Calculation of Residual Film Ratio>

$$\text{Residual film ratio (\%)} = [\text{FB } (\mu\text{m})/\text{FA } (\mu\text{m})] \times 100$$

<Residue Evaluation>

Residue on the obtained glass substrate was evaluated as follows.

Good: The residue was not confirmed. Poor: The residue was confirmed.

An unexposed area was rinsed with a developing device, and the surface of the developed planarization film was then observed and evaluated using a scanning electron microscope ("S-4000" manufactured by Hitachi High-Tech Corporation).

Good: No residue
Poor: Residue
The results are shown in Table 3.

[Example 2]

A colored curable resin composition and a color filter (colored coating film) were prepared and evaluated in the same manner as in Example 1 except that the azo dye obtained in Synthetic Example 1 was used in place of the azo dye obtained in Synthetic Example 2. The results are shown in Table 3.

[Example 3]

A colored curable resin composition and a color filter (colored coating film) were prepared and evaluated in the same manner as in Example 1 except that the azo dye obtained in Synthetic Example 3 was used in place of the azo dye obtained in Synthetic Example 2. The results are shown in Table 3.

[Example 4]

A colored curable resin composition and a color filter (colored coating film) were prepared and evaluated in the same manner as in Example 1 except that, with respect to the polymerization initiator (D), N-benzoyloxy-1-(4-phenylsulfanylphenyl)octane-1-one-2-imine was changed to PBG-327 (manufactured by Changzhou Tronly New Electronic Materials Co., Ltd.) represented by the following formula. The results are shown in Table 3.

[Formula 68]

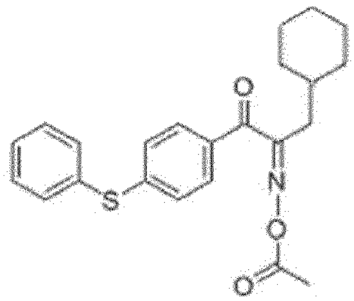

[Example 5]

A colored curable resin composition and a color filter (colored coating film) were prepared and evaluated in the same manner as in Example 1 except that 14 parts of the azo dye obtained in Synthetic Example 2 was changed to 20 parts, and 14 parts of the xanthene dye obtained in Synthetic Example 4 was changed to 8 parts. The results are shown in Table 3.

[Example 6]

A colored curable resin composition and a color filter (colored coating film) were prepared and evaluated in the same manner as in Example 1 except that 14 parts of the azo dye obtained in Synthetic Example 2 was changed to 8 parts, and 14 parts of the xanthene dye obtained in Synthetic Example 4 was changed to 20 parts. The results are shown in Table 3.

[Example 7]

A colored curable resin composition and a color filter (colored coating film) were prepared and evaluated in the same manner as in Example 1 except that the xanthene dye obtained in Synthetic Example 4 was changed to the xanthene dye obtained in Synthetic Example 7 [the compound represented by formula (A1-1)]. The results are shown in Table 3.

[Example 8]

A colored curable resin composition and a color filter (colored coating film) were prepared and evaluated in the same manner as in Example 1 except that the xanthene dye obtained in Synthetic Example 4 was changed to a xanthene dye represented by the following formula (Acid Red 52, available from Tokyo Chemical Industry Co., Ltd.). The results are shown in Table 3.

[Formula 69]

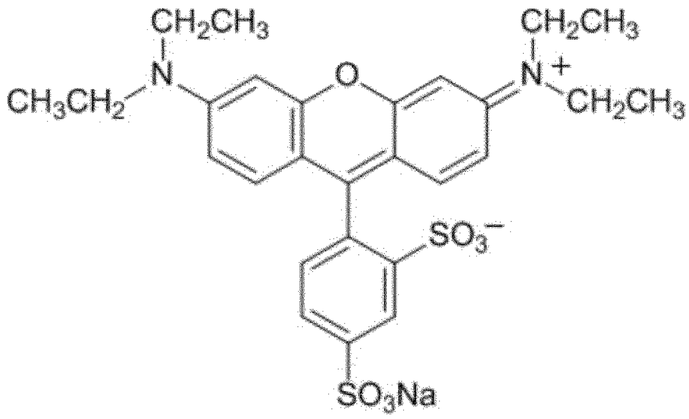

[Comparative Example 1]

A colored curable resin composition and a color filter (colored coating film) were prepared and evaluated in the same manner as in Example 1 except that the compound obtained in Synthetic Example 5 was used in place of the azo dye obtained in Synthetic Example 2. The results are shown in Table 3.

[Table 3]

| | Examples | | | | | | | | Comparative Example |
|---|---|---|---|---|---|---|---|---|---|
| | 1 | 2 | 3 | 4 | 5 | 6 | 7 | 8 | 1 |
| Residual film ratio [%] | 58 | 58 | 57 | 74 | 52 | 65 | 58 | 61 | 49 |
| Residue | Good | Good | Good | Good | Good | Good | Good | Good | Poor |

In the case where the color filter (colored coating film) was prepared using the colored curable resin compositions of Examples 1 to 8, the occurrence of the residue was confirmed to be suppressed to provide a high residual film ratio as compared with the case where the color filter (colored coating film) was prepared using the colored curable resin composition of Comparative Example 1.

Industrial Applicability

The colored curable resin composition of the present invention suppresses the occurrence of residue, which makes it possible to form a colored coating film at a high residual film ratio, thereby providing great advantages in the industrial field.

## Claims

1. A colored curable resin composition comprising: a colorant (A), a resin (B), a polymerizable compound (C), and a polymerization initiator (D),
the colorant (A) comprising a red pigment, a xanthene dye, and an azo dye.

2. The colored curable resin composition according to claim 1, wherein the azo dye comprises a compound represented by formula (I):

$A^1$-N=N-$B^1$ (I)
wherein:

$A^1$ represents a monovalent aromatic hydrocarbon group having 6 to 10 carbon atoms and optionally having a substituent; and

$B^1$ represents a monovalent aromatic hydrocarbon group having 6 to 14 carbon atoms and optionally having a substituent or a monovalent heterocyclic group having 3 to 14 carbon atoms and optionally having a substituent, and $-CH_2-$ contained in the heterocyclic group is optionally replaced with -CO-.

**3.** The colored curable resin composition according to claim 2, wherein $A^1$ is a phenyl group having two or more of at least one group selected from the group consisting of a carboxy group, a sulfo group, a sulfamoyl group, and an N-substituted sulfamoyl group, or a naphthyl group having two or more of at least one group selected from the group consisting of a sulfo group, a sulfamoyl group, and an N-substituted sulfamoyl group.

**4.** The colored curable resin composition according to claim 2 or 3, wherein $B^1$ represents a monovalent heterocyclic group having 3 to 14 carbon atoms and optionally having a substituent, and $-CH_2-$ contained in the heterocyclic group is optionally replaced with -CO-.

**5.** The colored curable resin composition according to any one of claims 1 to 4, wherein the azo dye comprises a compound represented by formula (II):

$B^{2a}-N=N-A^{2a}-O-CO-L-CO-O-A^{2b}-N=N-B^{2b}$ (II)
wherein:

$A^{2a}$ and $A^{2b}$ each independently represent a divalent group containing an aromatic hydrocarbon group having 6 to 10 carbon atoms and optionally having a substituent; and
$B^{2a}$ and $B^{2b}$ each independently represent a monovalent aromatic hydrocarbon group having 6 to 14 carbon atoms and optionally having a substituent or a monovalent heterocyclic group having 3 to 14 carbon atoms and optionally having a substituent, and $-CH_2-$ contained in the heterocyclic group is optionally replaced with -CO-; and
L represents a divalent aliphatic hydrocarbon group having 1 to 16 carbon atoms and optionally having a substituent, and $-CH_2-$ contained in the aliphatic hydrocarbon group is optionally replaced with -CO- or -O-

**6.** The colored curable resin composition according to claim 5, wherein $A^{2a}$ and $A^{2b}$ are each independently groups represented by formula ($A_{II}$):

$*-A^3-SO_2NR^{10}Z^1-$ ($A_{II}$)
wherein:

$A^3$ represents a divalent aromatic hydrocarbon group having 6 to 10 carbon atoms and optionally having a substituent;
$R^{10}$ each independently represents a hydrogen atom, a monovalent saturated hydrocarbon group having 1 to 16 carbon atoms and optionally having a substituent, or an acyl group having 2 to 18 carbon atoms and optionally having a substituent;
$Z^1$ each independently represents a divalent aliphatic hydrocarbon group having 1 to 16 carbon atoms and optionally having a substituent, and $-CH_2-$ contained in the aliphatic hydrocarbon group is optionally replaced with -CO- or -O-; and
* represents a point of attachment to a nitrogen atom.

**7.** The colored curable resin composition according to claim 5 or 6, wherein $B^{2a}$ and $B^{2b}$ each independently represent a monovalent heterocyclic group having 3 to 14 carbon atoms and optionally having a substituent, and - $CH_2$- contained in the heterocyclic group is optionally replaced with -CO-.

**8.** The colored curable resin composition according to claim 4 or 7, wherein when a plurality of heterocyclic groups are present, the heterocyclic groups are each independently groups represented by formula (Ba),

[Formula 1]

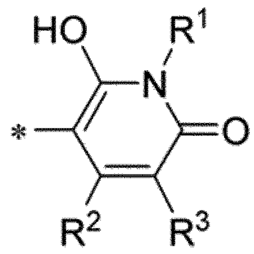

(Ba)

wherein:

$R^1$ and $R^2$ each independently represent a hydrogen atom or a monovalent saturated hydrocarbon group having 1 to 16 carbon atoms and optionally having a substituent;
$R^3$ represents a cyano group or a group represented by $-CO-NR^4R^5$;
$R^4$ and $R^5$ each independently represent a hydrogen atom, a saturated aliphatic hydrocarbon group having 1 to 10 carbon atoms, a saturated aliphatic hydrocarbon group having 1 to 10 carbon atoms and substituted with an alkoxy group having 1 to 8 carbon atoms, an aryl group having 6 to 20 carbon atoms, an aralkyl group having 7 to 20 carbon atoms, or an acyl group having 2 to 10 carbon atoms; and
* represents a point of attachment to a nitrogen atom.

**9.** A color filter formed from the colored curable resin composition according to any one of claims 1 to 8.

**10.** A solid-state imaging element comprising the color filter according to claim 9.

## INTERNATIONAL SEARCH REPORT

International application No.
PCT/JP2020/011134

A. CLASSIFICATION OF SUBJECT MATTER
Int. Cl. C08F2/44(2006.01)i, C08F220/18(2006.01)i, C08G59/32(2006.01)i, C09B11/28(2006.01)i, C09B67/20(2006.01)i, C09B67/22(2006.01)i, G02B5/20(2006.01)i, G03F7/004(2006.01)i, G03F7/027(2006.01)i, H04N5/225(2006.01)i
FI: C08F2/44 B, C09B67/20 K, C09B67/22 A, C09B11/28 C, C08F220/18, C08G59/32, G02B5/20 101, G03F7/004 505, G03F7/027, H04N5/225 300, H04N5/225 400

According to International Patent Classification (IPC) or to both national classification and IPC

B. FIELDS SEARCHED

Minimum documentation searched (classification system followed by classification symbols)
Int. Cl. C08F2/44, C08F220/18, C08G59/32, C09B11/28, C09B67/20, C09B67/22, G02B5/20, G03F7/004, G03F7/027, H04N5/225

Documentation searched other than minimum documentation to the extent that such documents are included in the fields searched
Published examined utility model applications of Japan 1922-1996
Published unexamined utility model applications of Japan 1971-2020
Registered utility model specifications of Japan 1996-2020
Published registered utility model applications of Japan 1994-2020

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2017-120379 A (DONGWOO FINE-CHEM CO., LTD.) 06 July 2017, claims, examples | 1, 9-10<br>2-8 |
| X<br>A | JP 2017-126058 A (DONGWOO FINE-CHEM CO., LTD.) 20 July 2017, claims, examples | 1, 9-10<br>2-8 |
| A | WO 2011/018987 A1 (SUMITOMO CHEMICAL CO., LTD.) 17 February 2011 | 1-10 |
| A | JP 2002-235020 A (RICOH CO., LTD.) 23 August 2002 | 1-10 |
| A | JP 2014-177567 A (NIPPON KAYAKU CO., LTD.) 25 September 2014 | 1-10 |

☐ Further documents are listed in the continuation of Box C.    ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
19.05.2020

Date of mailing of the international search report
26.05.2020

Name and mailing address of the ISA/
Japan Patent Office
3-4-3, Kasumigaseki, Chiyoda-ku,
Tokyo 100-8915, Japan

Authorized officer

Telephone No.

Form PCT/ISA/210 (second sheet) (January 2015)

**INTERNATIONAL SEARCH REPORT**
Information on patent family members

International application No.
PCT/JP2020/011134

| Patent Documents referred to in the Report | Publication Date | Patent Family | Publication Date |
|---|---|---|---|
| JP 2017-120379 A | 06.07.2017 | KR 10-2017-0078018 A<br>KR 10-2017-0084498 A<br>CN 106959579 A<br>TW 201723638 A | |
| JP 2017-126058 A | 20.07.2017 | KR 10-2017-0085687 A<br>CN 106980231 A<br>TW 201727363 A | |
| WO 2011/018987 A1 | 17.02.2011 | CN 102472849 A<br>KR 10-2012-0048678 A<br>TW 201207501 A | |
| JP 2002-235020 A | 23.08.2002 | (Family: none) | |
| JP 2014-177567 A | 25.09.2014 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016011419 A
- JP 2013014750 A
- JP 2010032999 A
- JP 4492760 B
- JP 2010152160 A
- JP 2012031218 A
- JP 2009013112 A
- JP 6075372 A
- JP 6075373 A
- JP 48038403 A
- JP 62174204 A
- JP 7010913 A
- JP 2017226814 A


### Non-patent literature cited in the description


- Color Index. The Society of Dyers and Colourists
- Experimental Method for Polymer Synthesis. Kagaku Dojin Publishing Co., Ltd, 01 March 1972